(19) Europäisches Patentamt
European Patent Office
Office européen des brevets

(11) EP 3 609 977 B1

(12) EUROPÄISCHE PATENTSCHRIFT

(45) Veröffentlichungstag und Bekanntmachung des Hinweises auf die Patenterteilung:
**29.05.2024 Patentblatt 2024/22**

(21) Anmeldenummer: **18716280.5**

(22) Anmeldetag: **10.04.2018**

(51) Internationale Patentklassifikation (IPC):
***C09K 11/02*** (2006.01) ***C09K 11/06*** (2006.01)
***H10K 85/60*** (2023.01)

(52) Gemeinsame Patentklassifikation (CPC):
**C09K 11/02; C09K 11/06; H10K 85/654; H10K 85/6572; H10K 85/6574;** H10K 50/11; H10K 85/342; H10K 2101/10; H10K 2101/90; Y02E 10/549; Y02P 70/50

(86) Internationale Anmeldenummer:
**PCT/EP2018/059076**

(87) Internationale Veröffentlichungsnummer:
**WO 2018/189134 (18.10.2018 Gazette 2018/42)**

# (54) ZUSAMMENSETZUNG FÜR ORGANISCHE ELEKTRONISCHE VORRICHTUNGEN

COMPOSITION FOR ORGANIC ELECTRONIC DEVICES

COMPOSITION POUR DISPOSITIFS ÉLECTRONIQUES ORGANIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.04.2017 EP 17166657**

(43) Veröffentlichungstag der Anmeldung:
**19.02.2020 Patentblatt 2020/08**

(73) Patentinhaber: **Merck Patent GmbH**
**64293 Darmstadt (DE)**

(72) Erfinder:
- **PARHAM, Amir**
  **60486 Frankfurt am Main (DE)**
- **KROEBER, Jonas**
  **60311 Frankfurt am Main (DE)**
- **EICKHOFF, Christian**
  **68259 Mannheim (DE)**
- **GROSSMANN, Tobias**
  **64297 Darmstadt (DE)**
- **LUDEMANN, Aurélie**
  **60322 Frankfurt am Main (DE)**
- **JOOSTEN, Dominik**
  **64372 Ober-Ramstadt (DE)**

(74) Vertreter: **Merck Patent Association**
**Merck Patent GmbH**
**64271 Darmstadt (DE)**

(56) Entgegenhaltungen:
**WO-A1-2014/094964 WO-A1-2015/169412**
**WO-A1-2016/015810 WO-A1-2016/062376**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 609 977 B1

## Beschreibung

Die vorliegende Erfindung betrifft eine Zusammensetzung, die einen bipolaren Host und einen elektronentransportierenden Host umfasst, deren Verwendung in elektronischen Vorrichtungen sowie elektronische Vorrichtungen enthaltend diese Zusammensetzung.

Der Aufbau organischer Elektrolumineszenzvorrichtungen (z.B. OLEDs - organic light emitting diodes oder OLECs - organic light emitting electrochemical cells), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei neben fluoreszierenden Emittern zunehmend metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfach gesteigerte Energie- und Leistungseffizienz möglich. Generell gibt es bei OLEDs, insbesondere auch bei OLEDs die Triplettemission (Phosphoreszenz) zeigen, jedoch immer noch Verbesserungsbedarf, beispielsweise im Hinblick auf Effizienz, Betriebsspannung und Lebensdauer.

Die Eigenschaften organischer elektrolumineszierender Vorrichtungen werden nicht nur durch die eingesetzten Emitter bestimmt. Hier sind insbesondere auch die anderen verwendeten Materialien, wie Host- und Matrixmaterialien, Lochblockiermaterialien, Elektronentransportmaterialien, Lochtransportmaterialien und Elektronen- bzw. Exzitonenblockiermaterialien von besonderer Bedeutung, und davon insbesondere die Host bzw. Matrixmaterialien. Verbesserungen dieser Materialien können zu deutlichen Verbesserungen elektrolumineszierender Vorrichtungen führen.

Hostmaterialien zur Verwendung in organischen elektronischen Vorrichtungen sind dem Fachmann gut bekannt. Im Stand der Technik wird häufig auch der Begriff Matrixmaterial verwendet, wenn ein Hostmaterial für phosphoreszierende Emitter gemeint ist. Mittlerweile wurde eine Vielzahl von Hostmaterialien sowohl für fluoreszierende als auch für phosphoreszierende elektronische Vorrichtungen entwickelt.

Für fluoreszierende OLEDs werden gemäß dem Stand der Technik vor allem kondensierte Aromaten, insbesondere Anthracenderivate, als Host-materialien vor allem für blau emittierende Elektrolumineszenzvorrichtungen verwendet, z. B. 9,10-Bis(2-naphthyl)anthracen (US 5935721). In WO 03/095445 und in CN 1362464 werden 9,10-Bis(1-naphthyl)anthracenDerivate für die Verwendung in OLEDs offenbart. Weitere Anthracenderivate sind in WO 01/076323, in WO 01/021729, in WO 2004/013073, in WO 2004/018588, in WO 2003/087023 oder in WO 2004/018587 offenbart. Hostmaterialien, basierend auf Aryl-substituierten Pyrenen und Chrysenen, werden in WO 2004/016575 offenbart. Hostmaterialien basierend auf Benzanthracenderivaten werden in WO 2008/145239 offenbart.

Gemäß dem Stand der Technik werden unter anderem Ketone (z. B. gemäß WO 2004/093207 oder WO 2010/006680) oder Phosphinoxide (z. B. gemäß WO 2005/003253) als Matrixmaterialien für phosphoreszierende Emitter verwendet. Weitere Matrixmaterialien gemäß dem Stand der Technik repräsentieren Triazine (bspw. WO 2008/056746, EP 0906947, EP 0908787, EP 0906948) sowie Lactame (bspw. WO 2011/116865 oder WO 2011/137951). Weiterhin werden gemäß dem Stand der Technik unter anderem Carbazolderivate (z. B. gemäß WO 2005/039246, US 2005/0069729 oder WO 2014/015931), Indolocarbazolderivate (z. B. gemäß WO 2007/063754 oder WO 2008/056746) oder Indenocarbazolderivate (z. B. gemäß WO 2010/136109 oder WO 2011/000455), insbesondere solche, die mit elektronenarmen Heteroaromaten wie Triazin substituiert sind, als Matrixmaterialien für phosphoreszierende Emitter verwendet. Aus der WO 2011/057706 sind Carbazolderivate bekannt, welche mit zwei Triphenyltriazingruppen substituiert sind. Aus der WO 2011/046182 sind Carbazol-Arylen-Triazin-Derivate bekannt, welche am Triazin mit einer Fluorenylgruppe substituiert sind.

WO 2009/069442 offenbart Tricyclen, wie Carbazol, Dibenzofuran oder Dibenzothiophen, die hochgradig mit elektronenarmen Heteroaromaten (z.B. Pyridin, Pyrimidin oder Triazin) substituiert sind, als Hostmaterialien. JP 2009-21336 offenbart substituierte Dibenzofurane, die in 2 Position mit Carbazol und in 8-Position mit einem Triazin substituiert sind, als Hostmaterialien. WO 2011/057706 offenbart vereinzelt substituierte Dibenzothiophene und Dibenzofurane als Hostmaterialien, wobei die Verbindungen in spezifischer Weise mit einer elektronenleitenden und mit einer lochleitenden Gruppe substituiert sind.

Eine weitere Möglichkeit, die Leistungsdaten elektronischer Vorrichtungen, insbesondere von organischen Elektrolumineszenzvorrichtungen, zu verbessern, besteht darin, Kombinationen aus zwei oder mehr Materialien, insbesondere Host-materialien, zu verwenden.

US 6,392,250 B1 offenbart die Verwendung einer Mischung bestehend aus einem Elektronentransportmaterial, einem Lochtransportmaterial und einem fluoreszierenden Emitter in der Emissionsschicht einer OLED. Mit Hilfe dieser Mischung konnte die Lebensdauer der OLED gegenüber dem Stand der Technik verbessert werden.

US 6,803,720 B1 offenbart die Verwendung einer Mischung enthaltend einen phosphoreszierenden Emitter sowie ein Loch- und ein Elektronentransportmaterial in der Emissionsschicht einer OLED. Dabei sind sowohl das Loch- und das Elektrontransportmaterial kleine organische Moleküle. In WO 2010/108579 ist eine Mischung enthaltend ein ladungstransportierendes Matrixmaterial und ein weiteres Matrixmaterial, welches durch eine große Bandlücke nicht oder nicht in wesentlichem Umfang am Ladungstransport teilnimmt, beschrieben.

Gemäß WO 2014/094964 wird eine Mischung aus einem elektronentransportierendem Lactam-Derivat sowie einem weiteren elektronentransportierenden Carbazol-Triazin-Derivat als Matrixmaterial für einen phosphoreszierenden und teils lochleitenden Emitter eingesetzt.

Weitere Hostmaterialien werden in WO2015/169412 und WO2016/015810 beschrieben.

Allerdings besteht bei Verwendung dieser Materialien oder bei der Verwendung von Mischungen der Materialien noch Verbesserungsbedarf, insbesondere in Bezug auf die Lebensdauer der organischen elektronischen Vorrichtung, und insbesondere auch für den typischen Fall, dass die lichtemittierende Komponente in geringen Konzentrationen von bis zu 5 Gew.-%, bezogen auf alle Komponenten einer emissiven Schicht, in die emissive Schicht eindotiert ist.

Aufgabe der vorliegenden Erfindung ist daher die Bereitstellung von Materialien, welche sich für den Einsatz in einer organischen elektronischen Vorrichtungen, insbesondere in einer organischen Elektrolumineszenzvorrichtungen, und insbesondere in einer fluoreszierenden oder phosphoreszierenden OLED eignen und zu guten Device-Eigenschaften insbesondere im Hinblick auf die Lebensdauer führen, sowie die Bereitstellung der entsprechenden elektronischen Vorrichtung.

Überraschend wurde gefunden, dass Zusammensetzungen, die einen bipolaren Host und einen elektronentransportierenden Host umfassen, diese Aufgabe lösen und die Nachteile aus dem Stand der Technik beseitigen. Derartige Zusammensetzungen führen zu sehr guten Eigenschaften organischer elektronischer Vorrichtungen, insbesondere organischer Elektrolumineszenzvorrichtungen, insbesondere hinsichtlich der Lebensdauer und insbesondere auch bei geringen Konzentrationen einer lichtemittierenden Komponente in der Emissionsschicht.

Gegenstand der vorliegenden Erfindung ist daher eine Zusammensetzung umfassend einen bipolaren Host und einen elektronentransportierenden Host. Organische elektronische Vorrichtungen, insbesondere organische Elektrolumineszenzvorrichtungen, die derartige Zusammensetzungen in einer Schicht enthalten, sowie die entsprechenden bevorzugten Ausführungsformen, sind ebenfalls Gegenstand der vorliegenden Erfindung. Die überraschenden Effekte werden durch eine sehr spezifische Selektion bekannter Materialien erreicht.

Dabei handelt es sich bei der Schicht, die die Zusammensetzung umfassend den bipolaren Host und den elektronentransportierenden Host enthält, insbesondere um eine emittierende Schicht (EML), eine Elektronentransportschicht (ETL), eine Elektroneninjektionsschicht (EIL) und/oder eine Lochblockierschicht (HBL). Wenn es sich um eine emittierende Schicht handelt, dann ist es bevorzugt eine phosphoreszierende Schicht, die dadurch gekennzeichnet ist, dass sie zusätzlich zu der Zusammensetzung umfassend den bipolaren Host und den elektronentransportierenden Host einen phosphoreszierenden Emitter enthält. In diesem Fall ist die erfindungsgemäße Zusammensetzung Matrixmaterial für den phosphoreszierenden Emitter, nimmt also selber nicht oder nicht in wesentlichem Umfang an der Lichtemission teil.

Ein phosphoreszierender Emitter im Sinne der vorliegenden Erfindung ist eine Verbindung, die Lumineszenz aus einem angeregten Zustand mit höherer Spinmultiplizität zeigt, also einem Spinzustand > 1, insbesondere aus einem angeregten Triplettzustand. Im Sinne dieser Anmeldung sollen alle lumineszierenden Komplexe mit Übergangsmetallen oder Lanthaniden als phosphoreszierende Emitter angesehen werden. Eine genauere Definition erfolgt weiter unten.

Wenn die Zusammensetzung umfassend den bipolaren Host und den elektronentransportierenden Host als Matrixmaterial für einen phosphoreszierenden Emitter eingesetzt wird, ist es bevorzugt, wenn deren Triplettenergie nicht wesentlich kleiner als die Triplettenergie des phosphoreszierenden Emitters ist. Dabei gilt bevorzugt für das Triplettniveau $T_1$(Emitter) - $T_1$(Matrix) $\leq$ 0.2 eV, besonders bevorzugt $\leq$ 0.15 eV, ganz besonders bevorzugt $\leq$ 0.1 eV. Dabei ist $T_1$(Matrix) das Triplettniveau des Matrixmaterials in der Emissionsschicht, wobei diese Bedingung für jedes der beiden Matrixmaterialien gilt, und $T_1$(Emitter) ist das Triplettniveau des phosphoreszierenden Emitters. Enthält die Emissionsschicht mehr als zwei Matrixmaterialien, so gilt die oben genannte Beziehung bevorzugt auch für jedes weitere Matrixmaterial.

Ein bipolarer Host im Sinne der vorliegenden Erfindung, wie er in der erfindungsgemäßen Zusammensetzung vorliegt, ist vorzugsweise eine Verbindung, die ein LUMO von kleiner oder gleich -2,4 eV und ein HOMO von größer oder gleich -5,5 eV aufweist. Dabei ist das LUMO das niedrigste unbesetzte Molekülorbital (lowest unoccupied molecular orbital) und das HOMO das höchste besetzte Molekülorbial (highest occupied molecular orbital). Der Wert des LUMO und des HOMO der Verbindungen wird durch quantenchemische Rechnung bestimmt, wie nachstehend im Beispielteil allgemein beschrieben ist.

Ein elektronentransportierender Host im Sinne der vorliegenden Erfindung, wie er in der erfindungsgemäßen Zusammensetzung vorliegt, ist vorzugsweise eine Verbindung, die ein LUMO von kleiner oder gleich -2,3 eV aufweist, bevorzugt kleiner oder gleich -2,4 eV.

Sowohl bei dem bipolaren Host als auch bei dem elektronentransportierenden Host handelt es sich erfindungsgemäß um organische Verbindungen.

Dem Fachmann ist bekannt, dass ein bipolarer Host ein solcher ist, der in der verwendeten Mischung im verwendeten Bauteil signifikant sowohl zum Elektronen- als auch zum Lochtransport beiträgt, also sowohl elektronenals auch lochleitende Eigenschaften umfasst. Dem Fachmann ist weiterhin bekannt, dass dies dadurch zu erreichen ist, dass ein Material ausgewählt wird, (a) in das aufgrund seiner Energieniveaulagen im Vergleich zu den Energieniveaulagen weiterer in derselben Mischung verwendeter Materialien signifikant sowohl Elektronen als auch Löcher injiziert

werden und (b) in dem der Transport nicht aufgrund extrem niedriger Elektronen- oder Lochmobilität (kleiner als $10^{-8}$ $cm^2/(Vs)$) unterdrückt ist. Die Messung von Elektronen- und Lochmobilitäten werden routinemäßig vom Fachmann mittels Standardverfahren durchgeführt.

Der Fachmann kann für die Auswahl geeigneter bipolarer Hosts auf eine große Anzahl bekannter Hosts zurückgreifen und sie beispielsweise mit ebenfalls bekannten Emittern mit dazu passenden Energieniveaulagen kombinieren.

Bevorzugte bipolare Hosts sind ausgewählt aus der Gruppe der Triazine, Pyrimidine, Pyrazine, Pyridine, Pyrazole, Pyridazine, Chinoline, Isochinoline, Chinoxaline, Chinazoline, Thiazole, Benzothiazole, Oxazole, Oxadiazole, Benzoxazole, Imidazole, Benzimidazole, Carbazole, Indenocarbazole, Indolocarbazole, Phosphinoxide, Phenylsulfonyle, Ketone, Lactame, Phenantroline und Triarylamine, wobei die Triazine, Pyrimidine, Chinazoline, Benzimidazole, Carbazole, Indenocarbazole, Indolocarbazole, Ketone, Lactame und Triarylamine besonders bevorzugt sind. Ganz besonders bevorzugte bipolare Hosts sind dabei ausgewählt aus der Gruppe der Triazine, Pyrimidine, Chinazoline, Benzimidazole, Carbazole und Indenocarbazole, wobei die Triazine, Pyrimidine, Carbazole und Indenocarbazole insbesondere bevorzugt sind.

Häufig werden bipolare Hosts durch sogenannte Hybridsysteme dargestellt. Hybridsysteme sind dadurch charakterisiert, dass sie sowohl wenigstens eine elektronentransportierende Gruppe (ET) als auch wenigstens eine lochtransportierende Gruppe (HT) enthalten, wobei dies im Allgemeinen Gruppen sind, die durch ihren Elektronenreichtum bzw. ihre Elektronenarmut ein für Lochinjektion geeignetes HOMO bzw. ein für Elektroneninjektion geeignetes LUMO erzielen.

Der bipolare Host der erfindungsgemäßen Zusammensetzung wird in Anspruch 1 der vorliegenden Erfindung im Detail beschrieben und basiert auf einer Verbindung der allgemeinen Formel (1):

$$ET\text{-}(L)_n\text{-}HT\text{-}(R^4)_q \qquad \text{Formel (1)}$$

wobei für die verwendeten Symbole und Indizes gilt:

ET ist eine organische elektronentransportierende Gruppe (ET) aus der Gruppe der elektronenarmen heteroaromatischen Gruppen, wobei die Gruppe ET bevorzugt eine Heteroarylgruppe mit 5 bis 60 aromatischen Ringatomen ist, wobei Stickstoffatome ganz bevorzugte Heteroatome darstellen, und ganz besonders bevorzugte Gruppen ET ausgewählt sind aus der Gruppe der Triazine, Pyrimidine, Pyrazine, Pyrazole, Pyridine, Pyridazine, Chinoline, Isochinoline, Chinoxaline, Chinazoline, Thiazole, Benzothiazole, Oxazole, Oxadiazole, Benzoxazole, Imidazole und Benzimidazole, wobei die Gruppe ET mit einem oder mehreren voneinander unabhängigen Resten $R^1$ substituiert sein kann;

HT ist eine organische lochtransportierende Gruppe (HT) aus der Gruppe der elektronenreichen heteroaromatischen Gruppen, wobei die Gruppe HT bevorzugt eine Heteroarylgruppe mit 5 bis 60 aromatischen Ringatomen ist, wobei Stickstoffatome ganz bevorzugte Heteroatome darstellen, und ganz besonders bevorzugte Gruppen HT ausgewählt sind aus der Gruppe Carbazole, Indenocarbazole, Indolocarbazole, Phenantroline und Triethylamine, wobei die Gruppe HT mit einem oder mehreren voneinander unabhängigen Resten $R^{1'}$ substituiert sein kann;

L ist eine verbrückende Gruppe C(=O), $S(=O)_2$, $P(=O)(R^{1''})$ oder ein aromatisches oder heteroaromatisches Ringsystem mit 5 bis 30 aromatischen Ringatomen, das durch einen oder mehreren voneinander unabhängigen Reste $R^{1''}$ substituiert sein kann;

n ist 0, 1, 2, 3 oder 4, bevorzugt 0 oder 1, ganz bevorzugt 1;

q ist eine ganze Zahle von 1 bis 5, bevorzugt von 1 bis 4, besonders bevorzugt von 1 bis 3, ganz bevorzugt von 1 bis 2, ganz besonders bevorzugt genau 2 und am meisten bevorzugt genau 1;

$R^1$, $R^{1'}$, $R^{1''}$ ist gleich oder verschieden bei jedem Auftreten H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy-, Alkylalkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C{=}CR^2$, $C{\equiv}C$, $Si(R^2)_2$, $Ge(R^2)_2$, $Sn(R^2)_2$, C=O, C=S, C=Se, $C{=}NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches

oder heteroaromatisches Ringsystem mit 5 bis 60 aromatischen Ringatomen, das jeweils durch einen oder mehrere Reste $R^2$ substituiert sein kann, oder eine Aryloxy-, Arylalkoxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination aus zwei oder mehr dieser Gruppen; dabei können zwei oder mehrere benachbarte Reste $R^1$, $R^{1'}$ oder $R^{1''}$ miteinander ein mono- oder polycyclisches, aliphatisches oder aromatisches Ringsystem bilden, wobei bevorzugt ist, wenn zwei oder mehr benachbarte Reste $R^1$, $R^{1'}$ oder $R^{1''}$ miteinander kein mono- oder polycyclisches, aliphatisches oder aromatisches Ringsystem bilden;

$R^2$ ist gleich oder verschieden bei jedem Auftreten H, D, F, Cl, Br, I, $N(R^3)_2$, CN, $NO_2$, $Si(R^3)_3$, $B(OR^3)_2$, $C(=O)R^3$, $P(=O)(R^3)_2$, $S(=O)R^3$, $S(=O)_2R^3$, $OSO_2R^3$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy-, Alkylalkoxy- oder Thioalkoxygruppe mit 3 bis 40 C-Atomen, die jeweils mit einem oder mehreren Resten $R^3$ substituiert sein kann, wobei eine oder mehrere nicht benachbarte $CH_2$-Gruppen durch $R^3C{=}CR^3$, $C{\equiv}C$, $Si(R^3)_2$, $Ge(R^3)_2$, $Sn(R^3)_2$, C=O, C=S, C=Se, $C{=}NR^3$, $P(=O)(R^3)$, SO, $SO_2$, $NR^3$, O, S oder $CONR^3$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^3$ substituiert sein kann, oder eine Aryloxy-, Arylalkoxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination aus zwei oder mehr dieser Gruppen; dabei können zwei oder mehrere benachbarte Reste $R^2$ miteinander ein mono- oder polycyclisches, aliphatisches oder aromatisches Ringsystem bilden;

$R^3$ ist gleich oder verschieden bei jedem Auftreten H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^3$ auch miteinander ein mono- oder polycyclisches, aliphatisches oder aromatisches Ringsystem bilden;

$R^4$ ist gleich oder verschieden bei jedem Auftreten $N(R^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy-, Alkylalkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C{=}CR^2$, $C{\equiv}C$, $Si(R^2)_2$, $Ge(R^2)_2$, $Sn(R^2)_2$, C=O, C=S, C=Se, $C{=}NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy-, Arylalkoxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination aus zwei oder mehr dieser Gruppen; dabei können zwei oder mehrere benachbarte Reste $R^4$ miteinander ein mono- oder polycyclisches, aliphatisches oder aromatisches Ringsystem bilden.

Die Verbindungen der allgemeinen Formel (1) enthalten definitionsgemäß immer wenigstens einen Substituenten $R^4$, der ungleich Wasserstoff ist.

Sofern zwei oder mehr benachbarte Reste miteinander kein mono- oder polycyclisches, aliphatisches oder aromatisches oder heteroaromatisches Ringsystem bilden, dürfen diese Reste nicht Teil eines Rings oder Ringsystems werden. Ist beispielsweise der Rest $R^1$ so definiert, dass zwei oder mehr benachbarte Reste $R^1$ miteinander kein mono- oder polycyclisches, aliphatisches oder aromatisches oder heteroaromatisches Ringsystem bilden, die Reste $R^1$ ihrerseits aber wieder mit Resten $R^2$ substituiert sein können, wobei zwei oder mehr benachbarte Reste $R^2$ miteinander ein mono- oder polycyclisches, aliphatisches oder aromatisches oder heteroaromatisches Ringsystem bilden können, dann darf der Ringschluss der Reste $R^2$ nicht in der Art erfolgen, dass dadurch die Reste $R^1$ Teil eines Ringes oder Ringsystems werden.

Unter der Formulierung, dass zwei oder mehr Reste miteinander einen Ring bilden können, soll im Rahmen

der vorliegenden Anmeldung unter anderem verstanden werden, dass die beiden Reste miteinander durch eine chemische Bindung verknüpft sind. Dies wird durch das folgende Schema verdeutl icht:

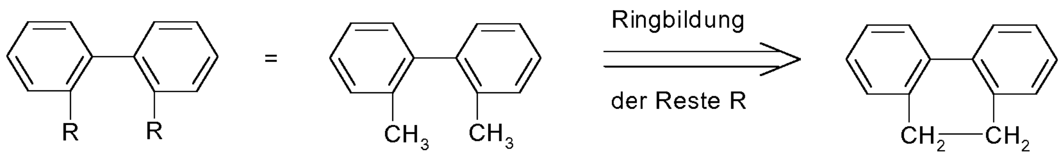


Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

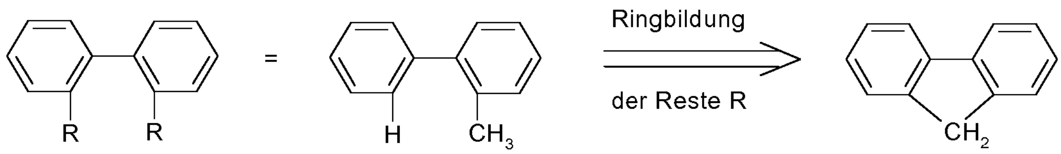


Unter einer kondensierten (annellierten) Arylgruppe wird dabei eine Arylgruppe verstanden, welche zwei oder mehr aromatische Ringe enthält, die miteinander kondensiert sind, d. h. eine oder mehr aromatische Bindungen miteinander teilen. Eine entsprechende Definition gilt für Heteroarylgruppen. Beispiele für kondensierte Arylgruppen ungeachtet der Zahl ihrer Ringatome sind Naphthyl, Anthracenyl, Pyrenyl, Phenanthrenyl und Perylenyl. Beispiele für kondensierte Heteroarylgruppen sind Chinolinyl, Indolyl, Carbazolyl, und Acridinyl.

Es folgen allgemeine Definitionen für chemische Gruppen im Rahmen der vorliegenden Anmeldung:
Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind bevorzugt ausgewählt aus N, O und S. Dies stellt die grundlegende Definition dar. Werden in der Beschreibung der vorliegenden Erfindung andere Bevorzugungen angegeben, beispielsweise bezüglich der Zahl der aromatischen Ringatome oder der enthaltenen Heteroatome, so gelten diese.

Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin oder Thiophen, oder ein kondensierter (annellierter) aromatischer bzw. heteroaromatischer Polycyclus, beispielsweise Naphthalin, Phenanthren, Chinolin oder Carbazol verstanden. Ein kondensierter (annellierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Eine elektronenarme heteroaromatische bzw. Heteroarylgruppe im Sinne der vorliegenden Erfindung ist definiert als 5-Ring-Heteroarylgruppe mit mindestens zwei Heteroatomen, beispielsweise Imidazol, Oxazol, Oxadiazol, etc., oder als 6-Ring-Heteroarylgruppe mit mindestens einem Heteroatom, beispielsweise Pyridin, Pyrimidin, Pyrazin, Triazin, etc.. Dabei können an diese Gruppen auch noch weitere 6-Ring-Aryl- oder 6-Ring-Heteroarylgruppen ankondensiert sein, wie dies beispielsweise in Benzimidazol, Chinolin oder Chinazolin der Fall ist.

Eine elektronenreiche heteroaromatische bzw. Heteroarylgruppen im Sinne der vorliegenden Erfindung sind solche Ringsysteme, die als Heteroarylgruppe Pyrrol, Furan, Thiophen, Benzothiophen, Benzofuran, Indol, Carbazol, Dibenzothiophen, Dibenzofuran, Azacarbazol und/oder Arylamine enthalten.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Unter einer Aryloxygruppe gemäß der Definition der vorliegenden Erfindung wird eine Arylgruppe, wie oben

definiert, verstanden, welche über ein Sauerstoffatom gebunden ist. Eine analoge Definition gilt für Heteroaryloxygruppen.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein $sp^3$-hybridisiertes C-, Si-, N- oder O-Atom, ein $sp^2$-hybridisiertes C- oder N-Atom oder ein sp-hybridisiertes C-Atom, verbunden sein können. So sollen beispielsweise auch Systeme wie 9,9'-Spirobifluoren, 9,9'-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Aryl- oder Heteroarylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 bis 60 bzw. 5 bis 30 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Naphthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Kombinationen dieser Gruppen.

Im Rahmen der vorliegenden Erfindung werden unter einem aliphatischen Kohlenwasserstoffrest bzw. einer geradkettigen Alkylgruppe mit 1 bis 40 C-Atomen bzw. einer verzweigten oder cyclischen Alkylgruppe mit 3 bis 40 C-Atomen bzw. einer Alkenyl- oder Alkinylgruppe mit 2 bis 40 C-Atomen, in der auch einzelne H-Atome oder $CH_2$-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neo-Pentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer Alkoxy- oder Thioalkylgruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Die Gruppe ET ist vorzugsweise eine elektronenarme heteroaromatische Gruppe, die mit einem oder mehreren Resten $R^1$ substituiert sein kann. Noch stärker bevorzugt sind heteroaromatische Gruppen mit 6 aromatischen Ringatomen, von denen mindestens eines, bevorzugt 2 und ganz bevorzugt mindestens drei ein N-Atom sind, oder heteroaromatische Gruppen mit 5 aromatischen Ringatomen, von denen mindestens 2 Heteroatome sind, bevorzugt mindestens eines davon ein N-Atom, das mit $R^1$ substituiert sein kann, wobei an diese Gruppen jeweils auch weitere Aryl- oder Heteroarylgruppen ankondensiert sein können.

Bevorzugte Beispiele für elektronenarme heteroaromatische Gruppen sind: Pyridine, Pyrazine, Pyrimidine, Pyridazine, 1,2,4-Triazine, 1,3,5-Triazine, Chinoline, Isochinoline, Chinoxaline, Chinazoline, Pyrazole, Imidazole, Benzimidazole, Thiazole, Benzothiazole, Oxazole oder Benzooxazole, die jeweils mit $R^1$ substituiert sein können. Noch

mehr bevorzugt ist die elektronentransportierende Gruppe ein mit einem oder mehreren Resten $R^1$ substituiertes Pyridin, Pyrazin, Pyrimidin, Pyridazin, 1,3,5-Triazin, Benzimidazol und Chinazolin.

Elektronenarme heteroaromatische Gruppen sind ausgewählt aus den Formeln

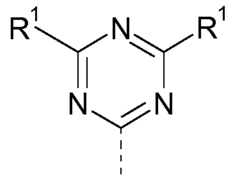

Formel (ET-12)

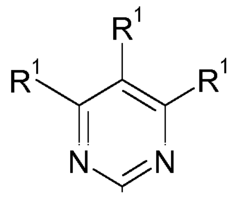

Formel (ET-13)

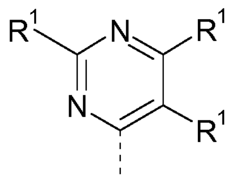

Formel (ET-14)

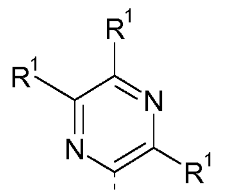

Formel (ET-15)

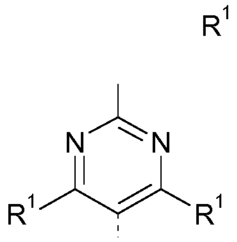

Formel (ET-16)

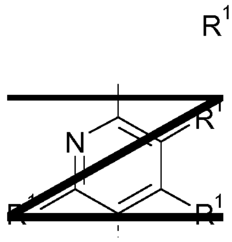

~~Formel (ET-17)~~

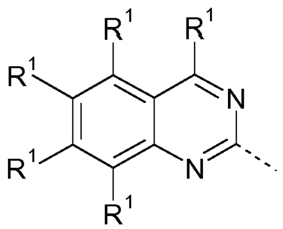

Formel (ET-20),

wobei Gruppen der Formeln (ET-12), (ET-13), (ET-14), (ET-15), ET-16) und (ET-20) ganz besonders bevorzugt sind, und Gruppen der Formel (ET-12) am meisten bevorzugt sind.

Die Substituenten $R^1$ in der Gruppe ET sind vorzugsweise ausgewählt aus der Gruppe bestehend aus H oder einem aromatischen oder heteroaromatischen Ringsystem mit 5 bis 60 aromatischen Ringatomen, das jeweils durch einen oder mehrere Reste $R^2$ substituiert sein kann, wobei bevorzugt ist, dass eine Gruppe ET, die mit einem oder mehreren Resten $R^1$ substituiert ist, keine elektronenreichen aromatischen oder heteroaromatischen Ringe oder Ringsysteme enthält.

Beispiele ganz besonders bevorzugter Gruppen ET sind die folgenden Gruppen, die mit einem oder mehreren voneinander unabhängigen Resten $R^2$ substituiert sein können, wobei die gestrichelten Bindungen die Bindungsposition zu der verbrückenden Gruppe $(L)_n$ oder der Gruppe HT (für n = 0) kennzeichnen.

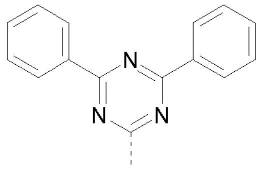

Formel (ET-21)

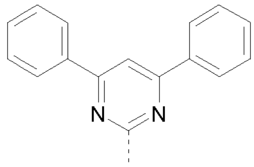

Formel (ET-22)

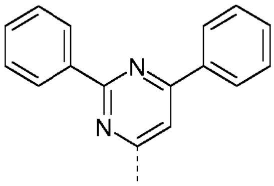

Formel (ET-23)

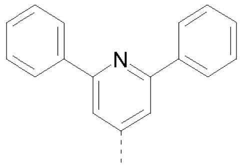

Formel (ET-24)

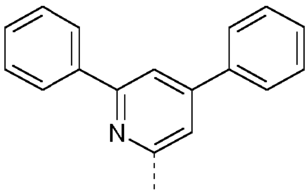

Formel (ET-25)

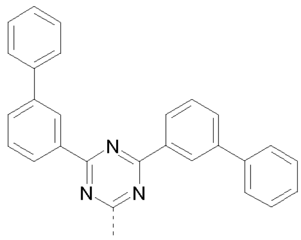

Formel (ET-26)

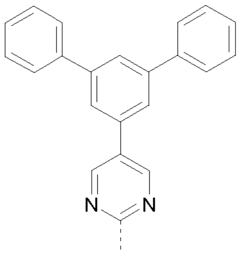

Formel (ET-27)

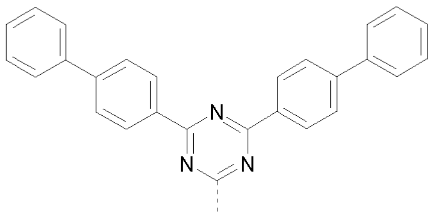

Formel (ET-28)

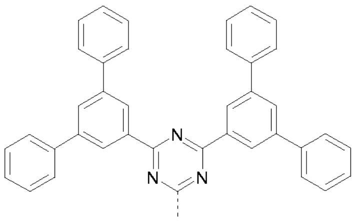

Formel (ET-29)

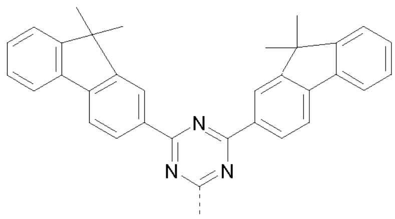

Formel (ET-30)

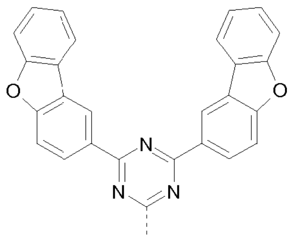

Formel (ET-31)

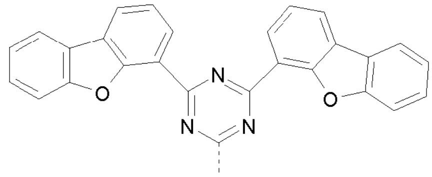

Formel (ET-32)

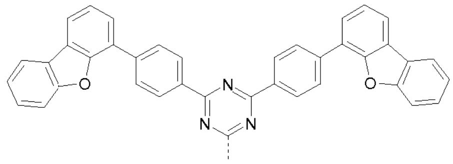

Formel (ET-33)

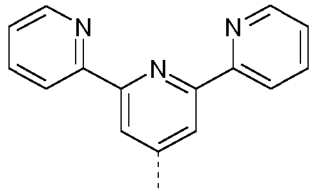

Formel (ET-34)

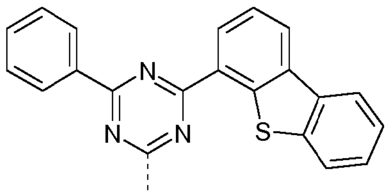

Formel (ET-35)

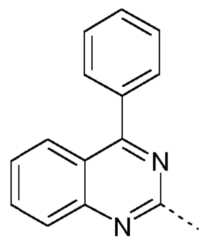

Formel (ET-36)

Die Gruppe HT ist vorzugsweise eine elektronenreiche heteroaromatische Gruppe, die mit einem oder mehreren Resten $R^{1'}$ substituiert sein kann und die mit mindestens 1 und maximal 5 Resten $R^4$ substituiert ist. Noch stärker bevorzugt sind aromatische heterocyclische Gruppen mit 3 bis 5 aneinanderkondensierten Arylgruppen mit jeweils 5 oder 6 aromatischen Ringatomen, von denen mindestens eine Gruppe, bevorzugt 1 oder 2 Gruppen, und ganz bevorzugt genau eine Gruppe eine Heteroarylgruppe mit 5 aromatischen Ringatomen ist, wobei von den Ringatomen eines ein Heteroatom, bevorzugt ein N-Atom, das mit $R^{1'}$ oder $R^4$ substituiert sein kann, ist.

Die elektronenreiche heteroaromatische Gruppe (HT) weist in einer bevorzugten Ausführungsform eine Struktur gemäß der nachstehenden Formel (HT-1) auf:

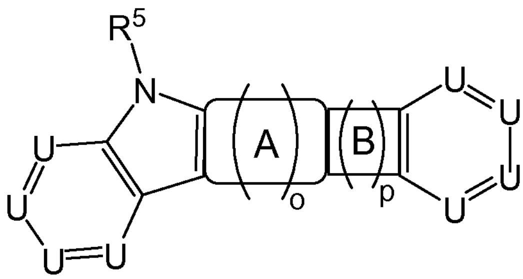

Formel (HT-1)

wobei gilt:

A, B sind gleich oder verschieden voneinander ein aromatischer oder heteroaromatischer Ring mit 5 oder 6 aromatischen Ringatomen, der mit einem oder mehreren Resten $R^5$ substituiert sein kann;

o, p sind gleich oder verschieden voneinander 0 oder 1;

U ist gleich oder verschieden bei jedem Auftreten $CR^5$, N oder O, wobei pro Cyclus maximal zwei U, die nicht nebeneinander stehen, für N oder O stehen und wobei U für Kohlenstoff steht, falls an diese Position eine Gruppe $(L)_n$ oder eine Gruppe ET (für n = 0) angebunden ist;

$R^5$ ist gleich oder verschieden bei jedem Auftreten entweder $R^{1'}$ oder $R^4$,

mit der Maßgabe, dass in der Struktur der Formel (HT-1) 1 bis 5 Reste $R^5$ vorhanden sind, die $R^4$ entsprechen, wobei $R^{1'}$ und $R^4$ die oben genannten Bedeutungen aufweisen.

In der Struktur der Formel (HT-1) ist es bevorzugt, wenn sowohl o als auch p gleich 0 oder gleich 1 sind, also gleichermaßen entweder den Wert 0 oder 1 annehmen. Besonders bevorzugt sind o und p beide gleich 0.

Falls sowohl o als auch p den Wert 1 annehmen, ist es bevorzugt, wenn die Ringe A und B eine unterschiedliche Anzahl an aromatischen Ringatomen aufweisen. Das heißt, wenn A ein aromatischer oder heteroaromatischer Ring mit 6 aromatischen Ringatomen ist, dann ist B vorzugsweise ein aromatischer oder heteroaromatischer Ring mit 5 aromatischen Ringatomen, und umgekehrt.

Zudem ist es bevorzugt, falls A und/oder B einen heteroaromatischen Ring darstellen, dass höchstens zwei, besonders bevorzugt genau eines der aromatischen Ringatomen ein Heteroatom, ausgewählt aus N oder O, bevorzugt N, darstellen.

U ist in der Struktur der Formel (HT-1) gleich oder verschieden bei jedem Auftreten $CR^5$, N oder O, wobei die maximal zwei U pro Cyclus, die nicht nebeneinander stehen, bevorzugt für N stehen. Besonders bevorzugt steht U für $CR^5$.

Besonders bevorzugte Beispiele elektronenreicher heteroaromatischer Gruppen HT sind Carbazole, Indenocarbazole und Indolocarbazole, wobei Carbazole ganz besonders bevorzugt sind.

Bevorzugte Ausführungsformen der Indenocarbazolgruppe, der Indolocarbazolgruppe oder der Carbazolgruppe sind die Strukturen der folgenden Formeln:

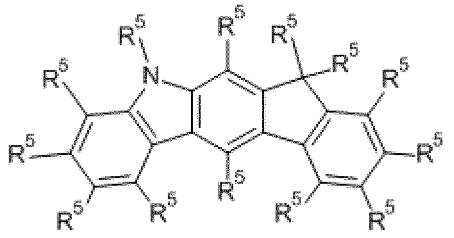

Formel (HT-2)

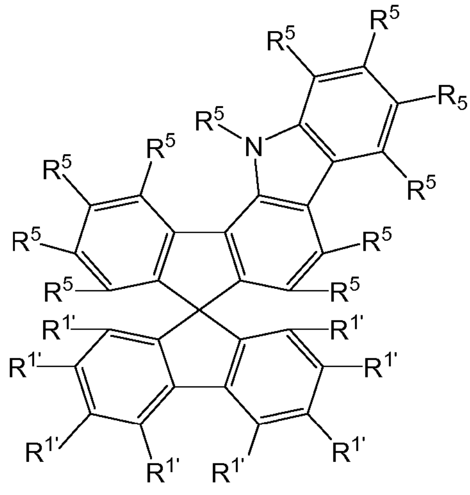

Formel (HT-3)

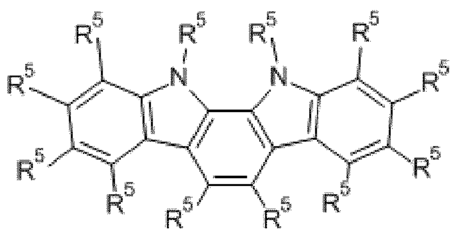

Formel (HT-4)

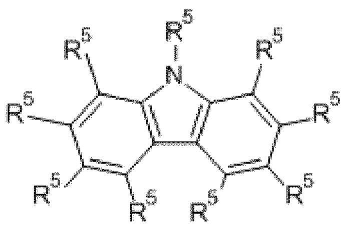

Formel (HT-5),

wobei $R^5$ gleich oder verschieden bei jedem Auftreten entweder $R^{1'}$ oder $R^4$ ist, mit der Maßgabe, dass die Gruppen (HT-2), (HT-3), (HT-4) und (HT-5) jeweils statt einem der Reste $R^5$ eine Bindung zu der verbrückenden Gruppe $(L)_n$ oder der Gruppe ET (für n = 0) aufweisen und dass in den Gruppen (HT-2), (HT-3), (HT-4) und (HT-5) jeweils 1 bis 5 Reste $R^5$ vorhanden sind, die $R^4$ entsprechen, und wobei $R^{1'}$ und $R^4$ die vorstehend genannten Bedeutungen aufweisen.

Die Bindung der 1 bis 5 Reste $R^4$ kann an alle noch nicht substituierten Positionen der Gruppen (HT-2), (HT-3), (HT-4) und (HT-5) erfolgen.

Die vorstehend genannten Gruppen ET und HT können beliebig miteinander kombiniert werden.

Beispiele bipolarer Hosts, die für einen Einsatz in der erfindungsgemäßen Zusammensetzung geeignet ist, sind daher Verbindungen der nachfolgenden allgemeinen Formeln, wobei die Beispiele (1-2) bis (1-45) und (1-66) bis (1-77) nicht unter den Gegenstand des Anspruchs 1 fallen und als Referenzbeispiele dienen:

| | | | |
|---|---|---|---|
| (1-2) | (ET-1)-$(L)_n$-(HT-2)-$(R^4)_q$ | (1-3) | (ET-1)-$(L)_n$-(HT-3)-$(R^4)_q$ |
| (1-4) | (ET-1)-$(L)_n$-(HT-4)-$(R^4)_q$ | (1-5) | (ET-1)-$(L)_n$-(HT-5)-$(R^4)_q$ |
| (1-6) | (ET-2)-$(L)_n$-(HT-2)-$(R^4)_q$ | (1-7) | (ET-2)-$(L)_n$-(HT-3)-$(R^4)_q$ |
| (1-8) | (ET-2)-$(L)_n$-(HT-4)-$(R^4)_q$ | (1-9) | (ET-2)-$(L)_n$-(HT-5)-$(R^4)_q$ |
| (1-10) | (ET-3)-$(L)_n$-(HT-2)-$(R^4)_q$ | (1-11) | (ET-3)-$(L)_n$-(HT-3)-$(R^4)_q$ |
| (1-12) | (ET-3)-$(L)_n$-(HT-4)-$(R^4)_q$ | (1-13) | (ET-3)-$(L)_n$-(HT-5)-$(R^4)_q$ |
| (1-14) | (ET-4)-$(L)_n$-(HT-2)-$(R^4)_q$ | (1-15) | (ET-4)-$(L)_n$-(HT-3)-$(R^4)_q$ |
| (1-16) | (ET-4)-$(L)_n$-(HT-4)-$(R^4)_q$ | (1-17) | (ET-4)-$(L)_n$-(HT-5)-$(R^4)_q$ |

(fortgesetzt)

| | | | |
|---|---|---|---|
| (1-18) | (ET-5)-$(L)_n$-(HT-2)-$(R^4)_q$ | (1-19) | (ET-5)-$(L)_n$-(HT-3)-$(R^4)_q$ |
| (1-20) | (ET-5)-$(L)_n$-(HT-4)-$(R^4)_q$ | (1-21) | (ET-5)-$(L)_n$-(HT-5)-$(R^4)_q$ |
| (1-22) | (ET-6)-$(L)_n$-(HT-2)-$(R^4)_q$ | (1-23) | (ET-6)-$(L)_n$-(HT-3)-$(R^4)_q$ |
| (1-24) | (ET-6)-$(L)_n$-(HT-4)-$(R^4)_q$ | (1-25) | (ET-6)-$(L)_n$-(HT-5)-$(R^4)_q$ |
| (1-26) | (ET-7)-$(L)_n$-(HT-2)-$(R^4)_q$ | (1-27) | (ET-7)-$(L)_n$-(HT-3)-$(R^4)_q$ |
| (1-28) | (ET-7)-$(L)_n$-(HT-4)-$(R^4)_q$ | (1-29) | (ET-7)-$(L)_n$-(HT-5)-$(R^4)_q$ |
| (1-30) | (ET-8)-$(L)_n$-(HT-2)-$(R^4)_q$ | (1-31) | (ET-8)-$(L)_n$-(HT-3)-$(R^4)_q$ |
| (1-32) | (ET-8)-$(L)_n$-(HT-4)-$(R^4)_q$ | (1-33) | (ET-8)-$(L)_n$-(HT-5)-$(R^4)_q$ |
| (1-34) | (ET-9)-$(L)_n$-(HT-2)-$(R^4)_q$ | (1-35) | (ET-9)-$(L)_n$-(HT-3)-$(R^4)_q$ |
| (1-36) | (ET-9)-$(L)_n$-(HT-4)-$(R^4)_q$ | (1-37) | (ET-9)-$(L)_n$-(HT-5)-$(R^4)_q$ |
| (1-38) | (ET-10)-$(L)_n$-(HT-2)-$(R^4)_q$ | (1-39) | (ET-10)-$(L)_n$-(HT-3)-$(R^4)_q$ |
| (1-40) | (ET-10)-$(L)_n$-(HT-4)-$(R^4)_q$ | (1-41) | (ET-10)-$(L)_n$-(HT-5)-$(R^4)_q$ |
| (1-42) | (ET-11)-$(L)_n$-(HT-2)-$(R^4)_q$ | (1-43) | (ET-11)-$(L)_n$-(HT-3)-$(R^4)_q$ |
| (1-44) | (ET-11)-$(L)_n$-(HT-4)-$(R^4)_q$ | (1-45) | (ET-11)-$(L)_n$-(HT-5)-$(R^4)_q$ |
| (1-46) | (ET-12)-$(L)_n$-(HT-2)-$(R^4)_q$ | (1-47) | (ET-12)-$(L)_n$-(HT-3)-$(R^4)_q$ |
| (1-48) | (ET-12)-$(L)_n$-(HT-4)-$(R^4)_q$ | (1-49) | (ET-12)-$(L)_n$-(HT-5)-$(R^4)_q$ |
| (1-50) | (ET-13)-$(L)_n$-(HT-2)-$(R^4)_q$ | (1-51) | (ET-13)-$(L)_n$-(HT-3)-$(R^4)_q$ |
| (1-52) | (ET-13)-$(L)_n$-(HT-4)-$(R^4)_q$ | (1-53) | (ET-13)-$(L)_n$-(HT-5)-$(R^4)_q$ |
| (1-54) | (ET-14)-$(L)_n$-(HT-2)-$(R^4)_q$ | (1-55) | (ET-14)-$(L)_n$-(HT-3)-$(R^4)_q$ |
| (1-56) | (ET-14)-$(L)_n$-(HT-4)-$(R^4)_q$ | (1-57) | (ET-14)-$(L)_n$-(HT-5)-$(R^4)_q$ |
| (1-58) | (ET-15)-$(L)_n$-(HT-2)-$(R^4)_q$ | (1-59) | (ET-15)-$(L)_n$-(HT-3)-$(R^4)_q$ |
| (1-60) | (ET-15)-$(L)_n$-(HT-4)-$(R^4)_q$ | (1-61) | (ET-15)-$(L)_n$-(HT-5)-$(R^4)_q$ |
| (1-62) | (ET-16)-$(L)_n$-(HT-2)-$(R^4)_q$ | (1-63) | (ET-16)-$(L)_n$-(HT-3)-$(R^4)_q$ |
| (1-64) | (ET-16)-$(L)_n$-(HT-4)-$(R^4)_q$ | (1-65) | (ET-16)-$(L)_n$-(HT-5)-$(R^4)_q$ |
| (1-66) | (ET-17)-$(L)_n$-(HT-2)-$(R^4)_q$ | (1-67) | (ET-17)-$(L)_n$-(HT-3)-$(R^4)_q$ |
| (1-68) | (ET-17)-$(L)_n$-(HT-4)-$(R^4)_q$ | (1-69) | (ET-17)-$(L)_n$-(HT-5)-$(R^4)_q$ |
| (1-70) | (ET-18)-$(L)_n$-(HT-2)-$(R^4)_q$ | (1-71) | (ET-18)-$(L)_n$-(HT-3)-$(R^4)_q$ |
| (1-72) | (ET-18)-$(L)_n$-(HT-4)-$(R^4)_q$ | (1-73) | (ET-18)-$(L)_n$-(HT-5)-$(R^4)_q$ |
| (1-74) | (ET-19)-$(L)_n$-(HT-2)-$(R^4)_q$ | (1-75) | (ET-19)-$(L)_n$-(HT-3)-$(R^4)_q$ |
| (1-76) | (ET-19)-$(L)_n$-(HT-4)-$(R^4)_q$ | (1-77) | (ET-19)-$(L)_n$-(HT-5)-$(R^4)_q$ |
| (1-78) | (ET-20)-$(L)_n$-(HT-2)-$(R^4)_q$ | (1-79) | (ET-20)-$(L)_n$-(HT-3)-$(R^4)_q$ |
| (1-80) | (ET-20)-$(L)_n$-(HT-4)-$(R^4)_q$ | (1-81) | (ET-20)-$(L)_n$-(HT-5)-$(R^4)_q$ |

$R^4$, q und n haben die zuvor genannte Bedeutung.

Die Gruppen (HT-1) bis (HT-5) weisen bevorzugt 1 bis 4, besonders bevorzugt 1 bis 3, ganz bevorzugt 1 bis 2, ganz besonders bevorzugt genau 2 und am meisten bevorzugt genau 1 Rest $R^5$ auf, der einem Rest $R^4$ entspricht.

Besonders bevorzugte Ausführungsformen der Indenocarbazolgruppe, der Indolocarbazolgruppe oder der Carbazolgruppe sind deshalb die Strukturen der folgenden Formeln:

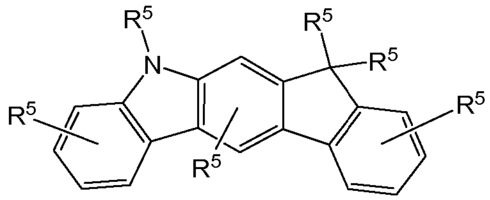

Formel (HT-6)

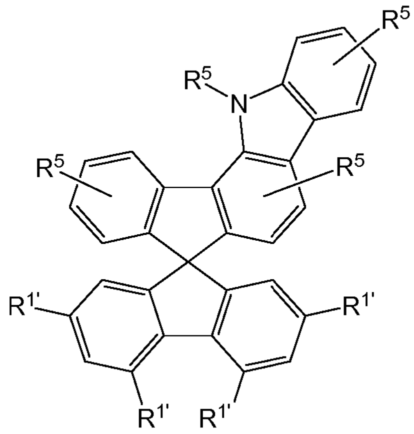

Formel (HT-7)

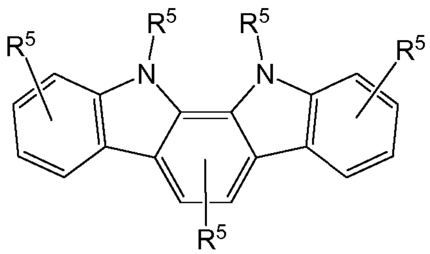

Formel (HT-8)

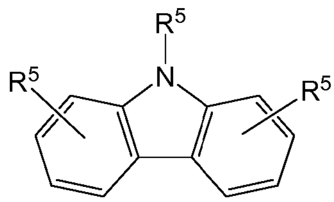

Formel (HT-9),

wobei die verwendeten Symbole die oben genannten Bedeutungen aufweisen und wobei in den Gruppen der Formeln (HT-6), (HT-7), (HT-8) und (HT-9) genau zwei, bevorzugt genau ein Rest $R^5$ einem Rest $R^4$ entspricht und jeweils einer der anderen Reste $R^5$ einer Bindung zu der verbrückenden Gruppe $(L)_n$ oder der Gruppe ET (für n = 0) entspricht.

Für die Fälle, in denen $R^5$ in der Gruppe HT einem Rest $R^{1'}$ entspricht, ist $R^{1'}$ bevorzugt ausgewählt aus der Gruppe bestehend aus H oder einem aromatischen oder heteroaromatischen Ring oder Ringsystem mit 5 bis 30 Ringatomen, wobei der Ring oder das Ringsystem jeweils durch einen oder mehrere Reste $R^2$ substituiert sein kann, bevorzugt aber unsubstituiert ist.

$R^{1'}$ ist ganz bevorzugt H oder ein aromatischer Ring oder Ringsystem mit 5 bis 30 Ringatomen, wobei der Ring oder das Ringsystem jeweils durch einen oder mehrere Reste $R^2$ substituiert sein kann, wobei es noch bevorzugter ist, wenn $R^{1'}$ unsusbtituiert ist. Ganz besonders bevorzugte aromatische Gruppen sind Phenyl, Biphenyl, Terphenyl und Quarterphenyl.

$R^{1'}$ ist weiterhin ganz bevorzugt H oder ein heteroaromatischer Ring oder Ringsystem mit 5 bis 30 Ringatomen, wobei der Ring oder das Ringsystem jeweils durch einen oder mehrere Reste $R^2$ substituiert sein kann, wobei es noch bevorzugter ist, wenn $R^{1'}$ unsusbtituiert ist. Ganz besonders bevorzugte heteroaromatische Gruppen sind Furan, Dibenzofuran, Thiophen, Benzothiophen, Dibenzothiophen, Carbazol, Phenanthridin und Chinoxalin.

In einer bevorzugten Ausführungsform der Erfindung enthält der bipolare Host mindestens eine der Gruppen (ET-12) bis (ET-16) und (ET-20)

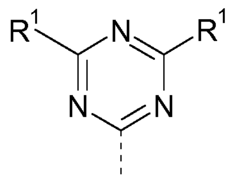

Formel (ET-12)

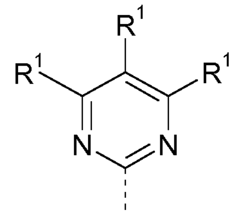

Formel (ET-13)

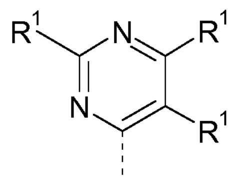

Formel (ET-14)

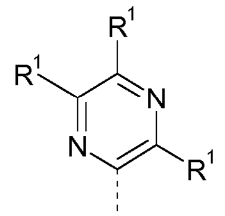

Formel (ET-15)

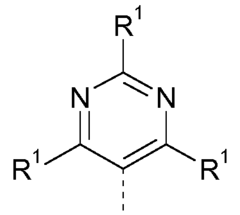

Formel (ET-16)

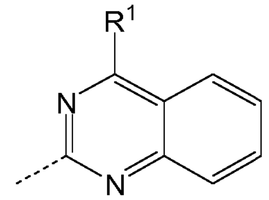

Formel (ET-20),

die über eine verbrückende Gruppe $(L)_n$ oder direkt an eine Gruppe HT (für n=0), die ausgewählt ist aus den Strukturen der Formeln (HT-6), (HT-7), (HT-8) und (HT-9), gebunden ist, wobei L, n und $R^1$ die zuvor genannten Bedeutungen aufweisen und die gestrichelte Bindung die Anbindungsposition zu $(L)_n$ oder der Gruppe HT (für n = 0) markiert.

Carbazole der Gruppe (HT-9) sind dabei ganz besonders bevorzugte elektronenreiche heteroaromatische Gruppen HT.

Der bipolare Host ist deshalb besonders bevorzugt ausgewählt aus den Verbindungen der Formeln (1a-1) bis (1a-6) und (1b-1) bis (1b-6),

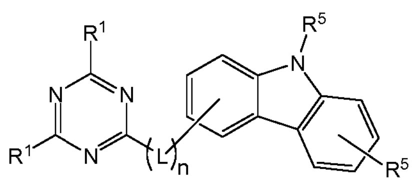

Formel (1a-1)

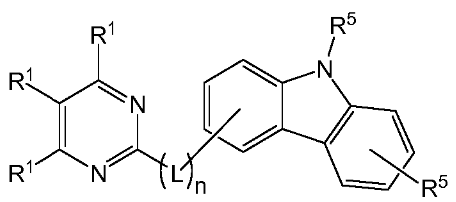

Formel (1a-2)

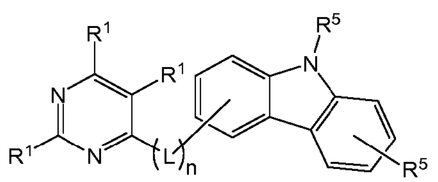

Formel (1a-3)

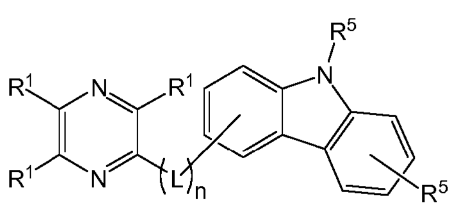

Formel (1a-4)

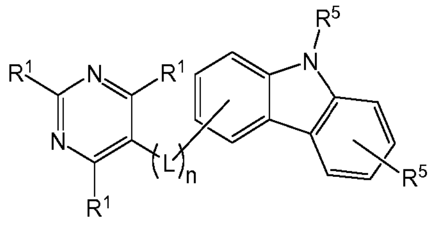

Formel (1a-5)

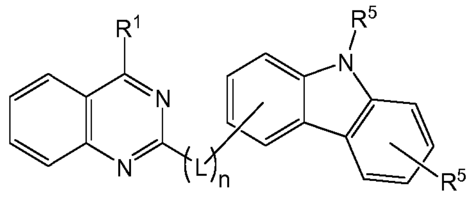

Formel (1a-6)

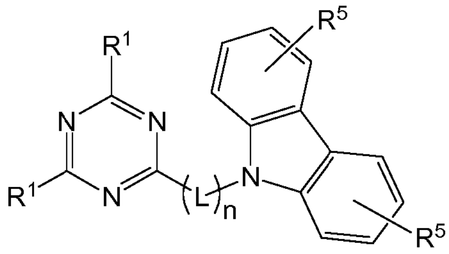

Formel (1b-1)

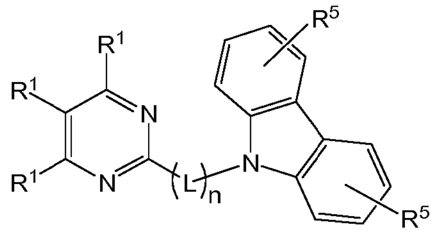

Formel (1b-2)

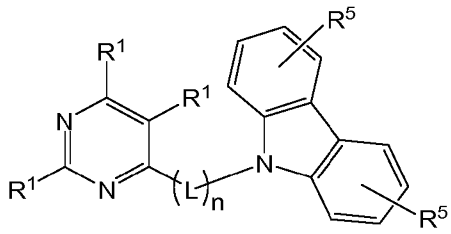

Formel (1b-3)

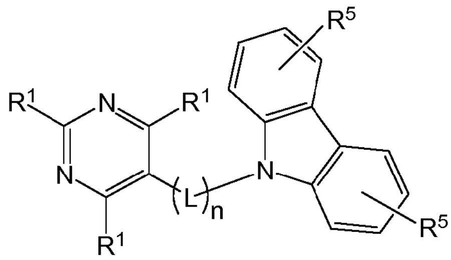

Formel (1b-4)

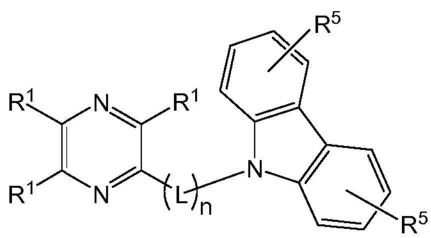

Formel (1b-5)

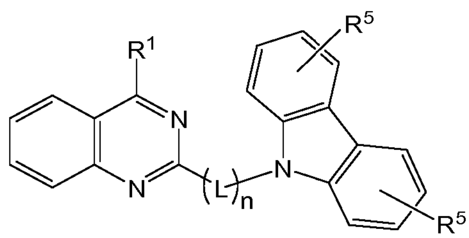

Formel (1b-6)

wobei L, n, $R^1$ und $R^5$ die zuvor genannten Bedeutungen aufweisen.

Wie vorstehend bereits erläutert wurde ist n gleich 0, 1, 2, 3 oder 4, bevorzugt 0 oder 1, und ganz bevorzugt 1.

Wie ebenfalls vorstehend bereits erläutert wurde, ist die verbrückende Gruppe L gleich C(=O), $S(=O)_2$, P(=O)($R^{1''}$) oder L ist ein aromatisches oder heteroaromatisches Ringsystem mit 5 bis 30 aromatischen Ringatomen, das durch einen oder mehreren voneinander unabhängigen Reste $R^{1''}$ substituiert sein kann;

Bevorzugt steht L für ein aromatisches oder heteroaromatisches Ringsystem mit 5 bis 24 aromatischen Ringatomen, insbesondere mit 6 bis 13 aromatischen Ringatomen, das durch einen oder mehrere Reste $R^{1''}$ substituiert sein kann, bevorzugt aber unsubstituiert ist;

Der bipolare Host der erfindungsgemäßen Zusammensetzung ist daher in einer weiteren bevorzugten Ausführungsform der vorliegenden Erfindung eine Verbindung der allgemeinen Formel (1-1):

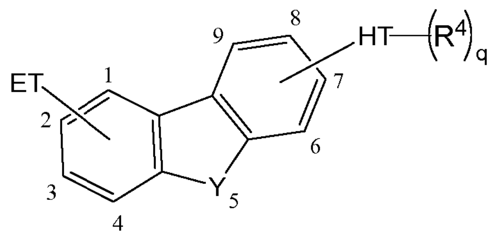

Formel (1-1),

wobei der Rest $R^4$ und die Gruppen ET und HT die vorstehend genannten Bedeutungen aufweisen und n = 1 gilt, und wobei

q eine ganze Zahl von 1 bis 5, bevorzugt von 1 bis 4, besonders bevorzugt von 1 bis 3, ganz bevorzugt von 1 bis 2, ganz besonders bevorzugt genau 2 und insbesondere bevorzugt genau 1 ist, und

Y O oder S, bevorzugt O ist.

Vorzugsweise ist die Gruppe ET in den Verbindungen der allgemeinen Formel (1-1) ausgewählt aus den Gruppen (ET-1) bis (ET-11), besonders bevorzugt aus den Gruppen der Formeln (ET-12) bis (ET-20), ganz besonders bevorzugt aus den Gruppen der Formeln (ET-12), (ET-13), (ET-14), (ET-15), (ET-16) und (ET-20).
Die Gruppe HT ist in Verbindungen der allgemeinen Formel (1-1) bevorzugt ausgewählt aus den Strukturen der Formeln (HT-2) bis (HT-5), besonders bevorzugt aus den Strukturen der Formeln (HT-6) bis (HT-9), und ganz besonders bevorzugt aus den Strukturen der Formel (HT-9).
In einer bevorzugten Ausführungsform der Erfindung ist der bipolare Host deshalb ausgewählt aus den Verbindungen der Formeln (1a-7) bis (1a-12) und Formeln (1b-7) bis (1b-12)

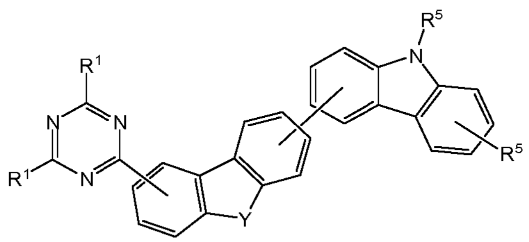

Formel (1a-7)

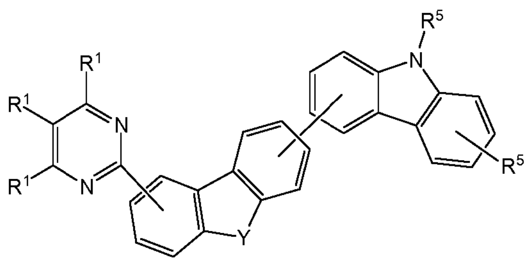

Formel (1a-8)

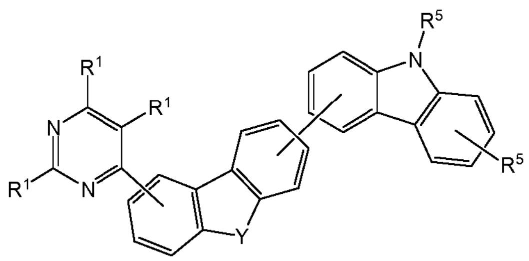

Formel (1a-9)

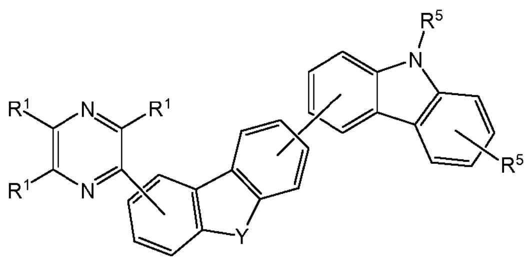

Formel (1a-10)

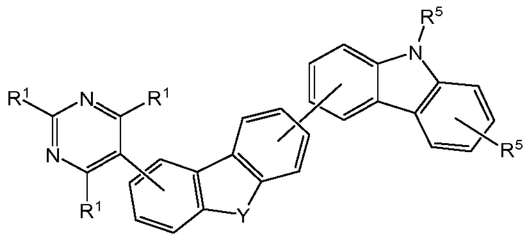

Formel (1a-11)

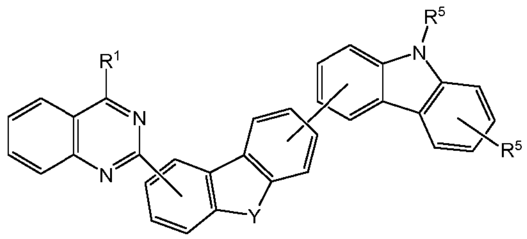

Formel (1a-12)

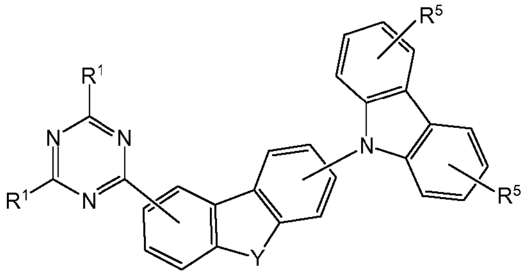

Formel (1b-7)

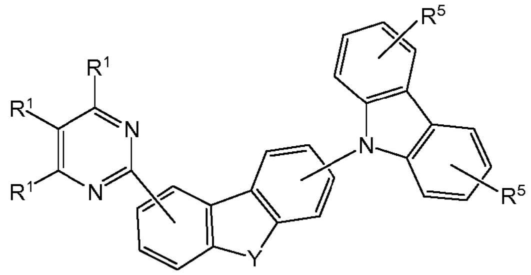

Formel (1b-8)

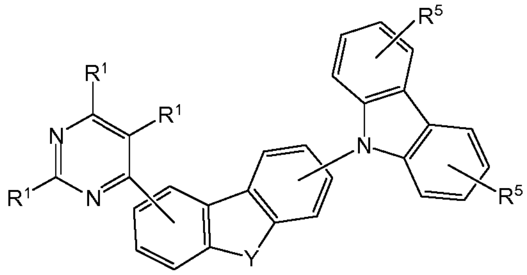

Formel (1ba-9)

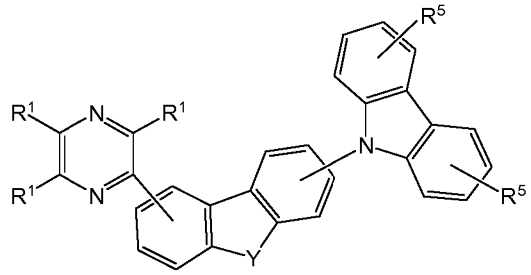

Formel (1b-10)

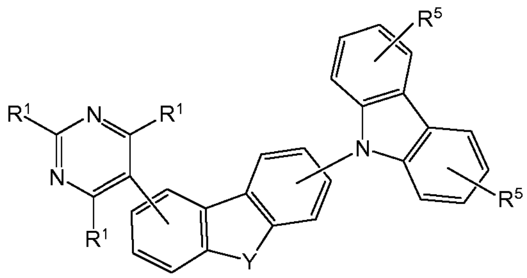

Formel (1b-11)

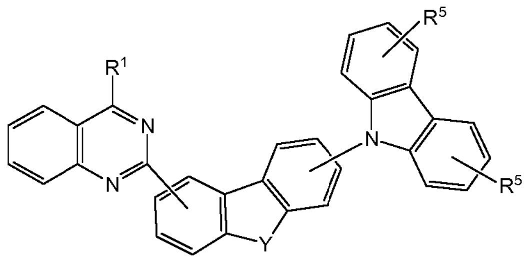

Formel (1b-12),

wobei die verwendeten Symbole der vorstehend genannten Bedeutungen aufweisen und wobei in den Formeln (1a-7) bis (1a-12) und (1b-7) bis (1b-12) jeweils genau einer der Reste $R^5$ einem Rest $R^4$ entspricht.

Dabei ist es besonders bevorzugt, wenn in den Strukturen der Formeln (1a-7) bis (1a-12) und (1b-7) bis (1b-12) an den Carbazolrest, der der Gruppe (HT-9) entspricht, ein weiterer Carbazolrest, der mit einem oder mehreren $R^2$ substituiert sein kann, gebunden ist.

In einer weiterhin bevorzugten Ausführungsform der vorliegenden Erfindung ist $R^4$ gleich oder verschieden bei jedem Auftreten $N(R^2)_2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy-, Alkylalkoxy- oder Thioalkoxygruppe mit 3 bis 40 C-Atomen, die jeweils mit einem oder mehreren Resten $R^2$ substituiert sein kann, ein aromatisches oder heteroaromatisches Ringsystem mit 5 bis 60 aromatischen Ringatomen, das jeweils durch einen oder mehrere Reste $R^2$ substituiert sein kann, oder eine Aryloxy-, Arylalkoxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination aus zwei oder mehr dieser Gruppen; dabei können zwei oder mehrere benachbarte Reste $R^4$ miteinander ein mono- oder polycyclisches, aliphatisches oder aromatisches Ringsystem bilden.

Ganz bevorzugt ist $R^4$ gleich oder verschieden bei jedem Auftreten ein aromatisches oder heteroaromatisches Ringsystem mit 5 bis 60 aromatischen Ringatomen, das jeweils durch einen oder mehrere Reste $R^2$ substituiert sein kann, oder eine Aryloxy-, Arylalkoxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination aus zwei oder mehr dieser Gruppen; dabei können zwei oder mehrere benachbarte Reste $R^4$ miteinander ein mono- oder polycyclisches, aliphatisches oder aromatisches Ringsystem bilden.

Besonders bevorzugt ist es, wenn $R^4$ gleich oder verschieden bei jedem Auftreten ein aromatisches oder heteroaromatisches Ringsystem mit 5 bis 60 aromatischen Ringatomen ist, das jeweils durch einen oder mehrere Reste $R^2$ substituiert sein kann; dabei können zwei oder mehrere benachbarte Reste $R^4$ miteinander ein polycyclisches, aromatisches Ringsystem bilden.

Ganz besonders bevorzugte aromatische oder heteroaromatische Ringsysteme für $R^4$ sind Phenyl, Biphenyl, Terphenyl, Quarterphenyl, Carbazol, Dibenzofuranyl, die mit einem oder mehreren $R^2$ substituiert sein können.

Es ist deshalb ganz besonders bevorzugt, wenn in den Strukturen der Formeln (1a-7) bis (1a-12) und (1b-7) bis (1b-12) $R^4$ den einen weiteren, optional mit einem oder mehreren Resten $R^2$ substituierten Carbazolrest darstellt, der an den Carbazolrest der Gruppe (HT-9) gebunden ist.

In einer besonders bevorzugten Ausführungsform ist der bipolare Host deshalb ausgewählt aus:
den Verbindungen der Formeln (1a-13) bis (1a-18) mit der allgemeinen Formel

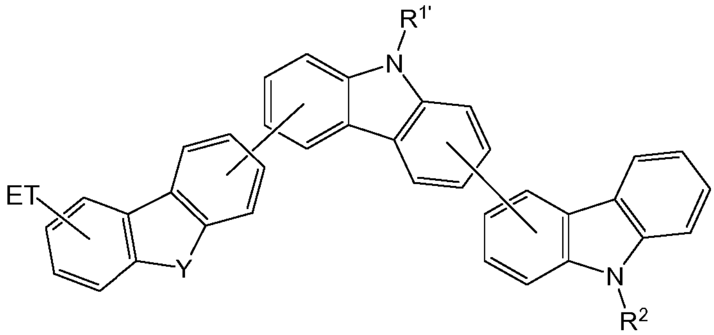
,

wobei gilt:

| Gruppe ET | Bipolarer Host |
|---|---|
| (ET-12) | Formel (1a-13) |
| (ET-13) | Formel (1a-14) |
| (ET-14) | Formel (1a-15) |
| (ET-15) | Formel (1a-16) |
| (ET-16) | Formel (1a-17) |
| (ET-20) | Formel (1a-18); |

den Verbindungen der Formeln (1a-19) bis (1a-24) mit der allgemeinen Formel

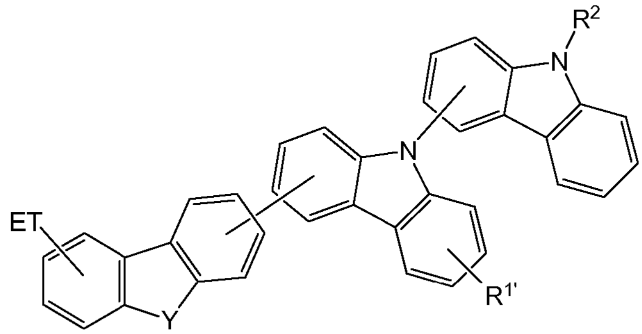

,

wobei gilt:

| Gruppe ET | Bipolarer Host |
|---|---|
| (ET-12) | Formel (1a-19) |
| (ET-13) | Formel (1a-20) |
| (ET-14) | Formel (1a-21) |
| (ET-15) | Formel (1a-22) |
| (ET-16) | Formel (1a-23) |
| (ET-20) | Formel (1a-24); |

den Verbindungen der Formeln (1b-13) bis (1b-18) mit der allgemeinen Formel

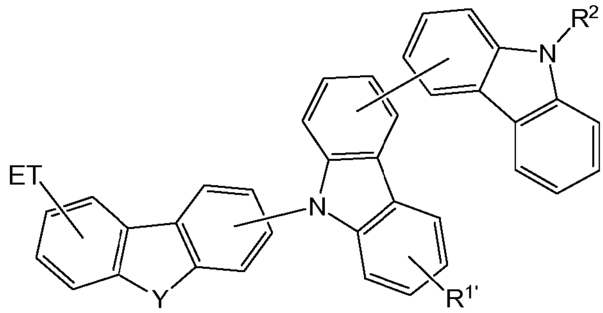

,

wobei gilt:

| Gruppe ET | Bipolarer Host |
|---|---|
| (ET-12) | Formel (1b-13) |
| (ET-13) | Formel (1b-14) |
| (ET-14) | Formel (1b-15) |
| (ET-15) | Formel (1b-16) |
| (ET-16) | Formel (1b-17) |
| (ET-20) | Formel (1b-18); und |

den Verbindungen der Formeln (1b-19) bis (1b-24) mit der allgemeinen Formel

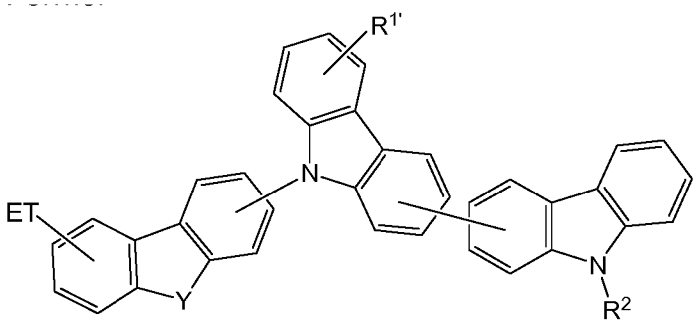

,

wobei gilt:

| Gruppe ET | Bipolarer Host |
|---|---|
| (ET-12) | Formel (1b-19) |
| (ET-13) | Formel (1b-20) |
| (ET-14) | Formel (1b-21) |
| (ET-15) | Formel (1b-22) |
| (ET-16) | Formel (1b-23) |
| (ET-20) | Formel (1b-24); |

und wobei $R^{1'}$, $R^2$ und Y die zuvor genannten Bedeutungen aufweisen.

Die Bindung des Rests $R^4$ kann grundsätzlich an alle noch nicht substituierten Positionen 1 bis 9 des Carbazol-Grundgerüsts, das der Gruppe (HT-9) entspricht, erfolgen. Nachfolgend sind die im Rahmen der vorliegenden Erfindung geltenden Bindungspositionen eines Carbazols angezeigt:

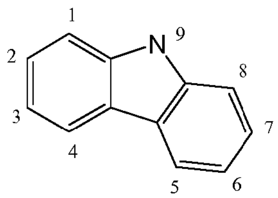

Bevorzugt Bindungspositionen für $R^4$ stellen die Positionen 2, 3, 6, 7 und 9 dar. Besonders bevorzugt sind die Positionen 3, 6 und 9. In den Fällen der Formeln (1a-1) bis (1a-12) sind die Bindungspositionen 6 und 9 für die Bindung von $R^4$ an das Carbazol-Grundgerüst der Gruppe (HT-9) ganz besonders bevorzugt. In den Fällen der Formeln (1b-1) bis (1b-12) sind die Bindungspositionen 3 und 6 für die Bindung von $R^4$ an das Carbazol-Grundgerüst der Gruppe (HT-9) ganz besonders bevorzugt.

Die Bindung der verbrückenden Gruppe $(L)_n$ bzw. ET (für n = 0) in den Fällen der Formeln (1a-1) bis (1a-6) sowie der Dibenzo-Gruppe in den Fällen der Formeln (1a-7) bis (1a-12) erfolgt bevorzugt an den Positionen 1, 2, 3 oder 4 des Carbazol-Grundgerüsts der Gruppe (HT-9), besonders bevorzugt an 2 oder 3, und ganz besonders bevorzugt an Position 3.

In einer mehr besonders bevorzugten Ausführungsform ist der bipolare Host deshalb ausgewählt ist aus den nachfolgenden Verbindungen der Formeln (1a-25) bis (1a-30) mit der allgemeinen Formel

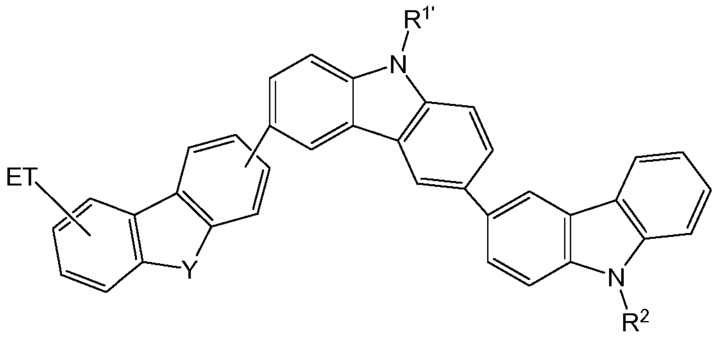

,

wobei gilt

| Gruppe ET | Bipolarer Host |
|---|---|
| (ET-12) | Formel (1a-25) |
| (ET-13) | Formel (1a-26) |
| (ET-14) | Formel (1a-27) |
| (ET-15) | Formel (1a-28) |
| (ET-16) | Formel (1a-29) |
| (ET-20) | Formel (1a-30); |

den nachfolgenden Verbindungen der Formeln (1a-31) bis (1a-36) mit der allemeinen Formel

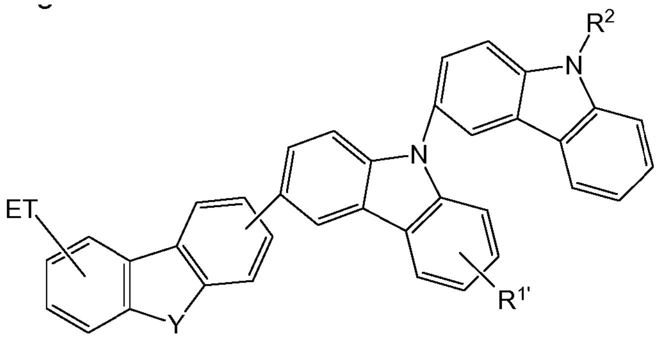

wobei gilt:

| Gruppe ET | Bipolarer Host |
|---|---|
| (ET-12) | Formel (1a-31) |
| (ET-13) | Formel (1a-32) |
| (ET-14) | Formel (1a-33) |
| (ET-15) | Formel (1a-34) |
| (ET-16) | Formel (1a-35) |
| (ET-20) | Formel (1a-36); |

den nachfolgenden Verbindungen der Formeln (1b-25) bis (1b-30) mit der allgemeinen Formel

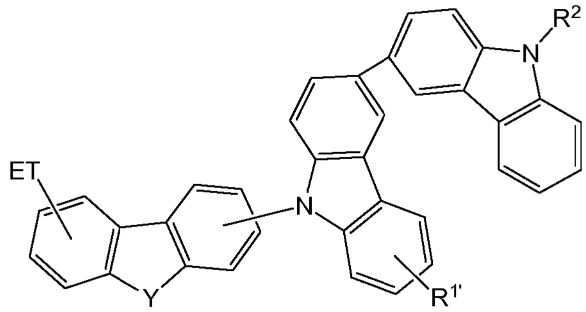

wobei gilt:

| Gruppe ET | Bipolarer Host |
|---|---|
| (ET-12) | Formel (1b-25) |
| (ET-13) | Formel (1b-26) |
| (ET-14) | Formel (1b-27) |
| (ET-15) | Formel (1b-28) |
| (ET-16) | Formel (1b-29) |
| (ET-20) | Formel (1b-30); und |

den nachfolgenden Verbindungen der Formeln (1b-31) bis (1b-36) mit der allgemeinen Formel

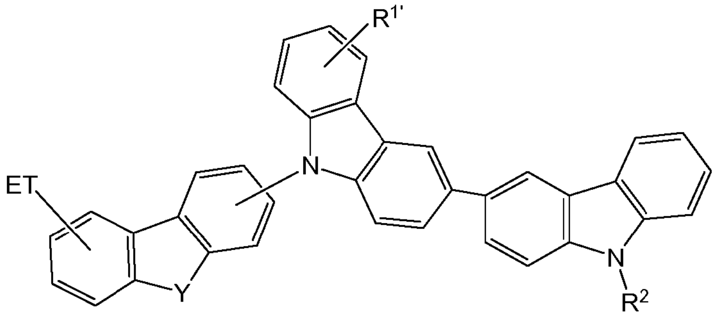

wobei gilt:

| Gruppe ET | Bipolarer Host |
|---|---|
| (ET-12) | Formel (1b-31) |
| (ET-13) | Formel (1b-32) |
| (ET-14) | Formel (1b-33) |
| (ET-15) | Formel (1b-34) |
| (ET-16) | Formel (1b-35) |
| (ET-20) | Formel (1b-36); |

wobei $R^{1'}$, $R^2$ und Y die zuvor genannten Bedeutungen aufweisen.

Die Substituenten $R^{1'}$ sind vorzugsweise ausgewählt aus der Gruppe bestehend aus H oder einem aromatischen oder heteroaromatischen Ring oder Ringsystem mit 5 bis 30 Ringatomen, wobei der Ring oder das Ringsystem jeweils durch einen oder mehrere Reste $R^2$ substituiert sein kann, bevorzugt aber unsubstituiert ist. $R^{1'}$ ist ganz bevorzugt H oder ein aromatischer Ring oder Ringsystem mit 5 bis 30 Ringatomen, wobei der Ring oder das Ringsystem jeweils durch einen oder mehrere Reste $R^2$ substituiert sein kann, wobei noch bevorzugter ist, wenn $R^{1'}$ unsusbtituiert ist. Ganz besonders bevorzugte aromatische Gruppen sind Phenyl, Biphenyl, Terphenyl und Quarterphenyl. $R^{1'}$ ist weiterhin ganz bevorzugt H oder ein heteroaromatischer Ring oder Ringsystem mit 5 bis 30 Ringatomen, wobei der Ring oder das Ringsystem jeweils durch einen oder mehrere Reste $R^2$ substituiert sein kann, wobei noch bevorzugter ist, wenn $R^{1'}$

unsusbtituiert ist. Ganz besonders bevorzugte heteroaromatische Gruppen sind Furan, Dibenzofuran, Thiophen, Benzothiophen, Dibenzothiophen, Carbazol, Phenanthridin und Chinoxalin.

Besonders bevorzugt ist die Gruppe ET ein Triazin gemäß der Formel (ET-12), wobei die Verbindungen der Formeln (ET-21) bis (ET-36) ganz besonders bevorzugter Beispiele der Gruppe ET darstellen.

Wie vorstehend bereits erläutert wurde, ist Y bevorzugt gleich O, sodass der verbrückende Ligand bevorzugt Dibenzofuran ist (siehe Formel (1-1)).

Weiterhin bevorzugt ist es, wenn die Gruppe ET an Position 1 oder 2, besonders bevorzugt an Position 1 des Dibenzofurans gebunden ist.

In einer weiter ganz besonders bevorzugten Ausführungsform ist der bipolare Host deshalb ausgewählt ist aus den Verbindungen der nachfolgenden Formeln (1a-37), (1a-38), (1b-37) und (1b-38)

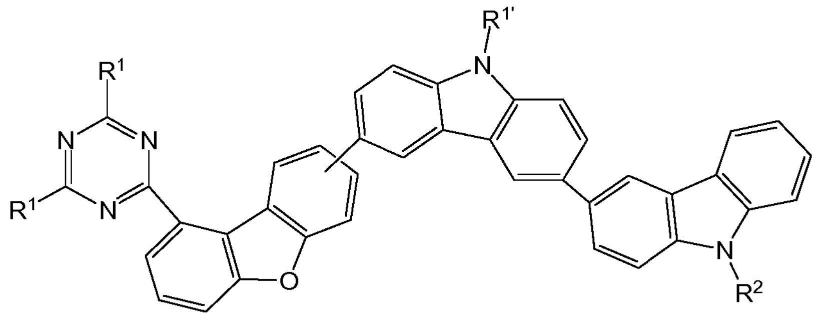

Formel (1a-37)

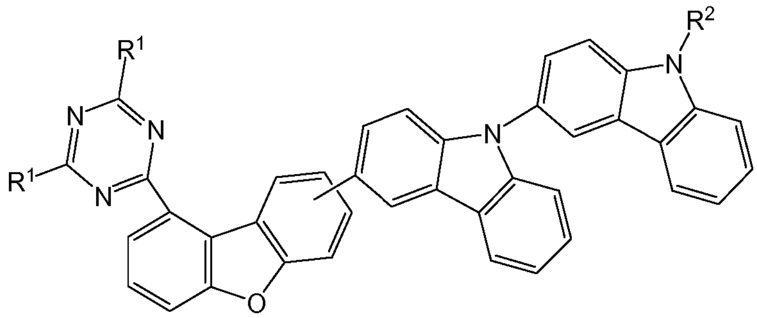

Formel (1a-38)

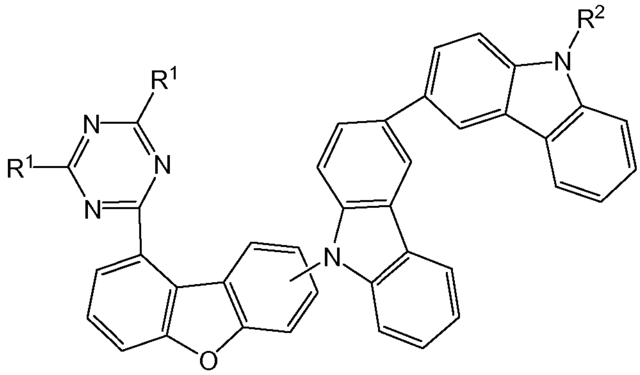

Formel (1b-37)

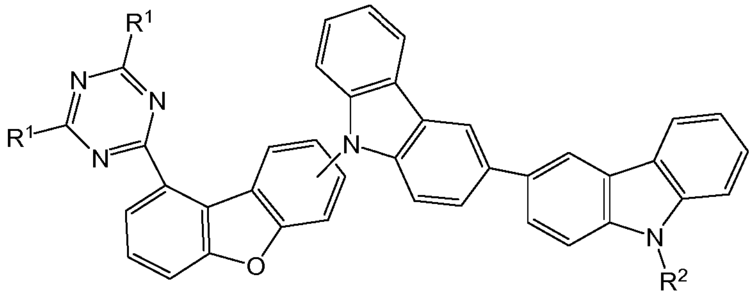

Formel (1b-38),

wobei $R^1$ und $R^2$ die zuvor genannten Bedeutungen aufweisen.

Die Substituenten $R^1$ sind ganz bevorzugt ausgewählt aus der Gruppe bestehend aus H oder einem aromatischen oder heteroaromatischen Ringsystem mit 5 bis 60 aromatischen Ringatomen, das jeweils durch einen oder mehrere Reste $R^2$ substituiert sein kann, wobei bevorzugt ist, dass $R^1$ keine elektronenreiche aromatische oder heteroaromatische Ringe oder Ringsysteme enthält. Ganz besonders bevorzugt sind die Substituenten $R^1$ so ausgewählt, dass die Triazin-Gruppe, die in den Verbindungen der Formeln (1a-37), (1a-38), (1b-37) und (1b-38) der Gruppe ET entspricht, einer der Gruppen (ET-21) bis (ET-36) entspricht.

Der Substituent $R^2$ ist vorzugsweise ausgewählt aus der Gruppe bestehend aus H oder einem aromatischen oder heteroaromatischen Ring oder Ringsystem mit 5 bis 30 Ringatomen, wobei der Ring oder das Ringsystem jeweils durch einen oder mehrere Reste $R^3$ substituiert sein kann, bevorzugt aber unsubstituiert ist. $R^2$ ist ganz bevorzugt H oder ein aromatischer Ring oder Ringsystem mit 5 bis 30 Ringatomen, wobei der Ring oder das Ringsystem jeweils durch einen oder mehrere Reste $R^3$ substituiert sein kann, wobei es noch bevorzugter ist, wenn $R^2$ unsusbtituiert ist. Ganz besonders bevorzugte aromatische Gruppen sind Phenyl, Biphenyl, Terphenyl und Quarterphenyl.

Am meisten bevorzugt ist die Gruppe HT in den Verbindungen der Formeln (1a-37), (1a-38), (1b-37) und (1b-38) an Position 8 des Dibenzofurans gebunden.

Beispiele für geeignete erfindungsgemäße Verbindungen des bipolaren Host sind die nachstehend gezeigten Strukturen.

| | | |
|---|---|---|
| 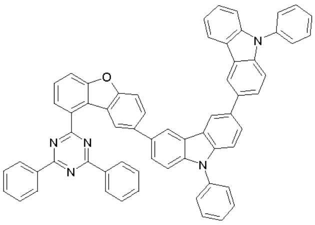 | 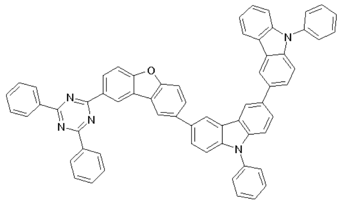 | 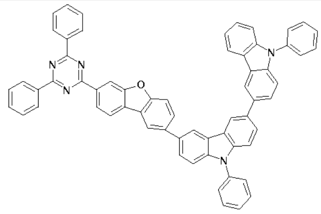 |
| 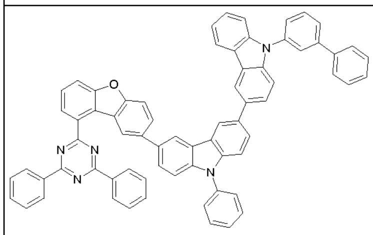 | 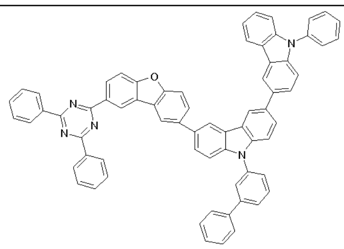 | 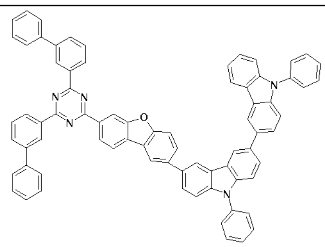 |
| 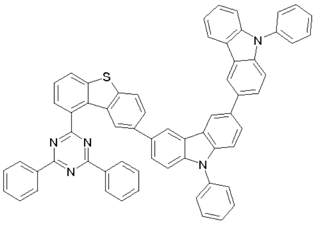 | 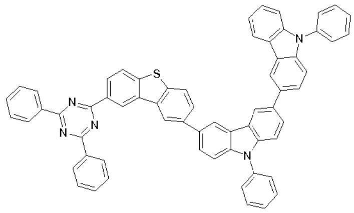 | 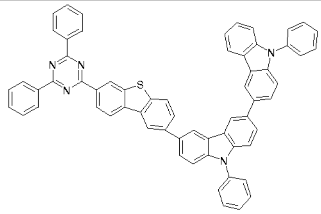 |
| 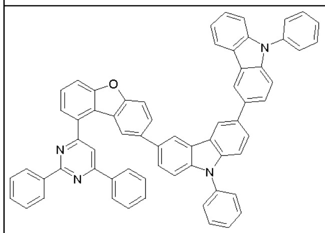 | 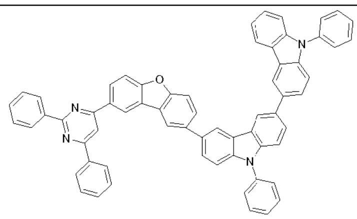 | 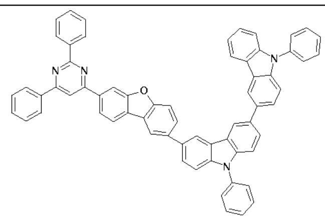 |
| 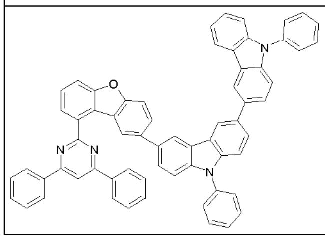 | 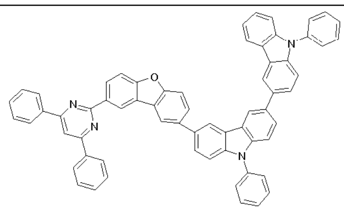 | 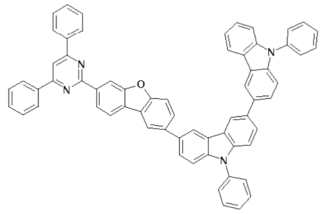 |

| | | |
|---|---|---|
| 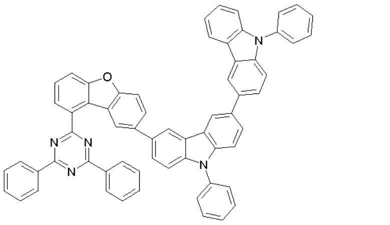 | 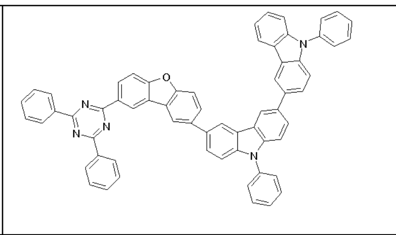 | 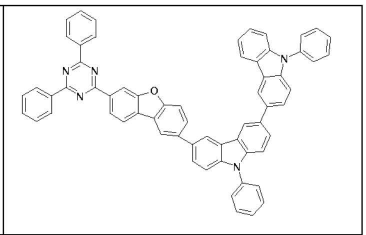 |
| 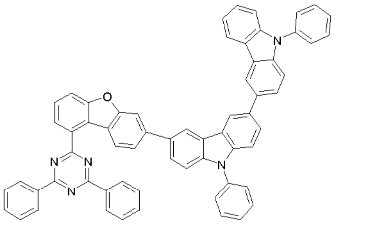 | 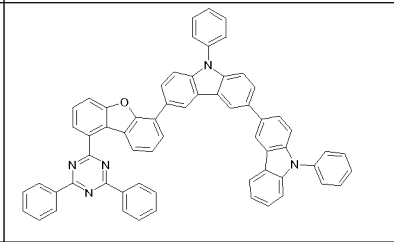 | 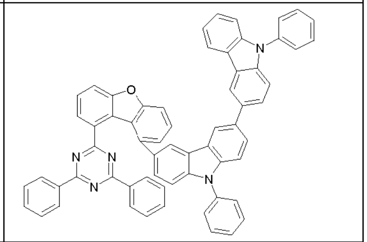 |
| 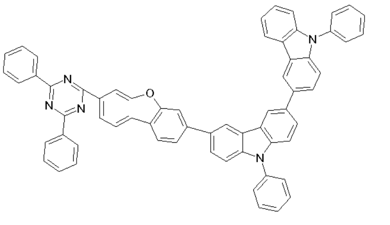 | 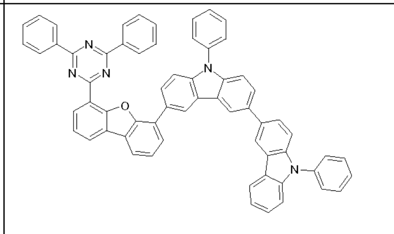 | 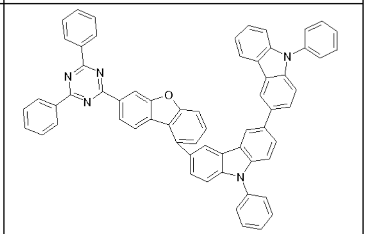 |
| 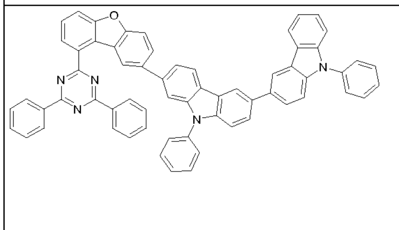 | 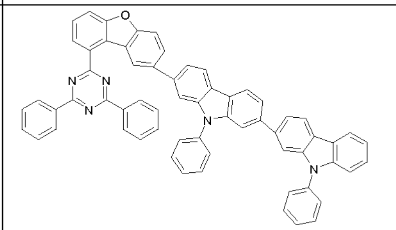 | 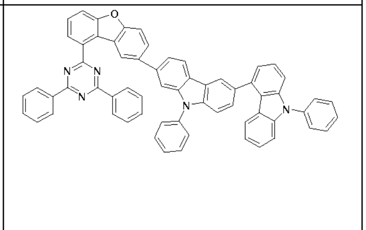 |
| 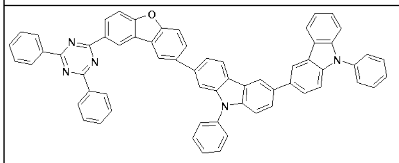 | 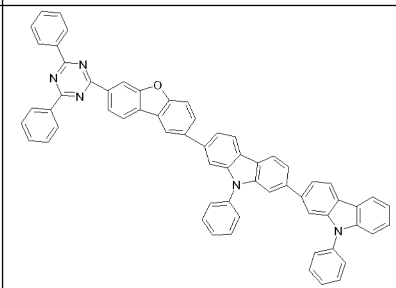 | 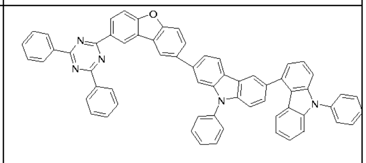 |
| 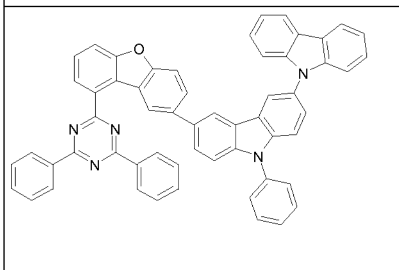 | 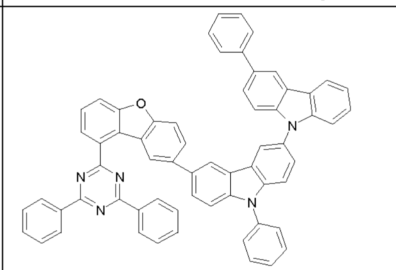 | 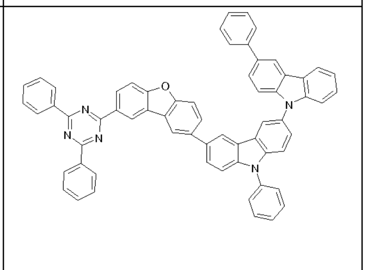 |
| 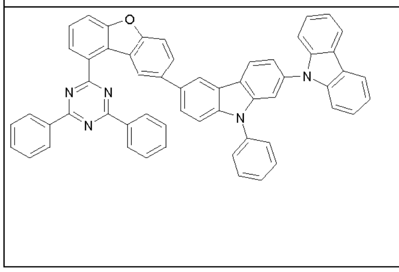 | 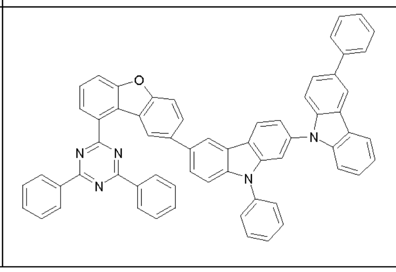 | 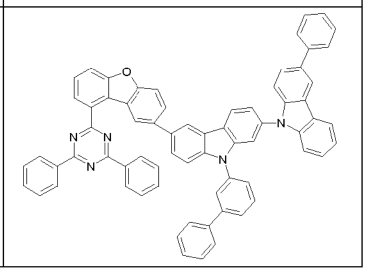 |

| | | |
|---|---|---|
| 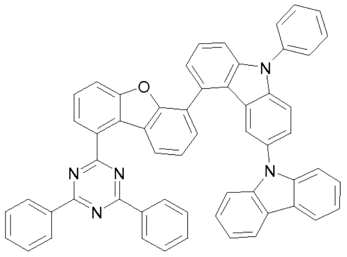 | 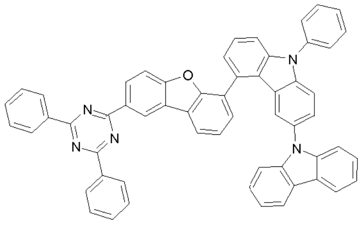 | 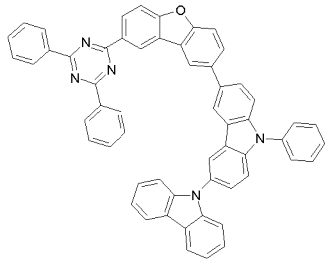 |
| 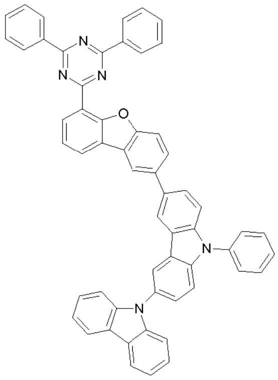 | 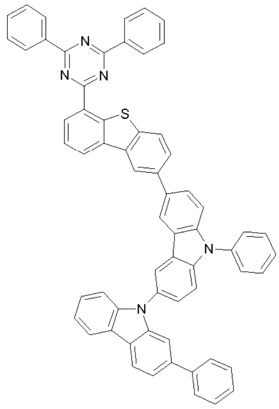 | 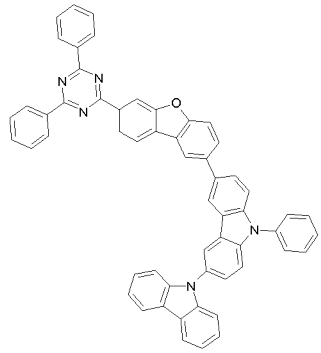 |
| 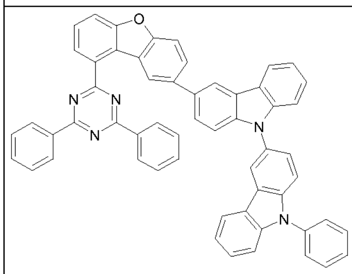 | 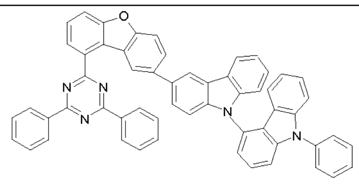 | 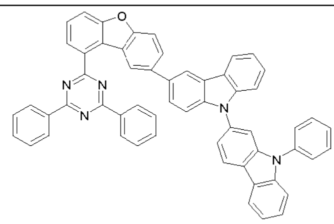 |
| 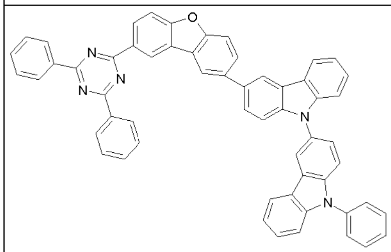 | 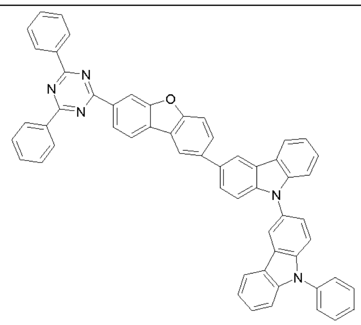 | 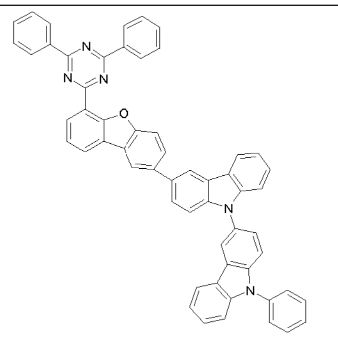 |
| 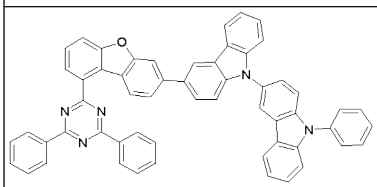 | 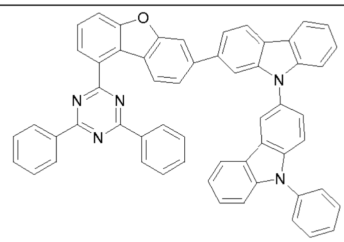 | 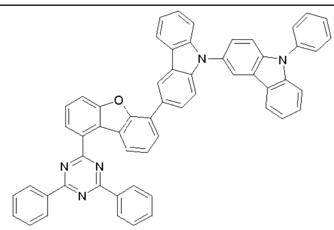 |

| | | |
|---|---|---|
| 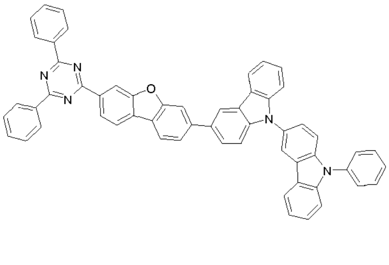 | 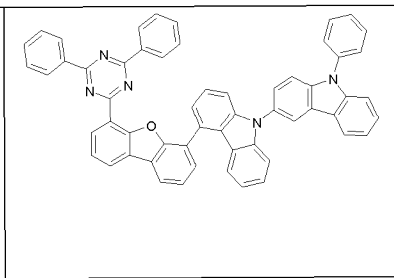 | 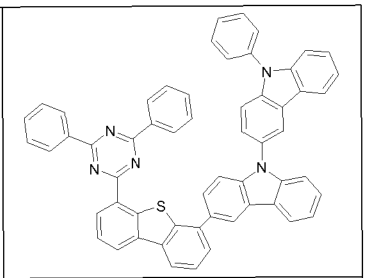 |
| 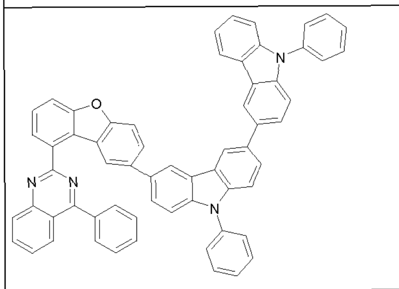 | 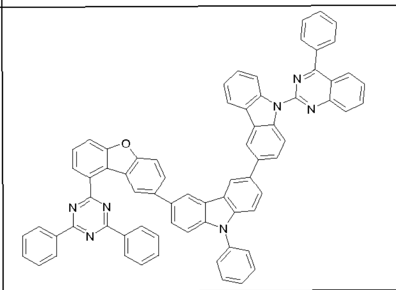 | 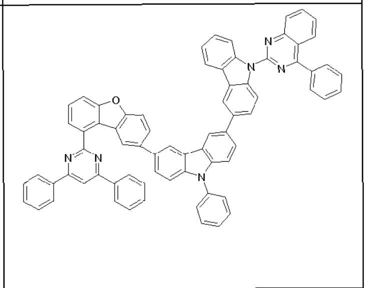 |
| 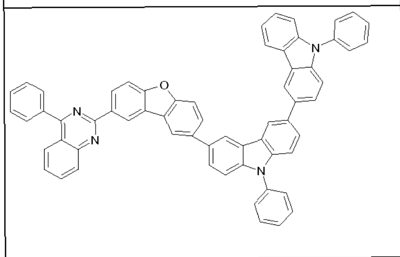 | 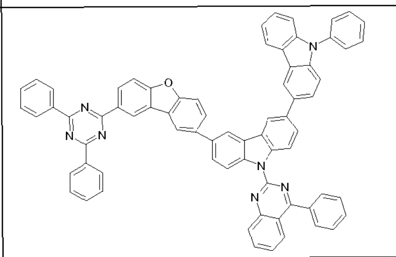 | 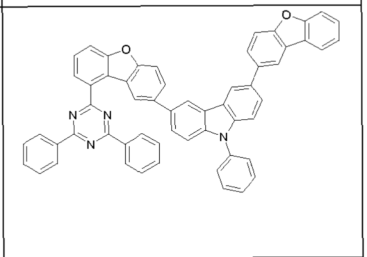 |
| 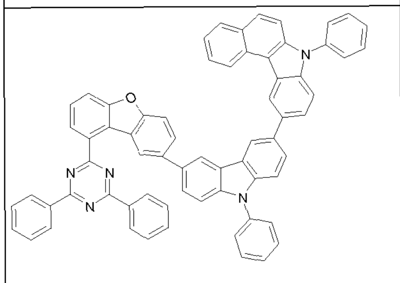 | 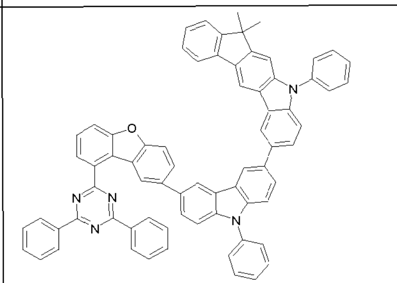 | 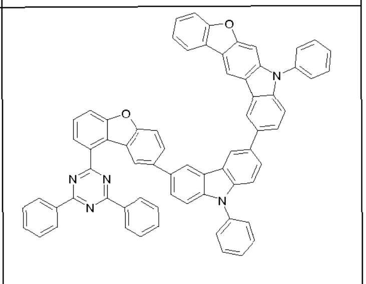 |
| 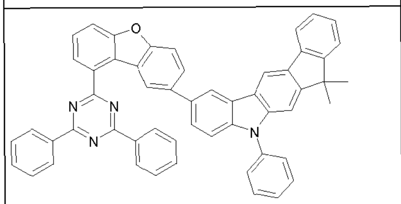 | 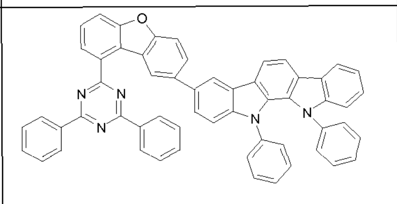 | 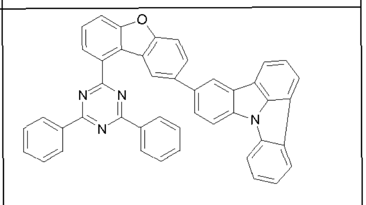 |
| 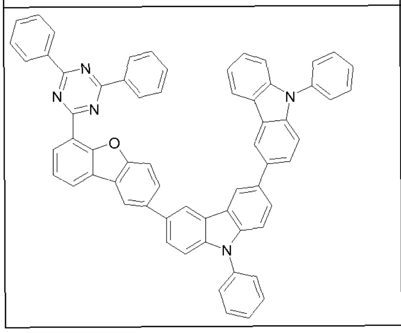 | 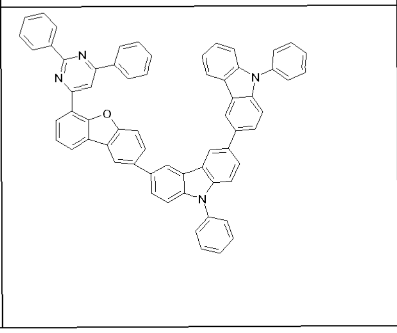 | 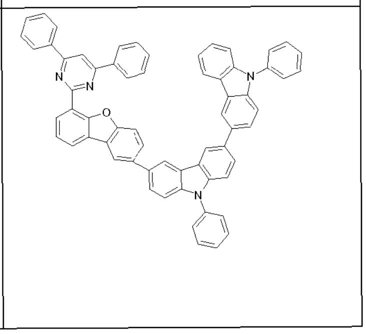 |

| | | |
|---|---|---|
| 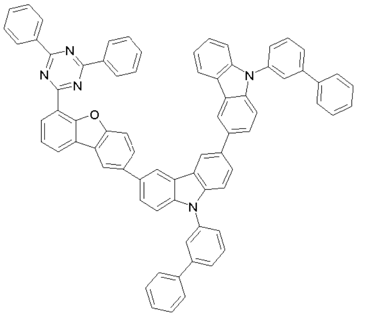 | 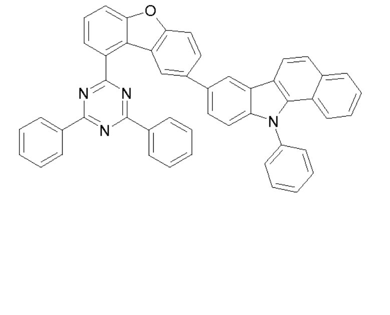 | 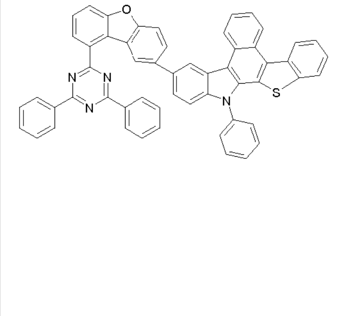 |
| 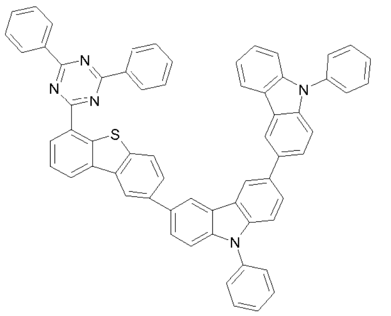 | 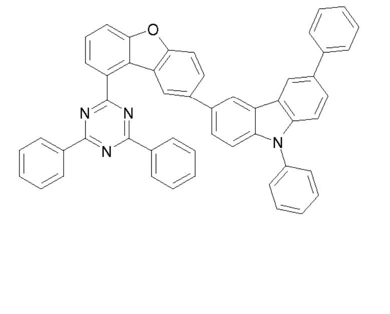 | 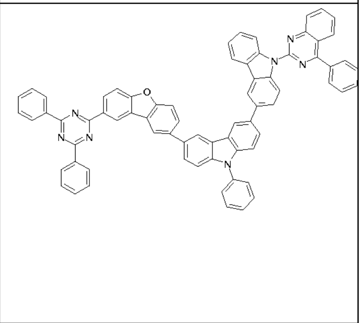 |
| 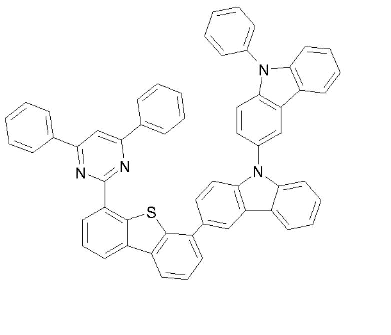 | 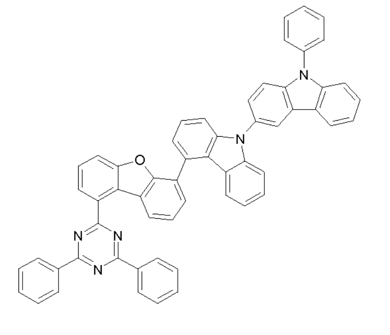 | 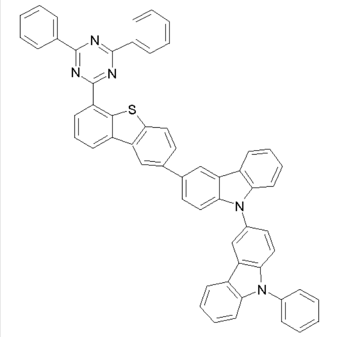 |
| 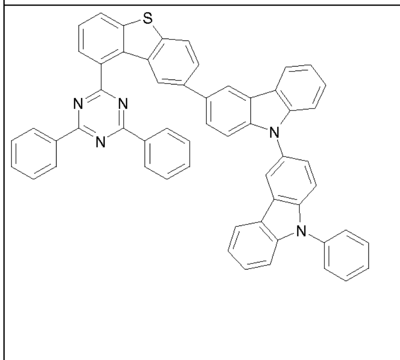 | 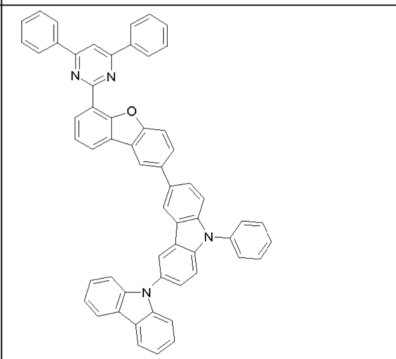 | 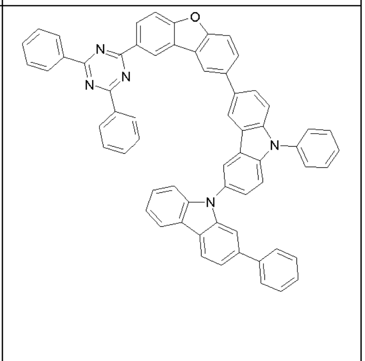 |
| 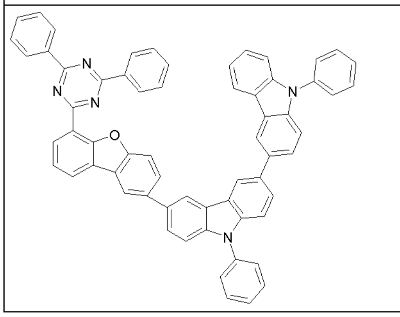 | 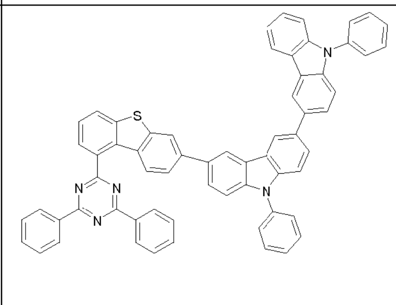 | 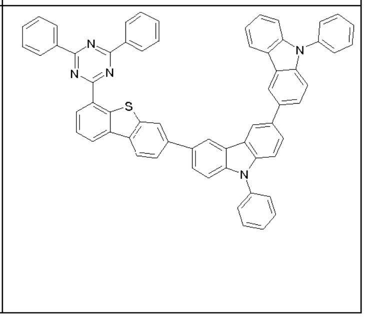 |

| | | |
|---|---|---|
| 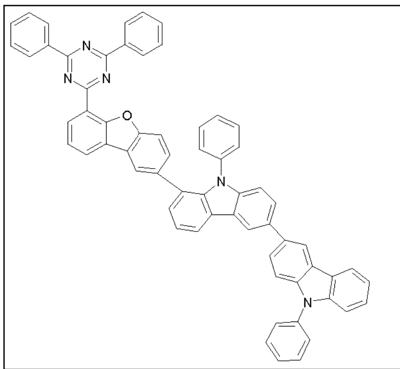 | 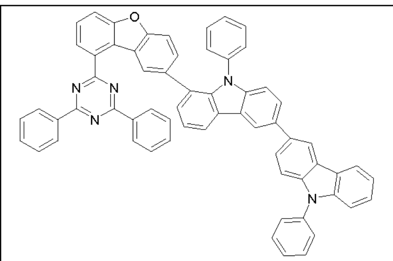 | 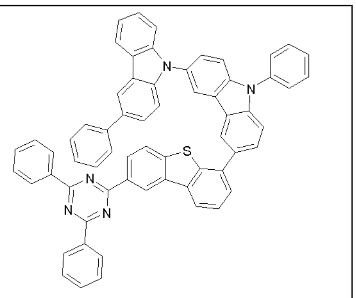 |
| 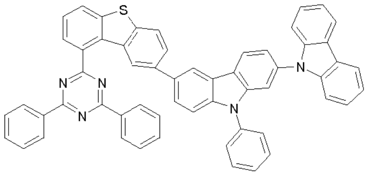 | | |

Die erfindungsgemäßen Verbindungen des bipolaren Host können nach dem Fachmann bekannten Syntheseschritten, wie z. B. Bromierung, Suzuki-Kupplung, Ullmann-Kupplung, Hartwig-Buchwald-Kupplung, etc., dargestellt werden. Ein geeignetes Syntheseverfahren ist allgemein im folgenden Schema 1 dargestellt.

Schema 1

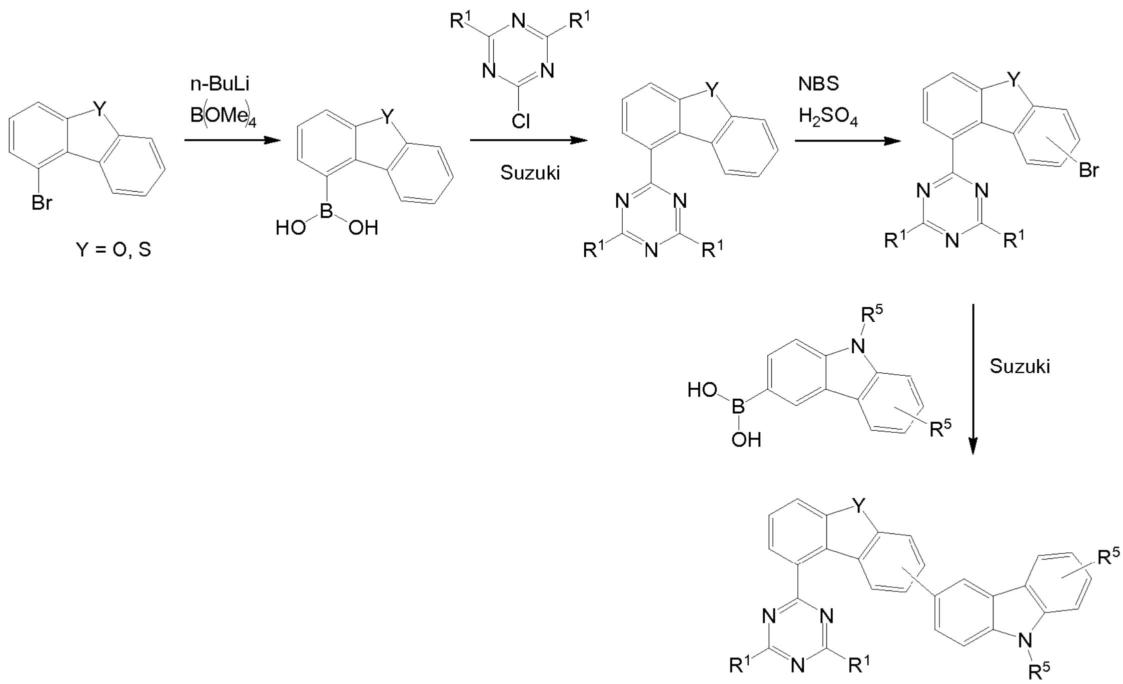


Im Folgenden werden bevorzugte elektronentransportierende Verbindungen beschrieben, die als elektronentransportierender Host in Kombination mit dem bipolaren Host in erfindungsgemäßen Zusammensetzungen eingesetzt werden.

Der elektronentransportierende Host ist vorzugsweise eine Verbindung der allgemeinen Formel (2) oder (2a):

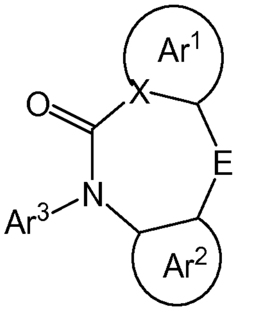

Formel (2)

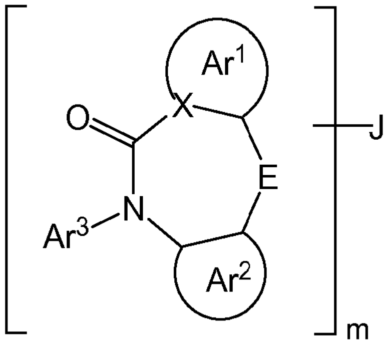

Formel (2a)

wobei für die verwendeten Symbole und Indizes gilt:

E ist eine Einfachbindung oder $NAr^4$;

X ist C, wenn $Ar^1$ eine 6-Ring-Aryl- oder 6-Ring-Heteroarylgruppe darstellt, bzw. ist C oder N, wenn $Ar^1$ eine 5-Ring-Heteroarylgruppe darstellt;

$Ar^1$ ist zusammen mit der Gruppe X und dem explizit dargestellten Kohlenstoffatom ein aromatisches oder heteroaromatisches Ringsystem mit 5 bis 30 aromatischen Ringatomen, welches durch einen oder mehrere Reste R substituiert sein kann;

$Ar^2$ ist zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann; dabei kann $Ar^2$ auch mit $Ar^3$ durch eine Einfachbindung verknüpft sein;

$Ar^3$ ist ausgewählt aus der Gruppe bestehend aus H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^6$ substituiert sein kann, wobei eine oder mehrere nicht-benachbarte $CH_2$-Gruppen durch $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 30 aromatischen Ringatomen, das jeweils mit einem oder mehreren Resten $R^6$ substituiert sein kann, einer Aryloxy- oder Heteroaryloxygruppe mit 5 bis 30 aromatischen Ringatomen, die mit einem oder mehreren Resten $R^6$ substituiert sein kann, oder einer Kombination dieser Systeme; dabei kann $Ar^3$ auch mit $Ar^2$ durch eine Einfachbindung verknüpft sein;

$Ar^4$ ist ein aromatisches oder heteroaromatisches Ringsystem mit 5 bis 30 aromatischen Ringatomen, welches durch einen oder mehrere Reste R substituiert sein kann; dabei kann $Ar^4$ auch mit $Ar^2$ oder $Ar^1$ durch eine Einfachbindung verknüpft sein;

m 2, 3 oder 4;

J ist für m = 2 eine Einfachbindung oder eine bivalente Gruppe, bzw. für m = 3 eine trivalente Gruppe bzw. für m = 4 eine tetravalente Gruppe, welche jeweils an eine beliebige Position an $Ar^1$, $Ar^2$, $Ar^3$ oder $Ar^4$ gebunden ist;

R ist bei jedem Auftreten gleich oder verschieden ausgewählt aus der Gruppe bestehend aus H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, einer geradkettigen Alkyl-, Alkoxy-oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^6$ substituiert sein kann, wobei eine oder mehrere nicht-benachbarte $CH_2$-Gruppen durch $R^6C=CR^6$, C≡C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem

oder mehreren Resten $R^6$ substituiert sein kann, einer Aryloxy- oder Heteroaryloxygruppe mit 5 bis 60 aromatischen Ringatomen, die mit einem oder mehreren Resten $R^6$ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^6$ substituiert sein kann;

$R^6$ ist bei jedem Auftreten gleich oder verschieden ausgewählt aus der Gruppe bestehend aus H, D, F, Cl, Br, I, CN, $NO_2$, $N(Ar^5)_2$, $N(R^7)_2$, $C(=O)Ar^5$, $C(=O)R^7$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^7$ substituiert sein kann, wobei eine oder mehrere nicht-benachbarte $CH_2$-Gruppen durch $R^7C=CR^7$, $C\equiv C$, $Si(R^7)_2$, $Ge(R^7)_2$, $Sn(R^7)_2$, C=O, C=S, C=Se, $C=NR^7$, $P(=O)(R^7)$, SO, $SO_2$, $NR^7$, O, S oder $CONR^7$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 - 60 aromatischen Ringatomen, das jeweils mit einem oder mehreren Resten $R^7$ substituiert sein kann, einer Aryloxy- oder Heteroaryloxygruppe mit 5 bis 60 aromatischen Ringatomen, die mit einem oder mehreren Resten $R^7$ substituiert sein kann, oder einer Kombination dieser Systeme, wobei optional zwei oder mehr benachbarte Substituenten $R^6$ ein monocyclisches oder polycyclisches, aliphatisches, aromatisches oder heteroaromatisches Ringsystem bilden können, das mit einem oder mehreren Resten $R^7$ substituiert sein kann;

$Ar^5$ ist bei jedem Auftreten gleich oder verschieden ein aromatisches oder heteroaromatisches Ringsystem mit 5 bis 30 aromatischen Ringatomen, das mit einem oder mehreren nicht-aromatischen Resten $R^7$ substituiert sein kann; dabei können zwei Reste $Ar^5$, welche an dasselbe N-Atom oder P-Atom binden, auch durch eine Einfachbindung oder eine Brücke, ausgewählt aus $N(R^7)$, $C(R^7)_2$ oder O, miteinander verbrückt sein;

$R^7$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^7$ miteinander ein mono- oder polycyclisches, aliphatisches, aromatisches oder heteroaromatisches Ringsystem bilden können.

Dabei bedeutet 6-Ring-Aryl- bzw. 6-Ring-Heteroarylgruppe bzw. 5-Ring-Heteroarylgruppe in der Definition von X, dass der Ring, der das explizit dargestellte Kohlenstoffatom und die Gruppe X enthält, ein solcher Ring ist. An diesen Ring können noch weitere aromatische bzw. heteroaromatische Gruppen ankondensiert sein.

Nachfolgend werden bevorzugte Ausführungsformen der Verbindung der Formel (2) bzw. (2a) beschrieben.

In einer bevorzugten Ausführungsform der Erfindung steht die Gruppe $Ar^1$ in Verbindungen der Formel (2) bzw. (2a) für eine Gruppe der Formel (3), (4), (5), (6) oder (7),

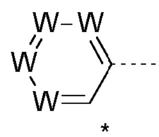
Formel (3)

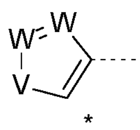
Formel (4)

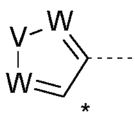
Formel (5)

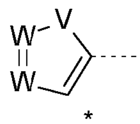
Formel (6)

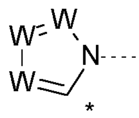
Formel (7)

wobei die gestrichelte Bindung die Verknüpfung mit der Carbonylgruppe andeutet, * die Position der Verknüpfung mit E andeutet und weiterhin gilt:

W ist gleich oder verschieden bei jedem Auftreten CR oder N; oder zwei benachbarte Gruppen W stehen für eine Gruppe der folgenden Formel (8) oder (9),

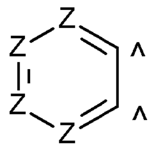

Formel (8)

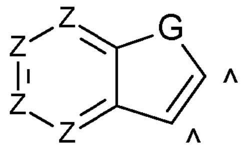

Formel (9)

wobei G für $CR_2$, NR, O oder S steht, Z gleich oder verschieden bei jedem Auftreten für CR oder N steht und ^ die entsprechenden benachbarten Gruppen W in der Formel (3) bis (7) andeuten;

V ist NR, O oder S;

die Gruppe $Ar^2$ steht für eine Gruppe gemäß einer der Formeln (10), (11) oder (12),

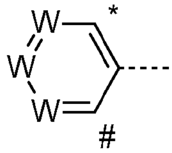

Formel (10)

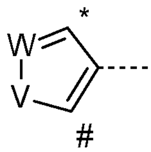

Formel (11)

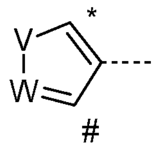

Formel (12)

wobei die gestrichelte Bindung die Verknüpfung mit N andeutet, # die Position einer möglichen Verknüpfung mit $Ar^3$ andeutet, * die Verknüpfung mit E andeutet und W und V die oben genannten Bedeutungen aufweisen;

die Gruppe $Ar^3$ steht für eine Gruppe gemäß einer der Formeln (13), (14), (15) oder (16),

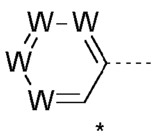

Formel (13)

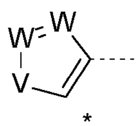

Formel (14)

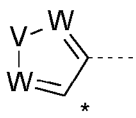

Formel (15)

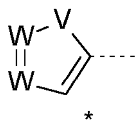

Formel (16)

wobei die gestrichelte Bindung die Verknüpfung mit N andeutet, * eine mögliche Verknüpfung mit $Ar^2$ andeutet und W und V die oben genannten Bedeutungen aufweisen.

Dabei können die oben genannten bevorzugten Gruppen $Ar^1$, $Ar^2$ und $Ar^3$ beliebig miteinander kombiniert werden.

Bevorzugten Ausführungsform der Erfindung sind daher Verbindungen gemäß Formel (2) bzw. (2a), für die gilt:

E ist eine Einfachbindung;
$Ar^1$ ist ausgewählt aus den Gruppen der oben genannten Formeln (3), (4), (5), (6) oder (7);
$Ar^2$ ist ausgewählt aus den Gruppen der oben genannten Formeln (10), (11) oder (12);
$Ar^3$ ist ausgewählt aus den Gruppen der oben genannten Formeln (13), (14), (15) oder (16).

Besonders bevorzugt stehen mindestens zwei der Gruppen $Ar^1$, $Ar^2$ und $Ar^3$ für eine 6-Ring-Aryl- oder eine 6-Ring-Heteroarylgruppe. Besonders bevorzugt steht also $Ar^1$ für eine Gruppe der Formel (3) und gleichzeitig steht $Ar^2$ für eine Gruppe der Formel (10), oder $Ar^1$ steht für eine Gruppe der Formel (3) und gleichzeitig steht $Ar^3$ für eine Gruppe der Formel (13), oder $Ar^2$ steht für eine Gruppe der Formel (10) und gleichzeitig steht $Ar^3$ für eine Gruppe der Formel (13).

Besonders bevorzugte Ausführungsformen der Formel (2) sind daher die Verbindungen der folgenden Formeln (17) bis (26),

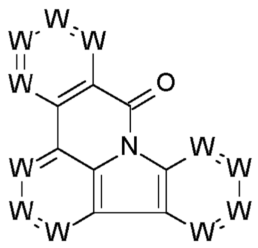
Formel (17)

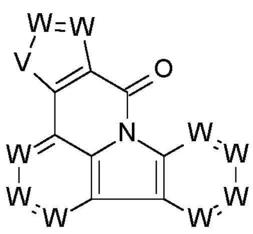
Formel (18)

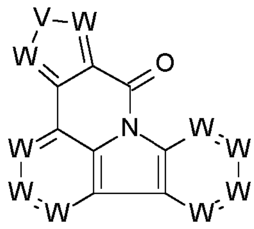
Formel (18-I)

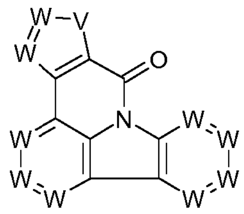
Formel (19)

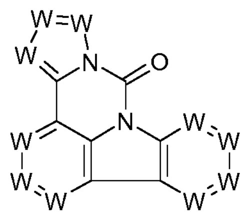
Formel (20)

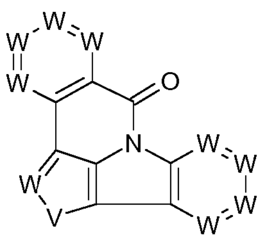
Formel (21)

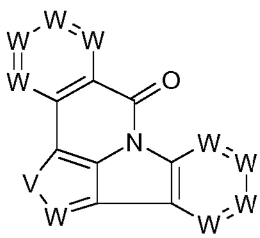
Formel (22)

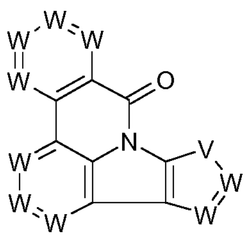
Formel (23)

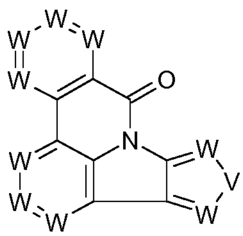
Formel (24)

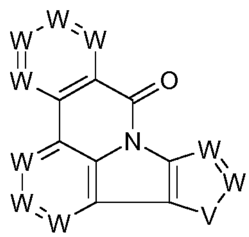
Formel (25)

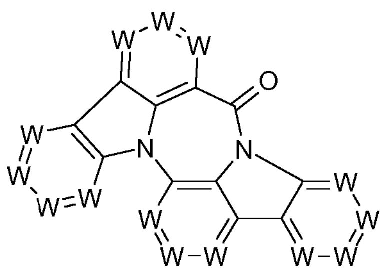
Formel (26)

wobei die verwendeten Symbole die vorstehend genannten Bedeutungen aufweisen.

Es ist weiterhin bevorzugt, wenn W für CR oder N steht und nicht für eine Gruppe der Formel (8) oder (9). In einer bevorzugten Ausführungsform der Verbindungen gemäß Formel (17) bis (26) steht pro Cyclus insgesamt maximal

ein Symbol W für N, und die verbleibenden Symbole W stehen für CR.

In einer besonders bevorzugten Ausführungsform der Erfindung stehen alle Symbole W für CR. Besonders bevorzugt sind daher die Verbindungen gemäß den folgenden Formeln (17a) bis (26a),

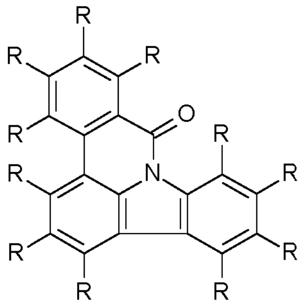

Formel (17a)

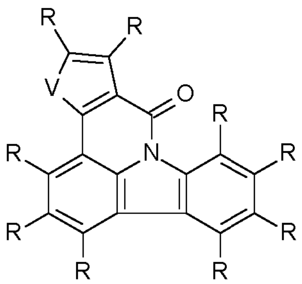

Formel (18a)

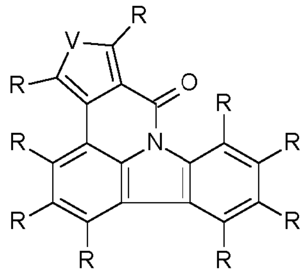

Formel (18-Ia)

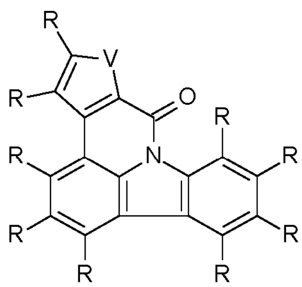

Formel (19a)

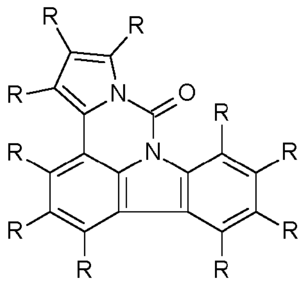

Formel (20a)

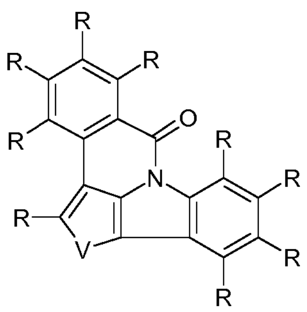

Formel (21a)

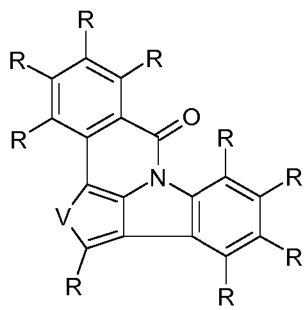

Formel (22a)

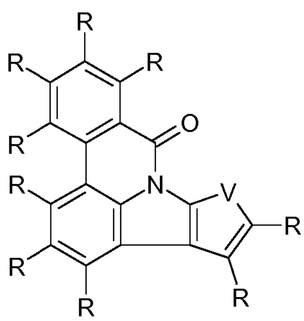

Formel (23a)

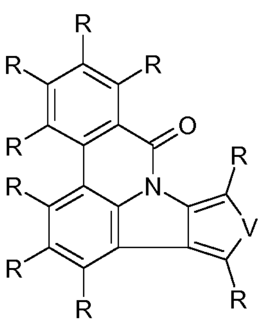

Formel (24a)

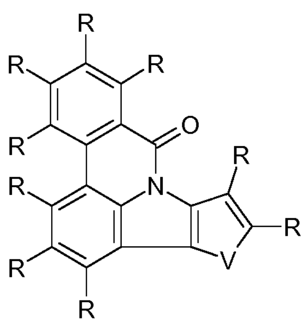

Formel (25a)

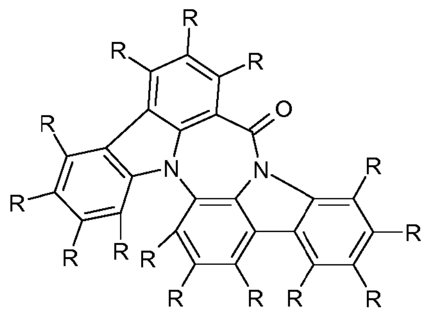

Formel (26a)

wobei die verwendeten Symbole die oben genannten Bedeutungen aufweisen.

Ganz besonders bevorzugt sind die Strukturen der Formeln (17b) bis (26b),

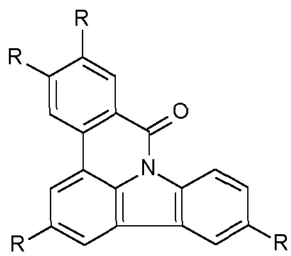

Formel (17b)

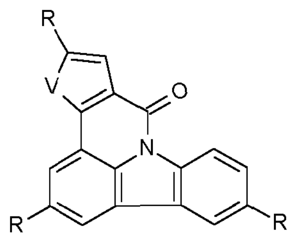

Formel (18b)

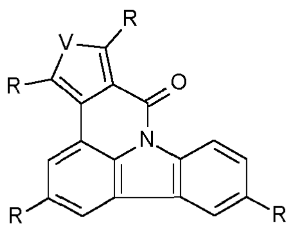

Formel (18-Ib)

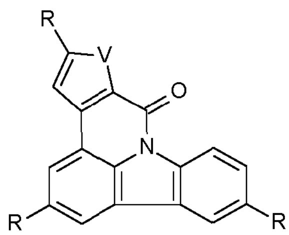

Formel (19b)

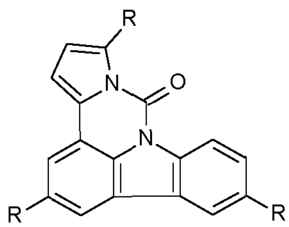

Formel (20b)

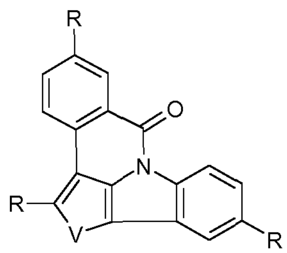

Formel (21b)

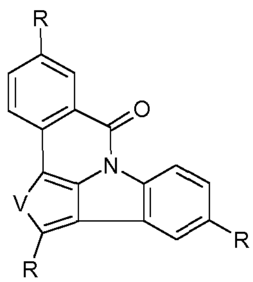

Formel (22b)

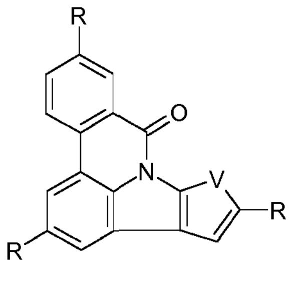
Formel (23b)

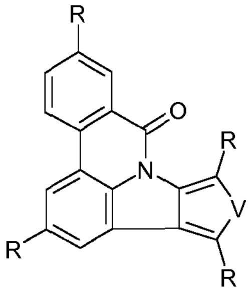
Formel (24b)

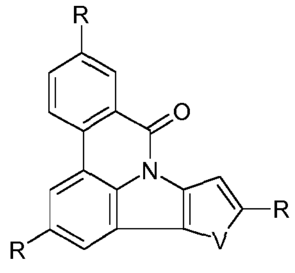
Formel (25b)

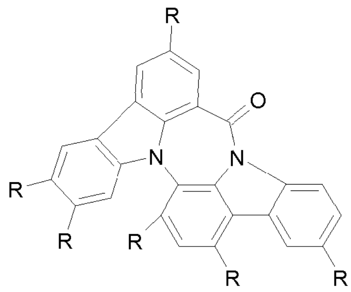
Formel (26b)

wobei die verwendeten Symbole die oben genannten Bedeutungen aufweisen.

Ganz besonders bevorzugt sind die Verbindungen der Formel (17) bzw. (17a) bzw. (17b).

In einer weiteren bevorzugten Ausführungsform der Erfindung steht $Ar^3$ für eine Gruppe der Formel (13) und zwei benachbarte Gruppen W in dieser Gruppe $Ar^3$ stehen für eine Gruppe der Formel (9) und die anderen Gruppen W in dieser Gruppe $Ar^3$ stehen gleich oder verschieden für CR oder N, insbesondere für CR. Dabei kann die Gruppe der Formel (9) in jeder möglichen Position ankondensiert sein. Besonders bevorzugt steht gleichzeitig $Ar^1$ für eine Gruppe der Formel (3), in der W gleich oder verschieden für CR oder N steht, insbesondere für CR, und $Ar^2$ steht für eine Gruppe der Formel (10), in der W gleich oder verschieden für CR oder N steht, insbesondere für CR. Bevorzugte Ausführungsformen der Verbindungen der Formel (2) sind also weiterhin die Verbindungen der folgenden Formeln (27) bis (32),

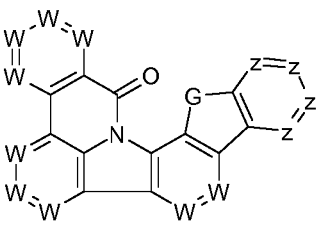
Formel (27)

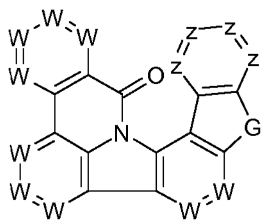
Formel (28)

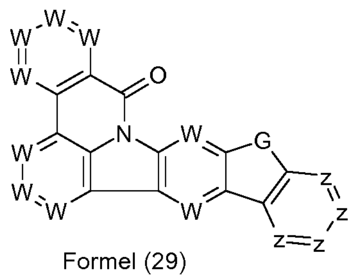
Formel (29)

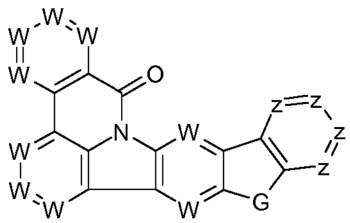
Formel (30)

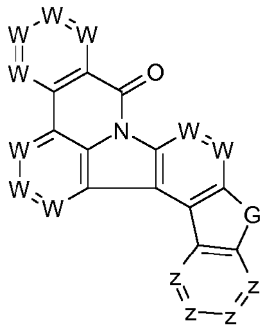
Formel (31)

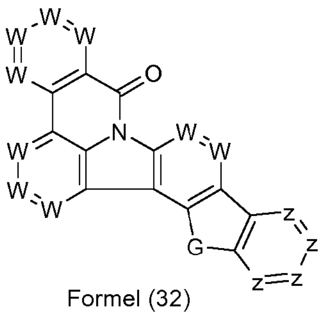
Formel (32)

wobei die verwendeten Symbole die oben genannten Bedeutungen aufweisen.

Es ist weiterhin bevorzugt, wenn W für CR oder N steht. In einer bevorzugten Ausführungsform der Erfindung steht pro Cyclus in den Verbindungen der Formel (27) bis (32) jeweils maximal eine Gruppe W bzw. Z für N und die anderen Gruppen W bzw. Z stehen für CR. Besonders bevorzugt stehen alle Gruppen W und Z für CR.

In einer weiteren bevorzugten Ausführungsform der Erfindung steht G für $CR_2$, NR oder O, besonders bevorzugt für $CR_2$ oder NR und ganz besonders bevorzugt für $CR_2$. In einer besonders bevorzugten Ausführungsform der Erfindung stehen alle Gruppen W und Z für CR und G steht gleichzeitig für $CR_2$, NR oder O, besonders bevorzugt für $CR_2$ oder NR und insbesondere für $CR_2$.

Bevorzugte Verbindungen der Formel (27) bis (32) sind somit die Verbindungen der folgenden Formeln (27a) bis (32a),

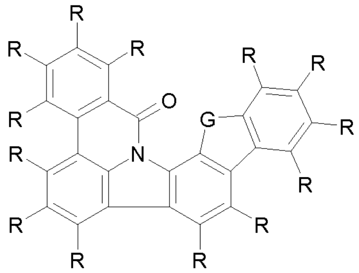

Formel (27a)

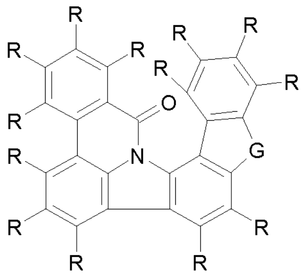

Formel (28a)

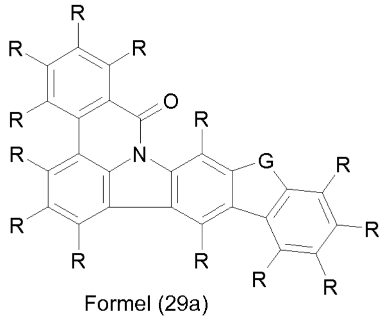

Formel (29a)

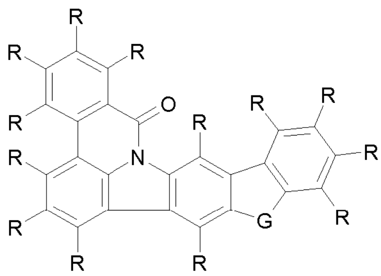

Formel (30a)

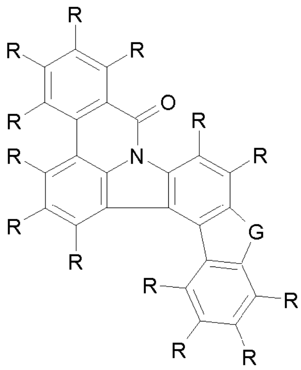

Formel (31a)

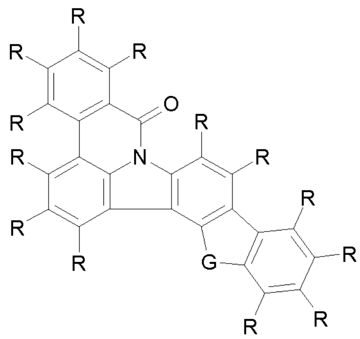

Formel (32a)

wobei die verwendeten Symbole die vorstehend genannten Bedeutungen aufweisen.

Die folgenden Verbindungen der Formeln (27b) bis (32b) sind besonders bevorzugt:

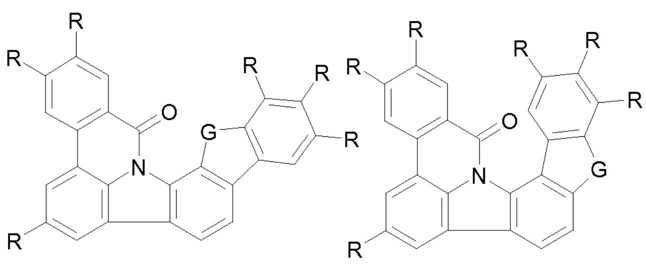

Formel (27b)

Formel (28b)

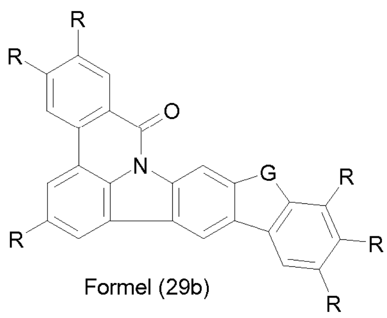

Formel (29b)

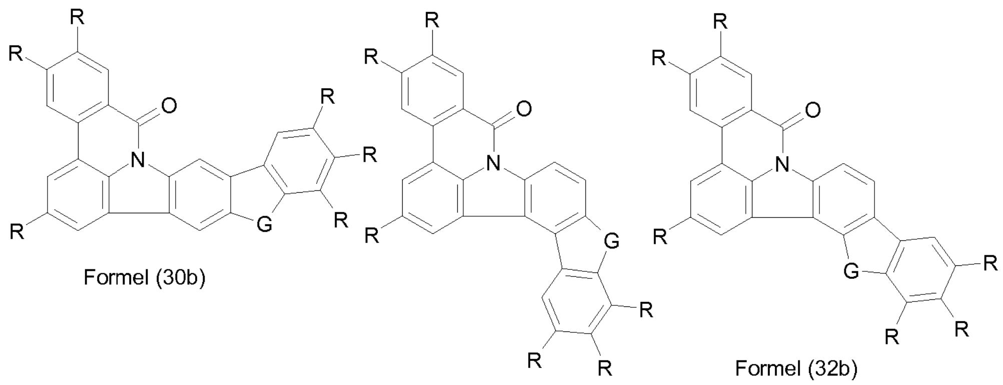

Formel (30b) Formel (31b) Formel (32b)

.

Dabei weisen R und G die oben genannten Bedeutungen auf und die oben bzw. im Folgenden genannten bevorzugten Bedeutungen.

Die verbrückende Gruppe J in den Verbindungen der Formeln (2a) ist bevorzugt ausgewählt aus einer Einfachbindung oder einem aromatischen oder heteroaromatischen Ringsystem mit 5 bis 30 aromatischen Ringatomen, welches durch einen oder mehrere Reste R substituiert sein kann. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind.

In einer weiteren bevorzugten Ausführungsform der Erfindung ist der Index m in Verbindungen der Formel (2a) gleich 2 oder 3, insbesondere gleich 2. Ganz besonders bevorzugt werden Verbindungen der Formel (2) eingesetzt.

In einer bevorzugten Ausführungsform der Erfindung ist R in den oben genannten Formeln gleich oder verschieden bei jedem Auftreten ausgewählt aus der Gruppe bestehend aus H, D, F, Cl, Br, CN, $N(Ar^5)_2$, $C(=O)Ar^5$, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenyl- oder Alkinylgruppe mit 2 bis 10 C-Atomen, die jeweils mit einem oder mehreren Resten $R^1$ substituiert sein kann, wobei eine oder mehrere nicht-benachbarte $CH_2$-Gruppen durch O ersetzt sein können und wobei ein oder mehrere H-Atome durch D oder F ersetzt sein können, einem aromatischen oder heteroaromatischen Ringsystem mit 5 bis 30 aromatischen Ringatomen, das jeweils mit einem oder mehreren Resten $R^6$ substituiert sein kann, einer Aryloxy- oder Heteroaryloxygruppe mit 5 bis 30 aromatischen Ringatomen, die mit einem oder mehreren Resten $R^6$ substituiert sein kann, oder einer Kombination dieser Systeme. Besonders bevorzugt ist R in den oben genannten Formeln gleich oder verschieden bei jedem Auftreten ausgewählt aus der Gruppe bestehend aus H, D, F, Cl, Br, CN, einer geradkettigen Alkylgruppe mit 1 bis 10 C-Atomen oder einer verzweigten oder cyclischen Alkylgruppe mit 3 bis 10 C-Atomen, die jeweils mit einem oder mehreren Resten $R^6$ substituiert sein kann, wobei ein oder mehrere H-Atome durch D oder F ersetzt sein können, einem aromatischen oder heteroaromatischen Ringsystem mit 5 bis 18 aromatischen Ringatomen, das jeweils mit einem oder mehreren Resten $R^6$ substituiert sein kann, oder einer Kombination dieser Systeme.

Dabei enthalten die Reste R, wenn diese aromatische oder heteroaromatische Ringsysteme enthalten, bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Insbesondere bevorzugt sind hier Phenyl, Biphenyl, Terphenyl, Quaterphenyl, Carbazol, Dibenzothiophen, Dibenzofuran, Indenocarbazol, Indolocarbazol, Triazin oder Pyrimidin, welche jeweils auch durch einen oder mehrere Reste $R^6$ substituiert sein können. Dabei ist es auch bevorzugt, wenn in den Resten $R^6$ nicht mehr als zwei aromatische Sechsringe direkt aneinander ankondensiert sind. Besonders bevorzugt enthält $R^6$ überhaupt keine Aryl- bzw. Heteroarylgruppen, in denen aromatische Sechsringe direkt aneinander ankondensiert sind.

Die Synthese der Verbindungen der Formel (2) kann gemäß den in der WO 2011/116865 und WO 2011/137951 beschriebenen Verfahren erfolgen.

Beispiele für erfindungsgemäß bevorzugte Verbindungen des eletronentransportierenden Host gemäß den oben aufgeführten Ausführungsformen sind die nachfolgend aufgeführten Verbindungen.

| | | |
|---|---|---|
| 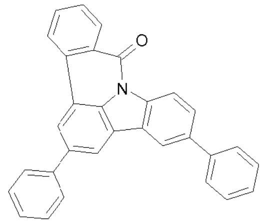 | 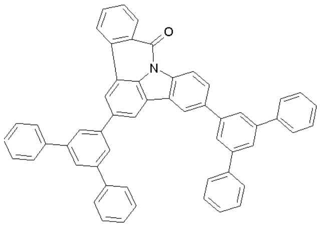 | 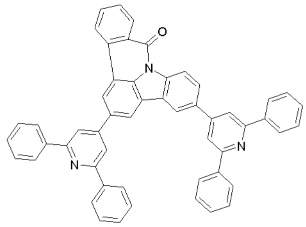 |
| 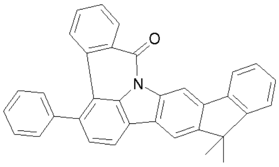 | 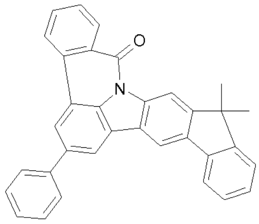 | 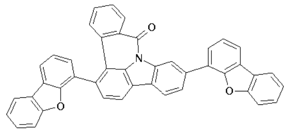 |
| 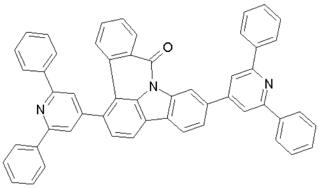 | 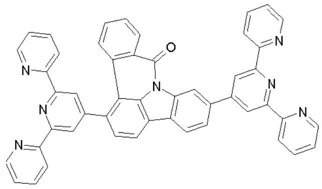 | 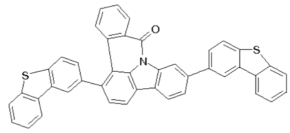 |

| | | |
|---|---|---|
| 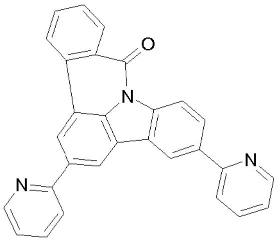 | 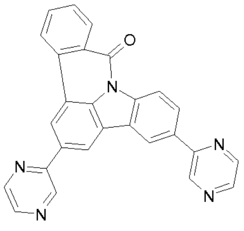 | 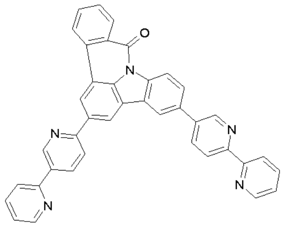 |
| 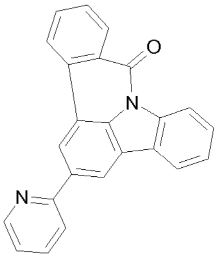 | 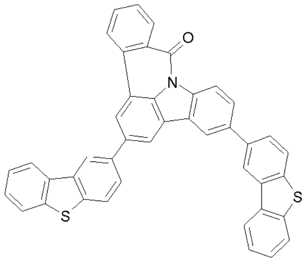 | 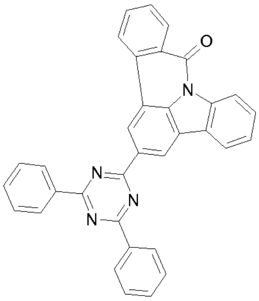 |
| 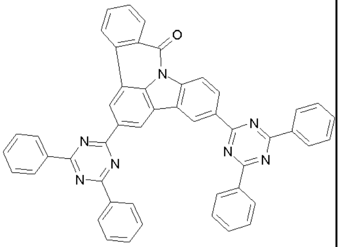 | 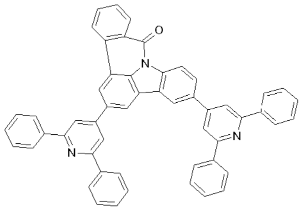 | 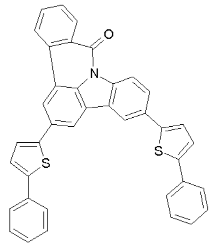 |
| 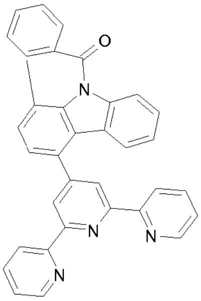 | 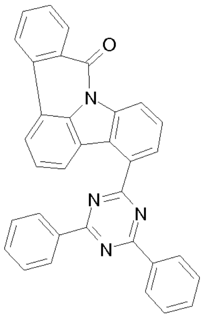 | 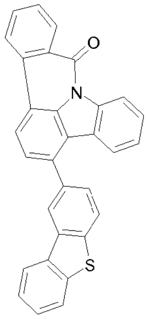 |
| 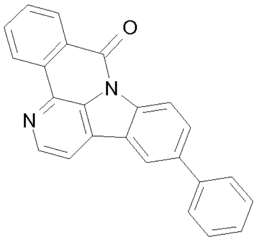 | 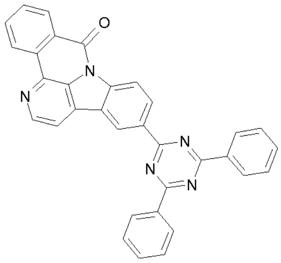 | 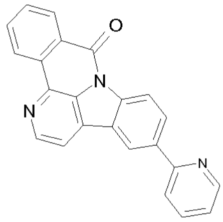 |
| 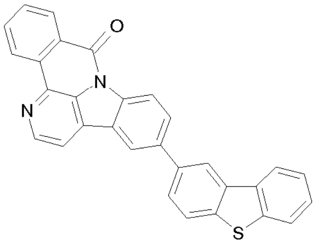 | 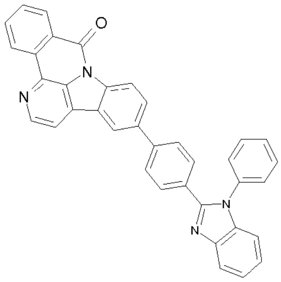 | 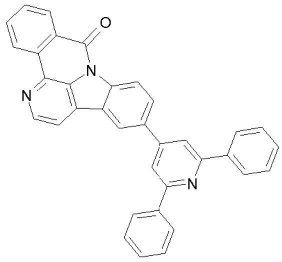 |

| | | |
|---|---|---|
| 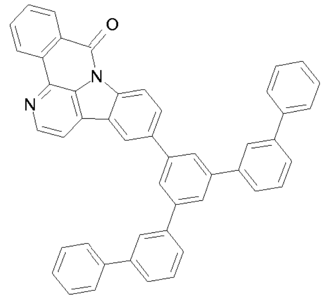 | 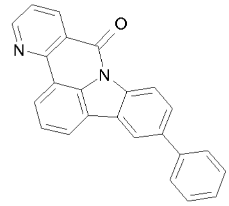 | 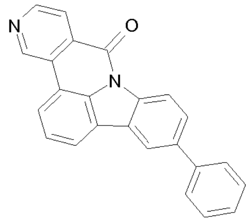 |
| 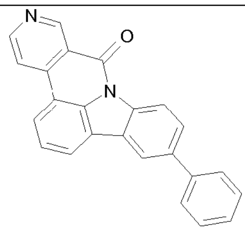 | 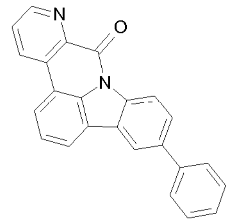 | 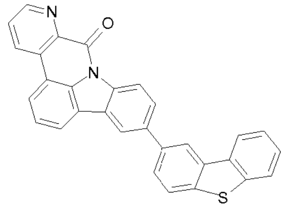 |
| 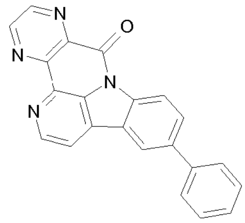 | 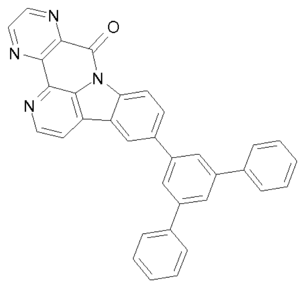 | 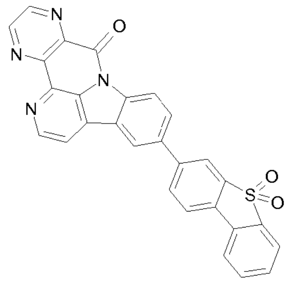 |
| 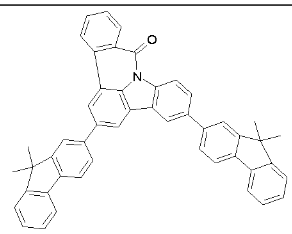 | 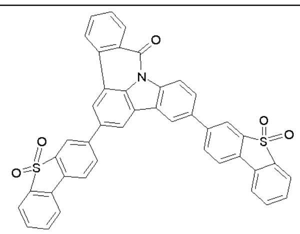 | 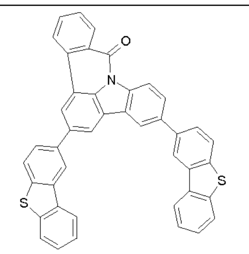 |
| 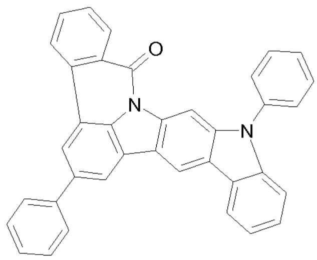 | 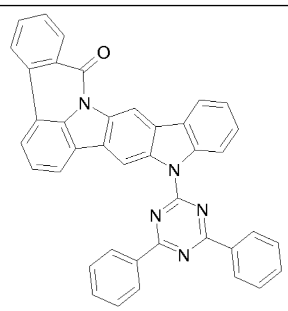 | 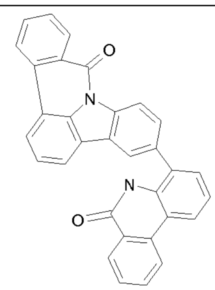 |
| 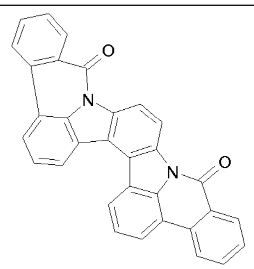 | 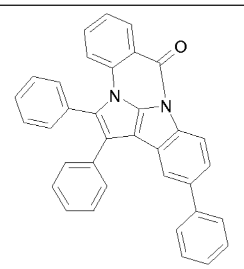 | 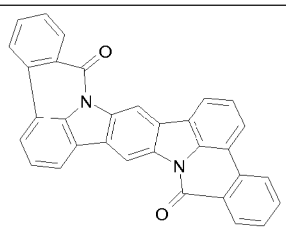 |

| | | |
|---|---|---|
| 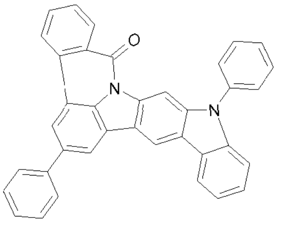 | 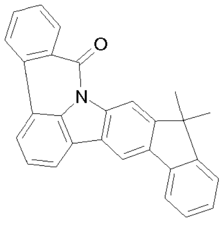 | 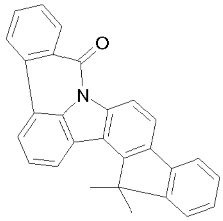 |
| 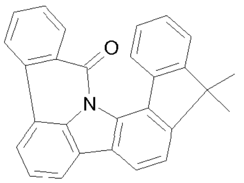 | 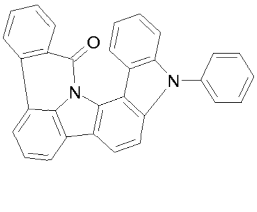 | 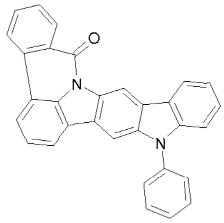 |
| 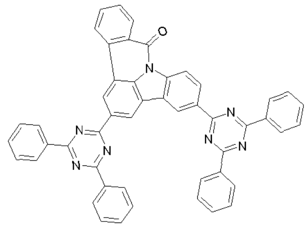 | 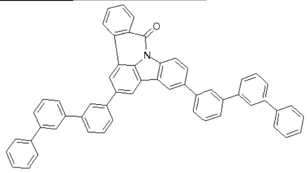 | 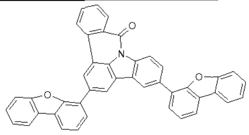 |
| 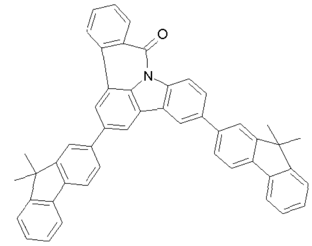 | 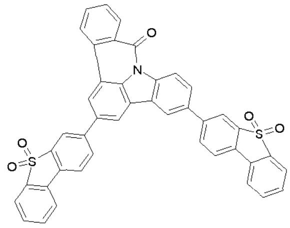 | 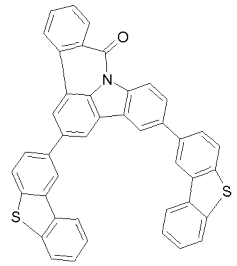 |
| 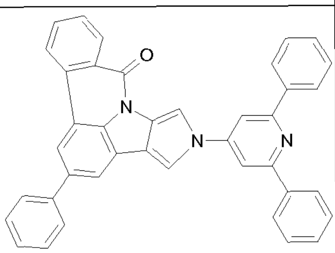 | 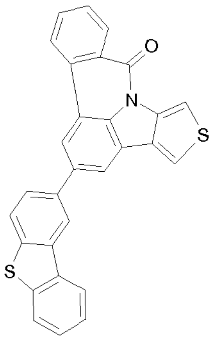 | 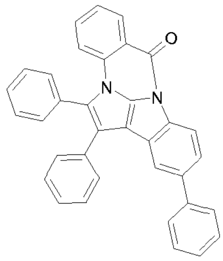 |
| 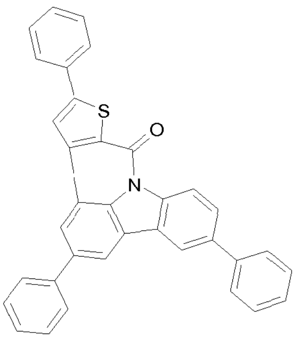 | 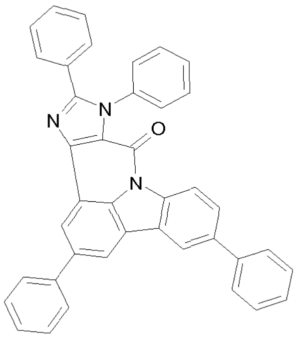 | 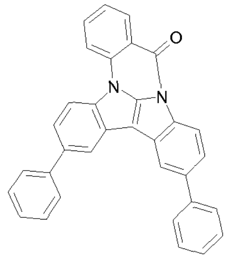 |

| | | |
|---|---|---|
| 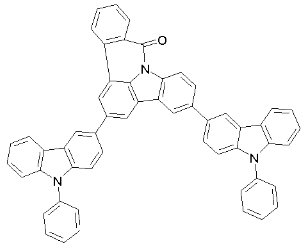 | 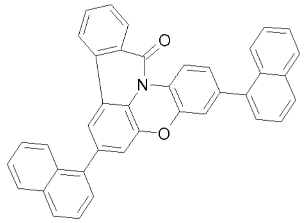 | 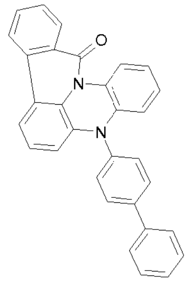 |
| 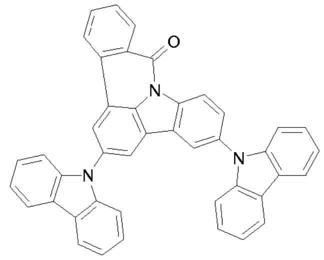 | 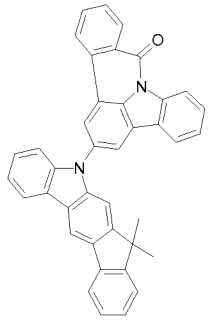 | 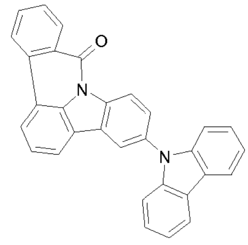 |
| 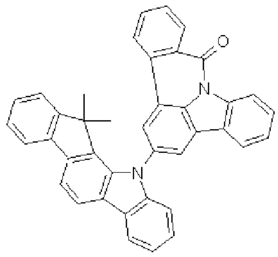 | 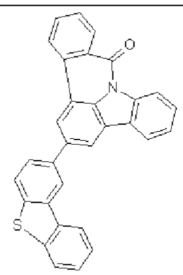 | 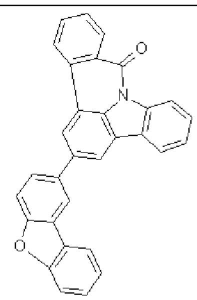 |
| 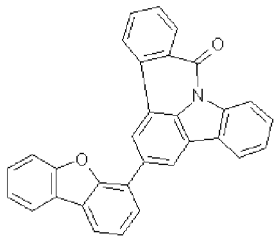 | 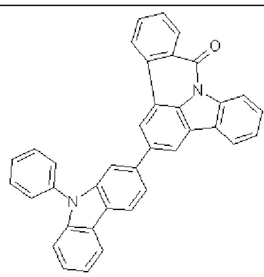 | 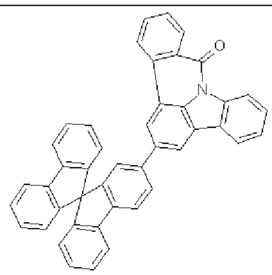 |
| 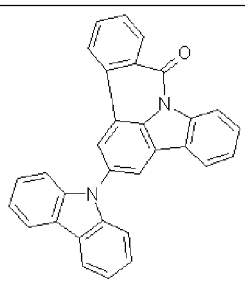 | 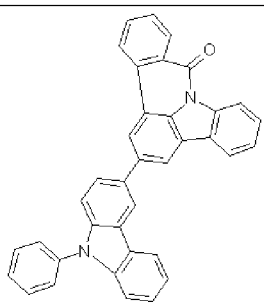 | 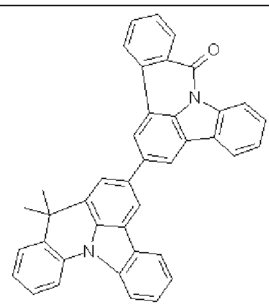 |

| | | |
|---|---|---|
| 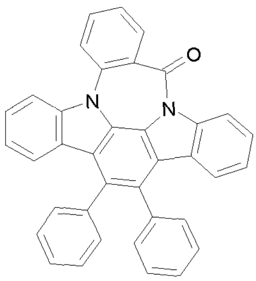 | 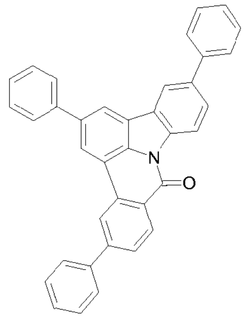 | 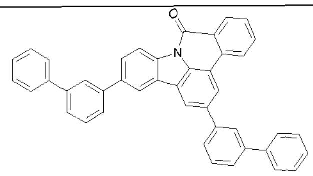 |
| 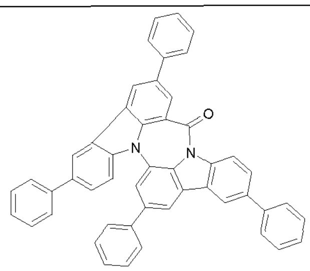 | 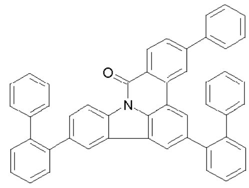 | 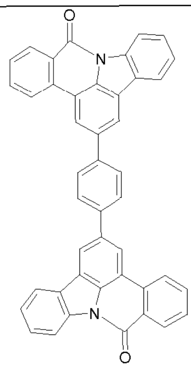 |
| 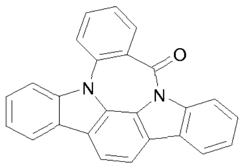 | 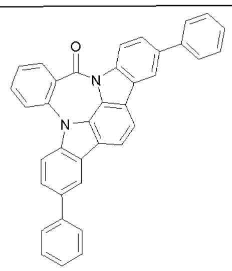 | 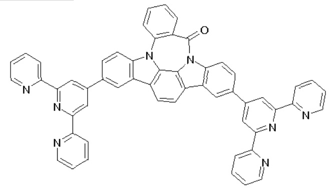 |
| 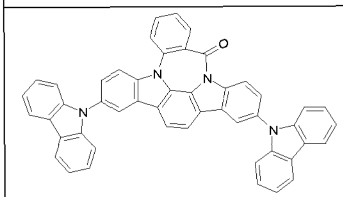 | 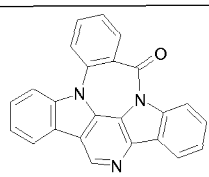 | 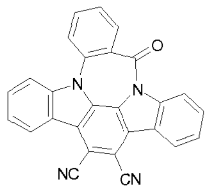 |
| 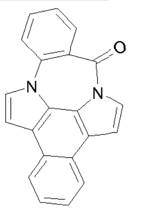 | 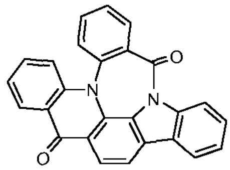 | 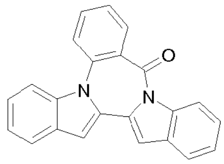 |
| 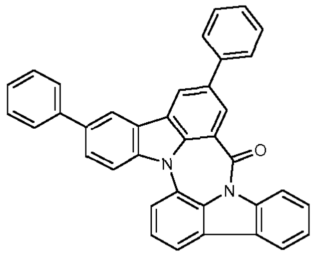 | 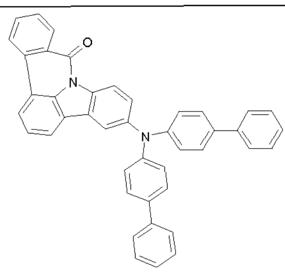 | 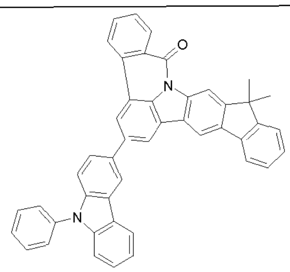 |

| | | |
|---|---|---|
| 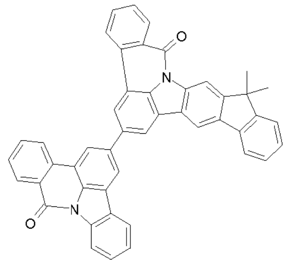 | 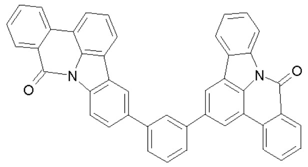 | 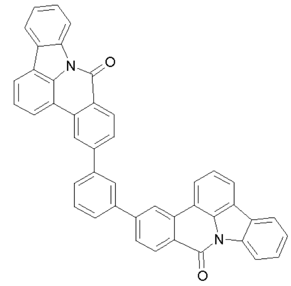 |
| 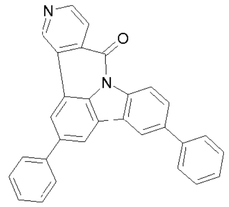 | 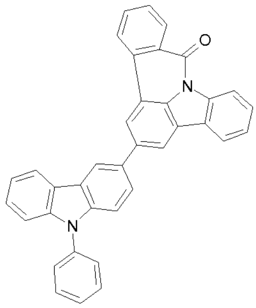 | 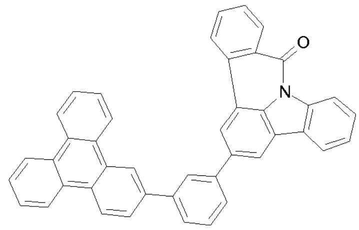 |
| 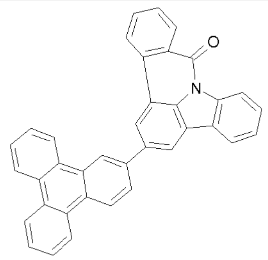 | 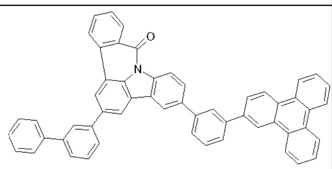 | 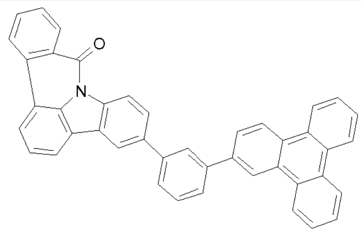 |
| 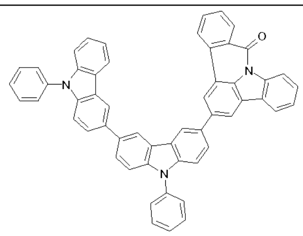 | 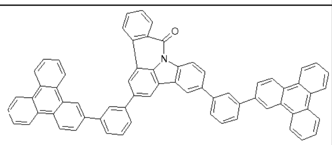 | 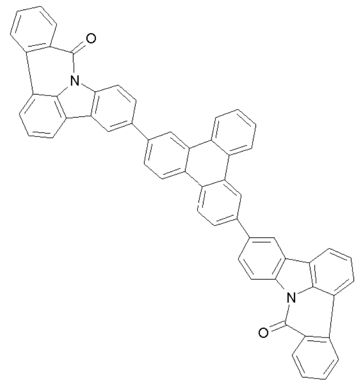 |
| 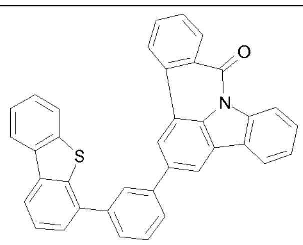 | 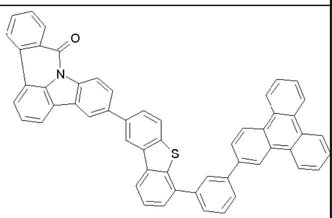 | 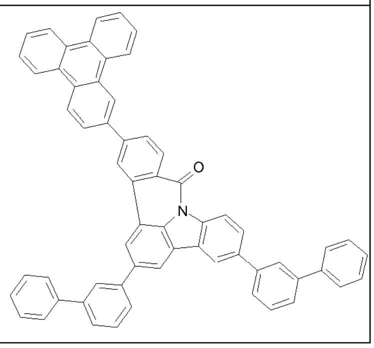 |

| | | |
|---|---|---|
| 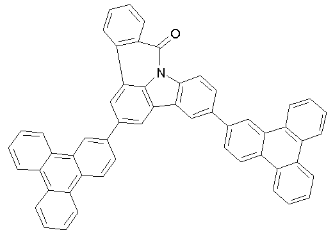 | 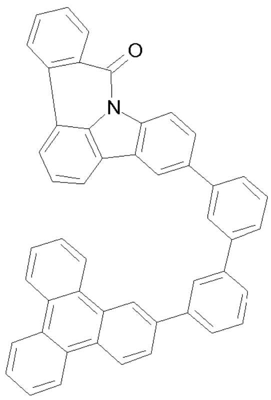 | 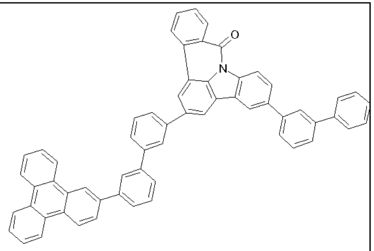 |
| 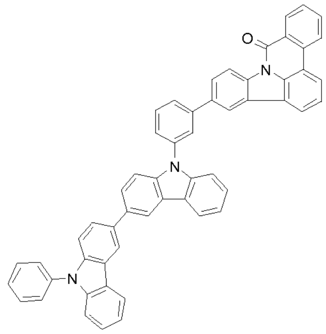 | 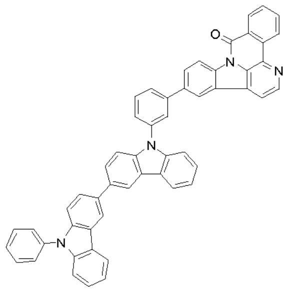 | 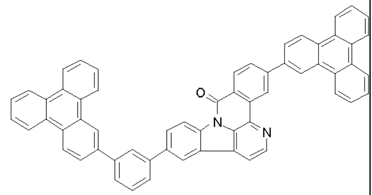 |
| 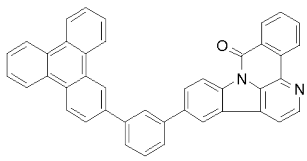 | 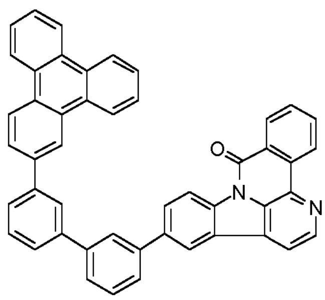 | 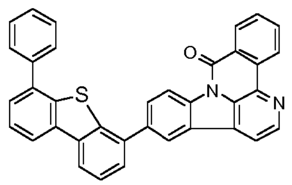 |
| 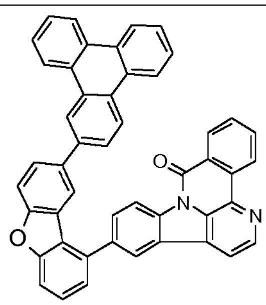 | | |

Die Konzentration des elektronentransportierenden Hosts in der erfindungsgemäßen Zusammensetzung liegt im Bereich von 5 Gew.-% bis 90 Gew.-%, bevorzugt im Bereich von 10 Gew.-% bis 85 Gew.-%, mehr bevorzugt im Bereich von 20 Gew.-% bis 85 Gew.-%, noch mehr bevorzugt im Bereich von 30 Gew.-% bis 80 Gew.-%, ganz besonders bevorzugt im Bereich von 20 Gew.-% bis 60 Gew.-% und am meisten bevorzugt im Bereich von 30 Gew.-% bis 50 Gew.-%, bezogen auf die gesamte Zusammensetzung.

Die Konzentration des bipolaren Hosts in der Zusammensetzung liegt im Bereich von 10 Gew.-% bis 95 Gew.-%, bevorzugt im Bereich von 15 Gew.-% bis 90 Gew.-%, mehr bevorzugt im Bereich von 15 Gew.-% bis 80 Gew.-%, noch mehr bevorzugt im Bereich von 20 Gew.-% bis 70 Gew.-%, ganz besonders bevorzugt im Bereich von 40 Gew.-% bis 80 Gew.-% und am meisten bevorzugt im Bereich von 50 Gew.-% bis 70 Gew.-%, bezogen auf die gesamte Zusammensetzung.

Die erfindungsgemäße Zusammensetzung kann in einer weiteren bevorzugten Ausführungsform neben einem bipolaren Host und einem elektronentransportierenden Host noch weitere Verbindungen, insbesondere organische

funktionelle Materialien, enthalten.

Die vorliegende Erfindung betrifft daher auch eine Zusammensetzung, die neben den vorstehend genannten Materialien mindestens noch eine weitere Verbindung enthält, die ausgewählt ist aus der Gruppe bestehend aus Lochinjektionsmaterialien, Lochtransportmaterialien, Lochblockiermaterialien, wide-band-gap-Materialien, fluoreszierenden Emittern, phosphoreszierenden Emittern, Hostmaterialien, Matrixmaterialien, Elektronenblockiermaterialien, Elektronentransportmaterialien und Elektroneninjektionsmaterialien, n-Dotanden und p-Dotanden. Es bereitet dem Fachmann dabei keinerlei Schwierigkeiten, diese aus einer Vielzahl ihm bekannter Materialien auszuwählen.

Unter n-Dotanden werden hierin Reduktionsmittel, d.h. Elektronendonatoren verstanden. Bevorzugte Beispiele für n-Dotanden sind $W(hpp)_4$ und weitere elektronenreiche Metallkomplexe gemäß WO 2005/086251 A2, P=N-Verbindungen (z.B. WO 2012/175535 A1, WO 2012/175219 A1), Naphthylencarbodiimide (z.B. WO 2012/168358 A1), Fluorene (z.B. WO 2012/031735 A1), Radikale und Diradikale (z.B. EP 1837926 A1, WO 2007/107306 A1), Pyridine (z.B. EP 2452946 A1, EP 2463927 A1), N-heterocyclische Verbindungen (z.B. WO 2009/000237 A1) und Acridine sowie Phenazine (z.B. US 2007/145355 A1).

Unter p-Dotanden werden hierin Oxidationsmittel, d.h. Elektronenakzeptoren verstanden. Bevorzugte Beispiele für p-Dotanden sind $F_4$-TCNQ, $F_6$-TNAP, NDP-2 (Fa. Novaled), NDP-9 (Fa. Novaled), Chinone (z.B. EP 1538684 A1, WO 2006/081780 A1, WO 2009/003455 A1, WO 2010/097433 A1), Radialene (z.B. EP 1988587 A1, US 2010/102709 A1, EP 2180029 A1, WO 2011/131185 A1, WO 2011134458 A1, US 2012/223296 A1), S-haltige Übergangsmetallkomplexe (z.B. WO 2007/134873 A1, WO 2008/061517 A2, WO 2008/061518 A2, DE 102008051737 A1, WO 2009/089821 A1, US 2010/096600 A1), Bisimidazole (z.B. WO 2008/138580 A1), Phthalocyanine (z.B. WO 2008/058525 A2), Bora-Tetraazapentalene (z.B. WO 2007/115540 A1) Fullerene (z.B. DE 102010046040 A1) und Hauptgruppenhalogenide (z.B. WO 2008/128519 A2).

Unter *wide-band-gap*-Material wird hierin ein Material im Sinne der Offenbarung von US 7,294,849 verstanden, das durch eine Bandlücke von mindestens 3.5 eV charakterisiert ist, wobei unter Bandlücke der Abstand zwischen HOMO und LUMO-Energie eines Materials verstanden wird. Diese Systeme zeigen besondere vorteilhafte Leistungsdaten in elektrolumineszierenden Vorrichtungen.

Es ist bevorzugt, wenn die erfindungsgemäße Zusammensetzung umfassend einen bipolaren Host und einen elektronentransportierenden Host zusätzlich wenigstens eine lichtemittierende Verbindung bzw. einen Emitter enthält, wobei phosphoreszierende Emitter besonders bevorzugt sind.

Vom Begriff phosphoreszierende Emitter sind typischerweise Verbindungen umfasst, bei denen die Lichtemission durch einen spin-verbotenen Übergang aus einem angeregten Zustand mit höherer Spinmultiplizität, also einem Spinzustand > 1, erfolgt, beispielsweise durch einen Übergang aus einem Triplett-Zustand oder einem Zustand mit einer noch höheren Spinquantenzahl, beispielsweise einem Quintett-Zustand. Bevorzugt wird hierbei ein Übergang aus einem Triplett-Zustand verstanden.

Als phosphoreszierende Emitter (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten, insbesondere ein Metall mit dieser Ordnungszahl. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium oder Platin enthalten. Im Sinne der vorliegenden Erfindung werden alle lumineszierenden Verbindungen, die die oben genannten Metalle enthalten, als phosphoreszierende Emitter angesehen.

Beispiele der oben beschriebenen Emitter können den Anmeldungen WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094961, WO 2014/094960, EP 13004411.8, EP 14000345.0, EP 14000417.7 und EP 14002623.8 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind, und der Fachmann kann ohne erfinderisches Zutun weitere phosphoreszierende Komplexe verwenden.

Bevorzugte fluoreszierende Emitter sind ausgewählt aus der Klasse der Arylamine. Unter einem Arylamin bzw. einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter

einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte fluoreszierende Emitter sind Indenofluorenamine bzw. -diamine, beispielsweise gemäß WO 2006/108497 oder WO 2006/122630, Benzoindenofluorenamine bzw. -diamine, beispielsweise gemäß WO 2008/006449, und Dibenzoindenofluorenamine bzw. -diamine, beispielsweise gemäß WO 2007/140847, sowie die in WO 2010/012328 offenbarten Indenofluorenderivate mit kondensierten Arylgruppen.

In einer weiteren bevorzugten Ausführungsform der Erfindung wird die erfindungsgemäße Zusammensetzung als eine Komponente von Mixed-Matrix-Systemen verwendet. Die Mixed-Matrix-Systeme umfassen bevorzugt drei oder vier verschiedene Matrixmaterialien, besonders bevorzugt drei verschiedene Matrixmaterialien (das heißt, eine weitere Matrixkomponente zusätzlich zu der erfindungsgemäßen Zusammensetzung). Besonders geeignete Matrixmaterialien, welche in Kombination mit der erfindungsgemäßen Zusammensetzung als Matrixkomponenten eines Mixed-Matrix-Systems verwendet werden können, sind ausgewählt aus wide-band-gap-Materialien, Elektronentransportmaterialien (ETM) und Lochtransportmaterialien (HTM).

Bevorzugt werden Mixed-Matrix-Systeme in phosphoreszierenden organischen Elektrolumineszenzvorrichtungen eingesetzt. Genauere Angaben zu Mixed-Matrix-Systemen sind unter anderem in der Anmeldung WO 2010/108579 enthalten. Besonders geeignete Matrixmaterialien, welche in Kombination mit der erfindungsgemäßen Zusammensetzung als Matrixkomponenten eines Mixed-Matrix-Systems in phosphoreszierenden oder fluoreszierenden organischen Elektrolumineszenzvorrichtungen eingesetzt werden können, sind ausgewählt aus den unten angegebenen bevorzugten Matrixmaterialien für phosphoreszierende Emitter oder den bevorzugten Matrixmaterialien für fluoreszierende Emitter, je nachdem welche Art von Emitter eingesetzt wird.

Als weitere Matrixmaterialien, bevorzugt für fluoreszierende Emitter, kommen neben der erfindungsgemäßen Zusammensetzung umfassend den bipolaren Host und den elektronentransportierenden Host verschiedene Stoffklassen in Frage. Bevorzugte weitere Matrixmaterialien sind ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, der Oligoarylenvinylene (z. B. DPVBi oder Spiro-DPVBi gemäß EP 676461), der polypodalen Metallkomplexe (z. B. gemäß WO 2004/081017), der lochleitenden Verbindungen (z. B. gemäß WO 2004/058911), der elektronenleitenden Verbindungen, insbesondere Ketone, Phosphinoxide, Sulfoxide, etc. (z. B. gemäß WO 2005/084081 und WO 2005/084082), der Atropisomere (z. B. gemäß WO 2006/048268), der Boronsäurederivate (z. B. gemäß WO 2006/117052) oder der Benzanthracene (z. B. gemäß WO 2008/145239). Besonders bevorzugte Matrixmaterialien sind ausgewählt aus den Klassen der Oligoarylene, enthaltend Naphthalin, Anthracen, Benzanthracen und/oder Pyren oder Atropisomere dieser Verbindungen, der Oligoarylenvinylene, der Ketone, der Phosphinoxide und der Sulfoxide. Ganz besonders bevorzugte Matrix-materialien sind ausgewählt aus den Klassen der Oligoarylene, enthaltend Anthracen, Benzanthracen, Benzphenanthren und/oder Pyren oder Atropisomere dieser Verbindungen. Unter einem Oligoarylen im Sinne dieser Erfindung soll eine Verbindung verstanden werden, in der mindestens drei Aryl- bzw. Arylengruppen aneinander gebunden sind.

Bevorzugte weitere Matrixmaterialien für phosphoreszierende Emitter sind neben der erfindungsgemäßen Zusammensetzung umfassend den bipolaren Host und den elektronentransportierenden Host aromatische Amine, insbesondere Triarylamine, z. B. gemäß US 2005/0069729, Carbazolderivate (z. B. CBP, N,N-Biscarbazolylbiphenyl) oder Verbindungen gemäß WO 2005/039246, US 2005/0069729, JP 2004/288381, EP 1205527 oder WO 2008/086851, verbrückte Carbazolderivate, z. B. gemäß WO 2011/088877 und WO 2011/128017, Indenocarbazolderivate, z. B. gemäß WO 2010/136109 und WO 2011/000455, Azacarbazolderivate, z. B. gemäß EP 1617710, EP 1617711, EP 1731584, JP 2005/347160, Indolocarbazolderivate, z. B. gemäß WO 2007/063754 oder WO 2008/056746, Ketone, z. B. gemäß WO 2004/093207 oder WO 2010/006680, Phosphinoxide, Sulfoxide und Sulfone, z. B. gemäß WO 2005/003253, Oligophenylene, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Aluminiumkomplexe, z. B. BAlq, Diazasilol- und Tetraazasilol-Derivate, z. B. gemäß WO 2010/054729, DiazaphospholDerivate, z. B. gemäß WO 2010/054730 und Aluminiumkomplexe, z. B. BAIQ.

Gemäß einer alternativen Ausführungsform der vorliegenden Erfindung enthält die Zusammensetzung neben den Bestandteilen bipolarer Host und elektronentransportierender Host keine weiteren Bestandteile, das heißt, funktionellen Materialien.

Die erfindungsgemäße Zusammensetzung eignet sich für die Verwendung in einer organischen elektronischen Vorrichtung. Dabei wird unter einer organischen elektronischen Vorrichtung eine Vorrichtung verstanden, welche mindestens eine Schicht enthält, die mindestens eine organische Verbindung enthält. Die Vorrichtung kann aber auch anorganische Materialien enthalten oder auch Schichten, welche vollständig aus anorganischen Materialien aufgebaut sind.

Die Komponenten bzw. Bestandteile der Zusammensetzungen können dabei durch Aufdampfen oder aus

Lösung prozessiert werden. Sofern die Zusammensetzungen aus Lösung aufgebracht werden, sind Formulierungen der erfindungsgemäßen Zusammensetzung enthaltend wenigstens ein weiteres Lösungsmittel erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden.

Ein weiterer Gegenstand der vorliegenden Erfindung ist daher eine Formulierung enthaltend eine erfindungsgemäße Zusammensetzung und mindestens ein Lösungsmittel.

Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan oder Mischungen dieser Lösemittel.

Die Formulierung kann dabei auch mindestens eine weitere organische oder anorganische Verbindung enthalten, die ebenfalls in der elektronischen Vorrichtung eingesetzt wird, insbesondere eine emittierende Verbindung, insbesondere ein phosphoreszierender Emitter und/oder ein weiteres Matrixmaterial. Geeignete emittierende Verbindungen und weitere Matrixmaterialien wurden vorstehend bereits aufgeführt.

Gegenstand der vorliegenden Erfindung ist auch die Verwendung der erfindungsgemäßen Zusammensetzung in einer organischen elektronischen Vorrichtung, bevorzugt in einer elektronentransportierenden und/oder in einer emittierenden Schicht.

Die organische elektronische Vorrichtung ist bevorzugt gewählt aus den organischen integrierten Schaltungen (OICs), organischen Feld-Effekt-Transistoren (OFETs), organischen Dünnfilmtransistoren (OTFTs), organischen Elektrolumineszenzvorrichtungen, organischen Solarzellen (OSCs), organischen optischen Detektoren und organischen Photorezeptoren, wobei die organischen Elektrolumineszenzvorrichtungen besonders bevorzugt sind.

Ganz besonders bevorzugte organische Elektrolumineszenzvorrichtungen für die Verwendung der erfindungsgemäßen Zusammensetzung sind organische lichtemittierende Transistoren (OLETs), organische Feld-Quench-Devices (OFQDs), organische lichtemittierende elektrochemischen Zellen (OLECs, LECs, LEECs), organische Laserdioden (O-Laser) und organische lichtemittierende Dioden (OLEDs), insbesondere bevorzugt sind OLECs und OLEDs und am meisten bevorzugt sind OLEDs.

Bevorzugt wird die erfindungsgemäße Zusammensetzung umfassend den bipolaren Host und den elektronentransportierenden Host in einer elektronischen Vorrichtung in einer Schicht mit elektronentransportierender Funktion verwendet. Die Schicht ist bevorzugt eine Elektroneninjektionsschicht (EIL), eine Elektronentransportschicht (ETL), eine Lochblockierschicht (HBL) und/oder eine Emissionsschicht (EML), besonders bevorzugt eine ETL, EIL und /oder eine EML. Ganz besonders bevorzugt wird die erfindungsgemäße Zusammensetzung in einer EML eingesetzt, insbesondere als Matrixmaterial.

Nochmals ein weiterer Gegenstand der vorliegenden Erfindung ist deshalb eine organische elektronische Vorrichtung, die insbesondere aus einer der vorstehend genannten elektronischen Vorrichtungen ausgewählt ist und die die erfindungsgemäße Zusammenfassung umfassend einen bipolaren Host und einen elektronentransportierenden Host enthält, bevorzugt in einer Emissionsschicht (EML), in einer Elektronentransportschicht (ETL), in einer Elektroneninjektionsschicht (EIL) und/oder in einer Lochblockierschicht (HBL), ganz bevorzugt in einer EML, EIL und/oder ETL und ganz besonders bevorzugt in einer EML.

Wenn es sich um eine emittierende Schicht handelt, dann ist es insbesondere bevorzugt eine phosphoreszierende Schicht, die dadurch gekennzeichnet ist, dass sie zusätzlich zu der Zusammensetzung umfassend den bipolaren Host und den elektronentransportierenden Host einen phosphoreszierenden Emitter enthält.

In einer besonders bevorzugten Ausführungsform der vorliegenden Erfindung handelt es sich daher bei der elektronische Vorrichtung um eine organische Elektrolumineszenzvorrichtung, ganz besonders bevorzugt um eine organische lichtemittierende Diode (OLED), die die erfindungsgemäße Zusammenfassung umfassend einen bipolaren Host und einen elektronentransportierenden Host zusammen mit einem phosphoreszierenden Emitter in der Emissionsschicht (EML) enthält.

Die Zusammensetzung aus bipolarem Host und elektronentransportierendem Host gemäß den bevorzugten Ausführungsformen und der emittierenden Verbindung enthält vorzugsweise zwischen 99,9 und 1 Vol.-%, weiter vorzugsweise zwischen 99 und 10 Vol.-%, besonders bevorzugt zwischen 98 und 60 Vol.-%, ganz besonders bevorzugt zwischen 97 und 80 Vol.-% an Matrixmaterial aus bipolarem und elektronentransportierendem Host gemäß den bevorzugten Ausführungsformen, bezogen auf die gesamte Mischung aus Emitter und Matrixmaterial. Entsprechend enthält die Zusammensetzung vorzugsweise zwischen 0,1 und 99 Vol.-%, weiter vorzugsweise zwischen 1 und 90 Vol.-%,

besonders bevorzugt zwischen 2 und 40 Vol.-%, ganz besonders bevorzugt zwischen 3 und 20 Vol.-% des Emitters bezogen auf die gesamte Mischung aus Emitter und Matrixmaterial. Werden die Verbindungen aus Lösung verarbeitet, so werden statt der oben angegebenen Mengen in Vol.-% bevorzugt die entsprechenden Mengen in Gew.-% verwendet.

Außer Kathode, Anode und der Schicht enthaltend die erfindungsgemäße Zusammensetzung kann eine elektronische Vorrichtung noch weitere Schichten enthalten. Diese sind beispielsweise gewählt aus jeweils einer oder mehreren Lochinjektionsschichten, Lochtransportschichten, Lochblockierschichten, emittierenden Schichten, Elektronentransportschichten, Elektroneninjektionsschichten, Elektronenblockierschichten, Excitonenblockierschichten, Zwischenschichten (Interlayers), Ladungserzeugungsschichten (Charge-Generation Layers) (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer) und/oder organischen oder anorganischen p/n-Übergängen. Es sei aber darauf hingewiesen, dass nicht notwendigerweise jede dieser Schichten vorhanden sein muss.

Die Abfolge der Schichten in einer organischen Elektrolumineszenzvorrichtung ist bevorzugt die folgende:
Anode / Lochinjektionsschicht / Lochtransportschicht / emittierende Schicht / Elektronentransportschicht / Elektroneninjektionsschicht / Kathode.

Dabei soll erneut darauf hingewiesen werden, dass nicht alle der genannten Schichten vorhanden sein müssen, und/oder dass zusätzlich weitere Schichten vorhanden sein können.

Eine organische Elektrolumineszenzvorrichtung, die die erfindungsgemäße Zusammensetzung enthält, kann mehrere emittierende Schichten enthalten. Besonders bevorzugt weisen diese Emissionsschichten in diesem Fall insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die blaues oder gelbes oder orangefarbenes oder rotes Licht emittieren. Insbesondere bevorzugt sind Dreischichtsysteme, also Systeme mit drei emittierenden Schichten, wobei die drei Schichten blaue, grüne und orange oder rote Emission zeigen (für den prinzipiellen Aufbau siehe z. B. WO 2005/011013). Es soll angemerkt werden, dass sich für die Erzeugung von weißem Licht anstelle mehrerer farbig emittierender Emitterverbindungen auch eine einzeln verwendete Emitterverbindung eignen kann, welche in einem breiten Wellenlängenbereich emittiert.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Als Materialien für die Elektronentransportschicht können alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise $Alq_3$, Zirkoniumkomplexe, beispielsweise $Zrq_4$, Benzimidazolderviate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Weiterhin geeignete Materialien sind Derivate der oben genannten Verbindungen, wie sie in JP 2000/053957, WO 2003/060956, WO 2004/028217, WO 2004/080975 und WO 2010/072300 offenbart werden.

Als Lochtransportmaterialien sind insbesondere Materialien bevorzugt, die in einer Lochtransport-, Lochinjektions- oder Elektronenblockierschicht verwendet werden können, wie Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627 oder der noch nicht offengelegten EP 12000929.5), Fluoren-Amine (z. B. gemäß EP 12005369.9, EP 12005370.7 und EP 12005371.5), Spiro-Dibenzopyran-Amine (z. B. gemäß der noch nicht offengelegten Anmeldung EP 11009127.9) und Dihydroacridin-Derivate (z. B. gemäß der noch nicht offengelegten EP 11007067.9).

Als Kathode elektronischer Vorrichtungen sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit

größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. $Al/Ni/NiO_x$, $Al/PtO_x$) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-ZinnOxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die organische elektronische Vorrichtung wird bei der Herstellung entsprechend (je nach Anwendung) strukturiert, kontaktiert und schließlich versiegelt, da sich die Lebensdauer der erfindungsgemäßen Vorrichtungen bei Anwesenheit von Wasser und/oder Luft verkürzt.

In einer weiteren bevorzugten Ausführungsform ist die organische elektronische Vorrichtung, die die erfindungsgemäße Zusammensetzung enthält, dadurch gekennzeichnet, dass eine oder mehrere organische Schichten enthaltend die erfindungsgemäße Zusammensetzung mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Dabei ist es jedoch auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere organische Schichten enthaltend die erfindungsgemäße Zusammensetzung aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen der Komponenten der erfindungsgemäßen Zusammensetzung nötig. Hohe Löslichkeit lässt sich durch geeignete Substitution der entsprechenden Verbindungen erreichen. Das Verarbeiten aus Lösung hat den Vorteil, dass die Schicht enthaltend die erfindungsgemäße Zusammensetzung sehr einfach und kostengünstig aufgebracht werden kann. Diese Technik eignet sich insbesondere für die Massenproduktion organischer elektronischer Vorrichtungen.

Weiterhin sind Hybridverfahren möglich, bei denen beispielsweise eine oder mehrere Schichten aus Lösung aufgebracht werden und eine oder mehrere weitere Schichten aufgedampft werden.

Diese Verfahren sind dem Fachmann generell bekannt und können von ihm ohne erfinderisches Zutun auf organische Elektrolumineszenzvorrichtungen angewandt werden.

Ein weiterer Gegenstand der vorliegenden Erfindung ist daher ein Verfahren zur Herstellung einer organischen elektronischen Vorrichtung, dadurch gekennzeichnet, dass mindestens eine organische Schicht enthaltend die erfindungsgemäße Zusammensetzung durch Gasphasenabscheidung, insbesondere mit einem Sublimationsverfahren und/oder mit einem OVPD (Organic Vapour Phase Deposition) Verfahren und/oder mit Hilfe einer Trägergassublimation, aufgebracht wird und/oder dass mindestens eine organische Schicht enthaltend die erfindungsgemäße Zusammensetzung aus Lösung, insbesondere durch Spincoating oder mit einem Druckverfahren, aufgebracht wird.

Bei der Herstellung einer organischen elektronischen Vorrichtung mittels Gasphasenabscheidung bestehen grundsätzlich zwei Möglichkeiten, wie eine organische Schicht, die die erfindungsgemäße Zusammensetzung enthalten soll und die mehrere verschiedene Bestandteile umfassen kann, auf ein beliebiges Substrat aufgebracht bzw. aufgedampft werden kann. Zum einen können die verwendeten Materialien jeweils in einer Materialquelle vorgelegt und schließlich aus den verschiedenen Materialquellen verdampft werden ("co-evaporation"). Zum anderen können die verschiedenen Materialien vorgemischt ("premixed") und das Gemisch in einer einzigen Materialquelle vorgelegt werden, aus der es schließlich verdampft wird ("premix-evaporation"). Dadurch lässt sich auf einfache und schnelle Art und Weise das Aufdampfen einer Schicht mit gleichmäßiger Verteilung der Komponenten erreichen, ohne dass ein präzises Ansteuerung einer Vielzahl an Materialqellen notwendig ist.

In einer bevorzugten Ausführungsform der vorliegenden Erfindung wird die mindestens eine organische Schicht deshalb mittels Gasphasenabscheidung aufgebracht, wobei die Bestandeile der Zusammensetzung vorgemischt und aus einer einzigen Materialquelle verdampft werden.

Die erfindungsgemäßen Zusammensetzungen bzw. die erfindungsgemäßen Vorrichtungen zeichnen sich durch folgende überraschende Vorteile gegenüber dem Stand der Technik aus:

1. Die Verwendung der erfindungsgemäßen Zusammensetzungen in organischen elektronischen Vorrichtungen,

insbesondere in einer organischen Elektrolumineszenzvorrichtungen, und insbesondere in einer OLED oder OLEC führt zu deutlichen Steigerungen der Lebensdauern der Vorrichtungen.

2. Die erfindungsgemäßen Zusammensetzungen eignen sich sehr gut für den Einsatz in einer Emissionsschicht und zeigen verbesserte Leistungsdaten, insbesondere Lebensdauer, gegenüber Verbindungen aus dem Stand der Technik, insbesondere auch für den Fall, dass die lichtemittierende Verbindung in geringen Konzentrationen bis zu ungefähr 5 Gew.-% in der Emissionsschicht vorhanden/eindotiert ist.

3. Die erfindungsgemäßen Zusammensetzungen können leicht prozessiert werden und eignen sich daher sehr gut für die Massenproduktion in der kommerziellen Anwendung.

4. Die erfindungsgemäßen Zusammensetzungen können vorgemischt und aus einer einzigen Materialquelle aufgedampft werden, so dass auf einfache und schnelle Art und Weise eine organische Schicht mit gleichmäßiger Verteilung der verwendeten Komponenten hergestellt werden kann.

Diese oben genannten Vorteile gehen nicht mit einer Verschlechterung der weiteren elektronischen Eigenschaften einer elektronischen Vorrichtung einher.
Die Erfindung wird durch die nachfolgenden Beispiele näher erläutert, ohne sie dadurch einschränken zu wollen.

**Beispiele:**

**Bestimmung von Orbitalenergien und elektronischer Zustände**

Die HOMO- und LUMO-Energien sowie das Triplettniveau und die Singulettniveaus der Materialien werden über quantenchemische Rechnungen bestimmt. Hierzu wird vorliegend das Programmpaket "Gaussian09, Revision D.01" (Gaussian Inc.) verwendet. Zur Berechnung organischer Substanzen ohne Metalle (mit Methode "org." bezeichnet) wird zuerst eine Geometrieoptimierung mit der semi-empirischen Methode AM1 (Gaussian-Eingabezeile "# AM1 opt") mit der Ladung (Charge) 0 und der Multiplizität (Multiplicity) 1 durchgeführt. Im Anschluss erfolgt auf Grundlage der optimierten Geometrie eine Energierechnung (single point) für den elektronischen Grundzustand und das Triplett-Niveau. Hierbei wird die TDDFT-Methode (time dependent density functional theory) B3PW91 mit dem Basissatz 6-31G(d) (Gaussian-Eingabezeile "# B3PW91/6-31G(d) td=(50-50,nstates=4)") verwendet (Ladung 0, Multiplizität 1). Für metallorganische Verbindungen (mit Methode "M-org." bezeichnet) wird die Geometrie mit der Methode Hartree-Fock und dem Basissatz LanL2MB (Gaussian-Eingabezeile "# HF/LanL2MB opt") optimiert (Ladung 0, Multiplizität 1). Die Energierechnung erfolgt, wie oben beschrieben, analog zu der der organischen Substanzen, mit dem Unterschied, dass für das Metallatom der Basissatz "LanL2DZ" und für die Liganden der Basissatz "6-31G(d)" verwendet wird (Gaussian-Eingabezeile "#B3PW91/gen pseudo=lanl2 td=(50-50,nstates=4)"). Aus der Energierechnung erhält man das HOMO als das letzte mit zwei Elektronen besetze Orbital (Alpha occ. eigenvalues) und LUMO als das erste unbesetzte Orbital (Alpha virt. eigenvalues) in Hartree-Einheiten, wobei HEh und LEh für die HOMO Energie in Hartree-Einheiten beziehungsweise für die LUMO-Energie in Hartree-Einheiten steht. Daraus wird der anhand von Cyclovoltammetriemessungen kalibrierte HOMO- und LUMO-Wert in Elektronenvolt wie folgt bestimmt:

$$\text{HOMO (eV)} = (\text{HEh}*27.212)*0.8308-1.118$$

$$\text{LUMO (eV)} = (\text{LEh}*27.212)*1.0658-0.5049$$

Diese Werte sind im Sinne dieser Anmeldung als HOMO bzw. als LUMO der Materialien anzusehen.
Das Triplett-Niveau T1 eines Materials ist definiert als die relative Anregungsenergie (in eV) des Triplettzustands mit der niedrigsten Energie, der sich aus der quantenchemischen Energierechnung ergibt.
Das Singulett-Niveau S1 eines Materials ist definiert als die relative Anregungsenergie (in eV) des Singulettzustands mit der zweitniedrigsten Energie, der sich aus der quantenchemischen Energierechnung ergibt. Der energetisch niedrigste Singulettzustand wird als S0 bezeichnet.
Die hierin beschriebene Methode ist unabhängig von dem verwendeten Softwarepaket und liefert immer dieselben Ergebnisse. Beispiele oft benutzter Programme für diesen Zweck sind "Gaussian09" (Gaussian Inc.) und Q-Chem 4.1 (Q-Chem, Inc.). Vorliegend wird zur Berechnung der Energien das Programmpaket "Gaussian09, Revision D.01" verwendet.

**Herstellung der OLEDs**

In den folgenden Beispielen E1 bis E3 (siehe Tabelle 1) wird der Einsatz der erfindungsgemäßen Zusammensetzung in OLEDs vorgestellt.

**Vorbehandlung für die Beispiele E1 bis E3:**

Glasplättchen, die mit strukturiertem ITO (Indium Zinn Oxid) der Dicke 50 nm beschichtet sind, werden vor der Beschichtung zunächst mit einem Sauerstoffplasma, gefolgt von einem Argonplasma, behandelt. Diese mit Plasma behandelten Glasplättchen bilden die Substrate, auf welche die OLEDs aufgebracht werden.

Die OLEDs haben prinzipiell folgenden Schichtaufbau: Substrat / Lochinjektionsschicht (HIL) / Lochtransportschicht (HTL) / Elektronenblockierschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 2 gezeigt. Die Daten der OLEDs sind in Tabelle 3 aufgelistet. Die Beispiele V1 bis V4 sind Vergleichsbeispiele gemäß dem Stand der Technik, die Beispiele E1 bis E3 zeigen Daten von erfindungsgemäßen OLEDs. Die HOMO- und LUMO-Werte der Verbindungen sind in Tabelle 4 zusammengefasst.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie L1:CbzT1:TEG1(45%:45%:10%) bedeutet hierbei, dass das Material L1 in einem Volumenanteil von 45%, CbzT1 in einem Anteil von 45% und TEG1 in einem Anteil von 10% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (SE, gemessen in cd/A) und die externe Quanteneffizienz (EQE, gemessen in %) in Abhängigkeit der Leuchtdichte, berechnet aus Strom-Spannungs-Leuchtdichte-Kennlinien unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 3 bezeichnet die Spannung, die für eine Leuchtdichte von 1000 cd/$m^2$ benötigt wird. SE1000 und EQE1000 bezeichnen die Stromeffizienz bzw. die externe Quanteneffizienz, die bei 1000cd/$m^2$ erreicht werden.

Als Lebensdauer LD wird die Zeit definiert, nach der die Leuchtdichte bei Betrieb mit konstanter Stromdichte $j_0$ von der Startleuchtdichte auf einen gewissen Anteil L1 absinkt. Eine Angabe L1=80% inTabelle 3 bedeutet, dass die in Spalte LD angegebene Lebensdauer der Zeit entspricht, nach der die Leuchtdichte auf 80% ihres Anfangswertes absinkt.

**Verwendung von erfindungsgemäßen Zusammensetzungen in OLEDs**

Die erfindungsgemäßen Materialien können in der Emissionsschicht in phosphoreszierenden grünen OLEDs eingesetzt werden. Die erfindungsgemäßen Verbindungen CbzT4 und L2 werden in den Beispielen E1 bis E3 als Matrixmaterial in der Emissionsschicht eingesetzt. Des Weiteren lassen sich die erfindungsgemäßen Materialien in der Elektronentransportschicht (ETL), Elektroneninjektionsschicht (EIL), Lochblockierschicht (HBL) oder Elektronenblockierschicht (EBL) einsetzen.

Im Folgenden werden die Beispiele näher erläutert, um die Vorteile der erfindungsgemäßen OLEDs zu verdeutlichen.

**Verwendung von erfindungsgemäßen Zusammensetzungen in der Emissionsschicht phosphoreszierender OLEDs**

Durch den Einsatz von Verbindungen gemäß Stand der Technik, also die Kombination aus zwei elektronentransportierenden Hosts (z.B. einem Lactam-Derivat und einem Triazin-Carbazol-Derivat) mit einem lochtransportierenden Emitter lassen sich bei mittleren Emitterkonzentrationen in der EML von 10% gute Spannungen, Effizienzen und Lebensdauern realisieren (V1 bis V3). Die Verwendung von kleineren Emitterkonzentrationen von <10% nach dem Beispiel V3 führt erwartungsgemäß zu deutlich verringerten Lebensdauern, da die Balance aus Elektronen- und Lochstrom nicht mehr gegeben ist. Die Kombination aus einem elektronentransportierenden Host und einem bipolaren Host, wobei beide aus der Klasse der Triazin-Carbazol-Derivate stammen, führt hingegen auch bei geringen Emitterkonzentrationen (7%) zu einer Verbesserung der Lebensdauer (V4).

Eine ausgezeichnete Verbesserung der Lebensdauer bei gleichzeitig geringer Emitterkonzentration (7%) in

der EML erhält man durch die spezielle Kombination aus einem elektronentransportierenden Host aus der Klasse der Lactame und einem bipolaren Host aus der Klasse der Triazin-Carbazol-Derivate (E1 bis E2). Selbst mit sehr geringen Emitterkonzentrationen von 3% lässt sich eine um ca. den Faktor 2 verbesserte Lebensdauer im Vergleich zu dem Stand der Technik (V1 bis V3) erzielen (E3).

Gleichzeitig bleibt die niedrige Betriebsspannung der OLEDs bei E1 bis E3 erhalten. Gegenüber dem Stand der Technik lassen sich außerdem herausragende Effizienzen erzielen.

Nach dem Vorbild der Beispiele E1 bis E3 erhält man durch die Kombination von weiteren bipolaren Triazin-Carbazol-Verbindungen (linke Spalte Tabelle 5) mit elektronenleitenden Lactamen mit (rechte Spalte Tabelle 5) und phosphoreszierenden Emittern OLEDs mit ausgezeichneten Leistungsdaten, was die breite Anwendbarkeit der erfindungsgemäßen Materialkombination demonstriert.

Tabelle 1: Aufbau der OLEDs

| Bsp | HIL/HTL Dicke | HTL/HIL Dicke | EBL Dicke | EML Dicke | HBL Dicke | ETL Dicke | EIL Dicke |
|---|---|---|---|---|---|---|---|
| V1 | SpA1 70nm | HATCN 5nm | SpMA1 90nm | L1:CbzT1:TEG1 (45%:45%:10%) 40nm | --- | ST2:LiQ (50%50%) 30nm | --- |
| V2 | SpA1 70nm | HATCN 5nm | SpMA1 90nm | L1:CbzT3:TEG1 (45%:45%:10%) 40nm | IC1 5nm | ST2:LiQ (50%: 50%) 25nm | --- |
| V3 | SpA1 70nm | HATCN 5nm | SpMA1 90nm | L2:CbzT1:TEG1 (45%:45%:10%) 40nm | --- | ST2 30nm | LiQ 1nm |
| V4 | HATCN 5nm | SpMA1 215nm | SpMA2 20nm | CbzT2:CbzT4: TEG2 (47%:46%:07%) 30nm | ST2 10nm | ST2:LiQ (50%50%) 30nm | LiQ 1nm |
| E1 | HATCN 5nm | SpMA1 215nm | SpMA2 20nm | L2:CbzT4:TEG2 (47%:46%:07%) 30nm | ST2 10nm | ST2:LiQ (50%50%) 30nm | LiQ 1nm |
| E2 | HATCN 5nm | SpMA1 215nm | SpMA2 20nm | L2:CbzT4:TEG3 (47%:46%:07%) 30nm | ST2 10nm | ST2:LiQ (50%50%) 30nm | LiQ 1nm |
| E3 | HATCN 5nm | SpMA1 215nm | SpMA2 20nm | L2:CbzT4:TEG3 (48%:49%:03%) 30nm | ST2 10nm | ST2:LiQ (50%50%) 30nm | LiQ 1nm |

Tabelle 2: Strukturformeln der Materialien für die OLEDs

| | |
|---|---|
| 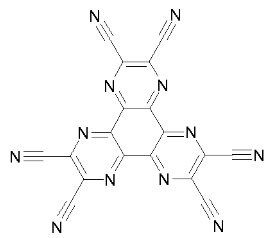 | 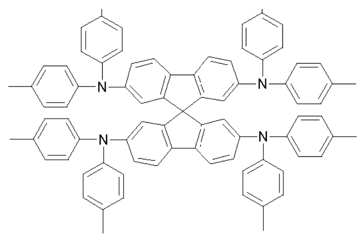 |

(fortgesetzt)

| HATCN | SpA1 |
|---|---|
| 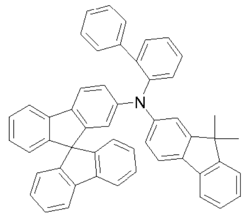 | 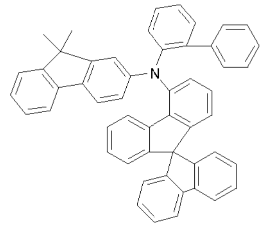 |
| SpMA1 | SpMA2 |
| 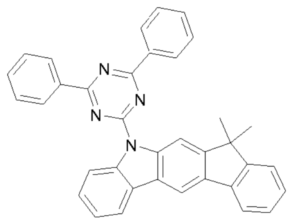 | 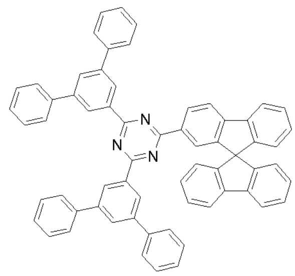 |
| IC1 | ST2 |
| 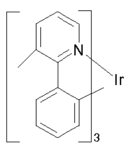 | 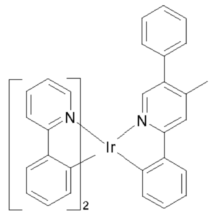 |
| TEG1 | TEG2 |
| 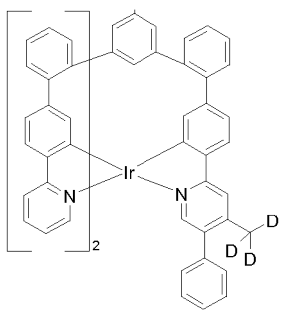 | 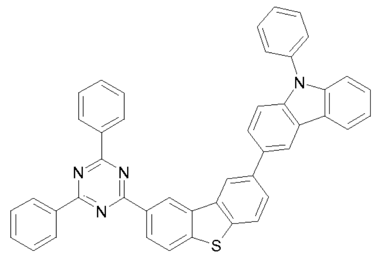 |
| TEG3 | CbzT1 |
| 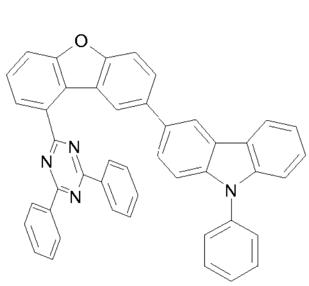 | 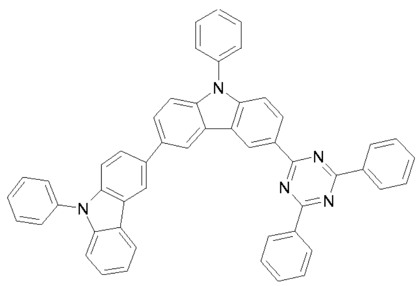 |
| CbzT2 | CbzT3 |

(fortgesetzt)

| | |
|---|---|
| 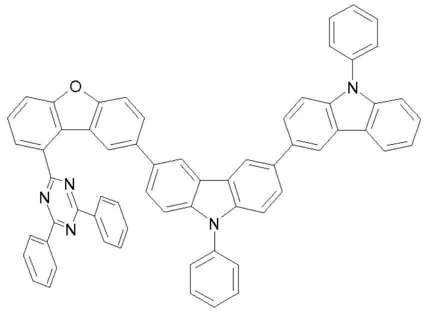 | 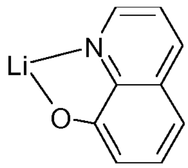 |
| CbzT4 | LiQ |
| 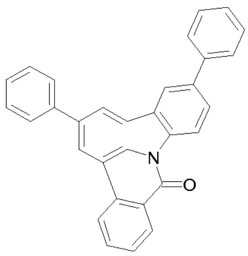 | 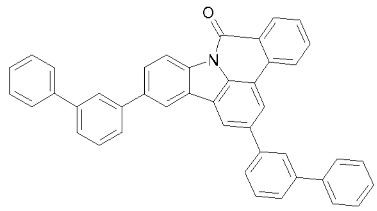 |
| L1 | L2 |

Tabelle 3: Daten der OLEDs

| Bsp. | U1000 (V) | SE1000 (cd/A) | EQE 1000 (%) | CIE x/y bei 1000 cd/m$^2$ | $j_0$ (mA/cm$^2$) | L1 (%) | LD (h) |
|---|---|---|---|---|---|---|---|
| V1 | 2.9 | 62 | 17.2 | 0.33/0.62 | 20 | 80 | 260 |
| V2 | 3.4 | 55 | 15.4 | 0.33/0.63 | 20 | 80 | 215 |
| V3 | 2.6 | 59 | 16.4 | 0.33/0.62 | 20 | 80 | 165 |
| V4 | 3.1 | 66 | 179 | 0.35/0.62 | 20 | 80 | 620 |
| E1 | 3.2 | 70 | 189 | 0.32/0.64 | 20 | 80 | 750 |
| E2 | 3.1 | 72 | 190 | 0.37/0.61 | 20 | 80 | 1110 |
| E3 | 3.1 | 70 | 18.4 | 0.37/0.61 | 20 | 80 | 500 |

Tabelle 4: HOMO- und LUMO-Werte der Verbindungen

| Verbindung | HOMO (eV) | LUMO (eV) |
|---|---|---|
| L1 | -5.97 | -2.49 |
| L2 | -5.97 | -2.50 |
| CbzT1 | -5.60 | -2.55 |
| CbzT2 | -5.53 | -2.64 |
| CbzT3 | -5.43 | -2.37 |
| CbzT4 | -5.31 | -2.59 |

Tabelle 5: Strukturformeln für weitere Materialkombinationen

| Carabzol-Triazine (CbzT) | Lactame (L) |
|---|---|
| 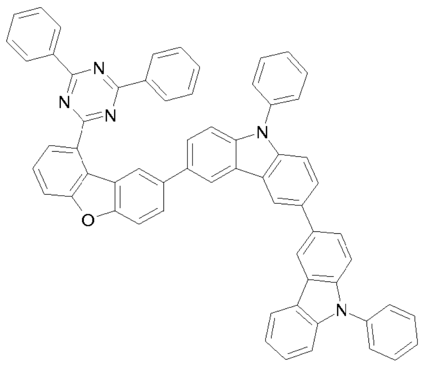 | 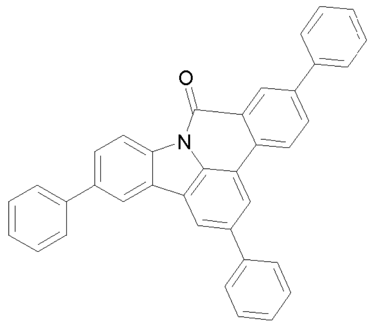 |
| 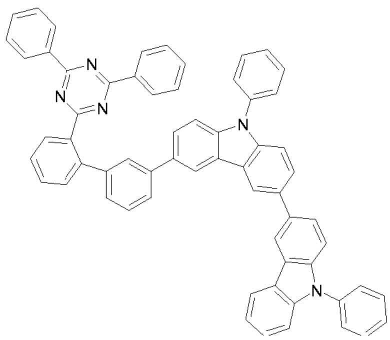 | 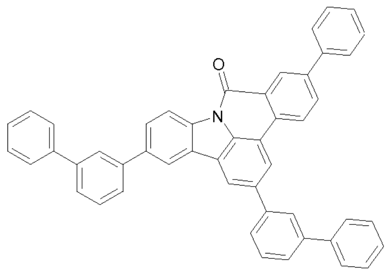 |
| | |
| | 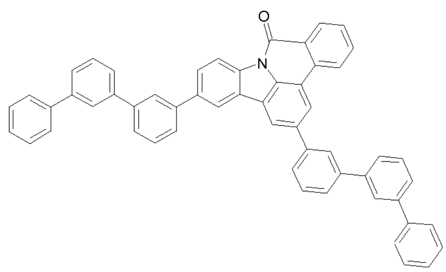 |
| | 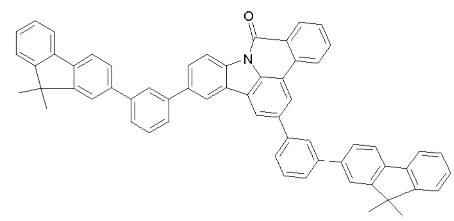 |
| | 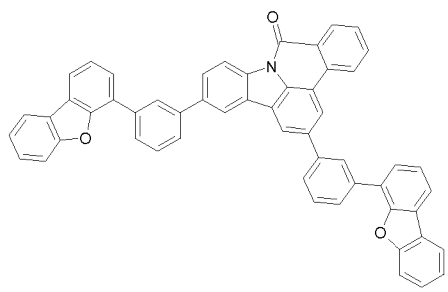 |

(fortgesetzt)

| Carabzol-Triazine (CbzT) | Lactame (L) |
|---|---|
| | 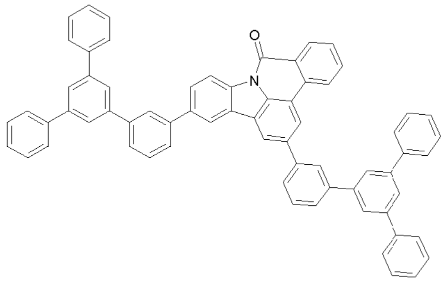 |
| | 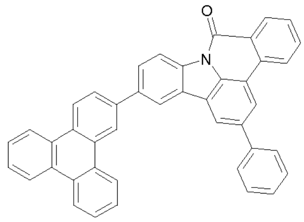 |
| | 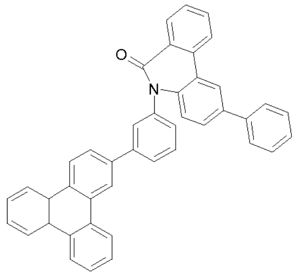 |
| | 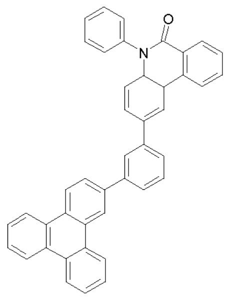 |
| | 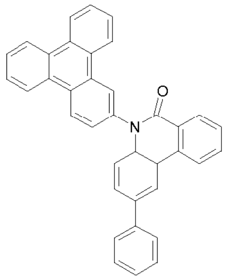 |

(fortgesetzt)

| Carabzol-Triazine (CbzT) | Lactame (L) |
|---|---|
| | 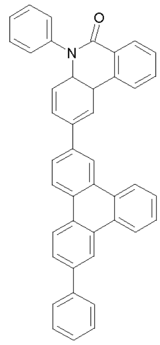 |

## Patentansprüche

1. Zusammensetzung umfassend einen bipolaren Host und einen elektronentransportierenden Host, **dadurch gekennzeichnet, dass** der bipolare Host ausgewählt ist aus den Verbindungen der Formeln (1a-13) bis (1a-18) mit der allgemeinen Formel

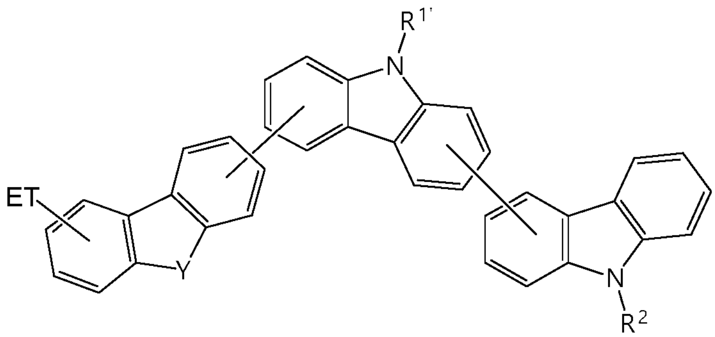

,

wobei gilt:

| Gruppe ET | Bipolarer Host |
|---|---|
| (ET-12) | Formel (1a-13) |
| (ET-13) | Formel (1a-14) |
| (ET-14) | Formel (1a-15) |
| (ET-15) | Formel (1a-16) |
| (ET-16) | Formel (1a-17) |
| (ET-20) | Formel (1a-18); |

den Verbindungen der Formeln (1a-19) bis (1a-24) mit der allgemeinen Formel

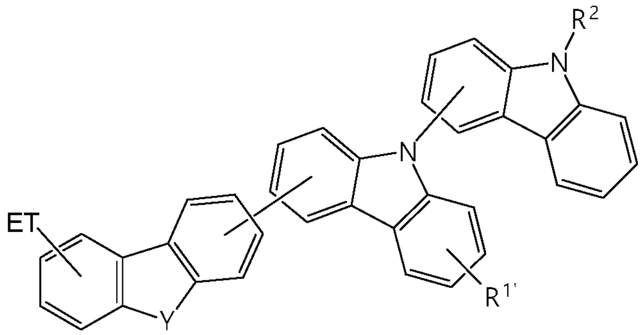

,

wobei gilt:

| Gruppe ET | Bipolarer Host |
|---|---|
| (ET-12) | Formel (1a-19) |
| (ET-13) | Formel (1a-20) |
| (ET-14) | Formel (1a-21) |
| (ET-15) | Formel (1a-22) |
| (ET-16) | Formel (1a-23) |
| (ET-20) | Formel (1a-24); |

den Verbindungen der Formeln (1b-13) bis (1b-18) mit der allgemeinen Formel

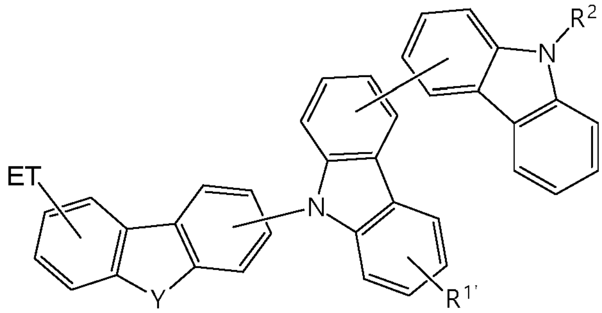

,

wobei gilt:

| Gruppe ET | Bipolarer Host |
|---|---|
| (ET-12) | Formel (1b-13) |
| (ET-13) | Formel (1b-14) |
| (ET-14) | Formel (1b-15) |
| (ET-15) | Formel (1b-16) |
| (ET-16) | Formel (1b-17) |
| (ET-20) | Formel (1b-18); und |

den Verbindungen der Formeln (1b-19) bis (1b-24) mit der allgemeinen Formel

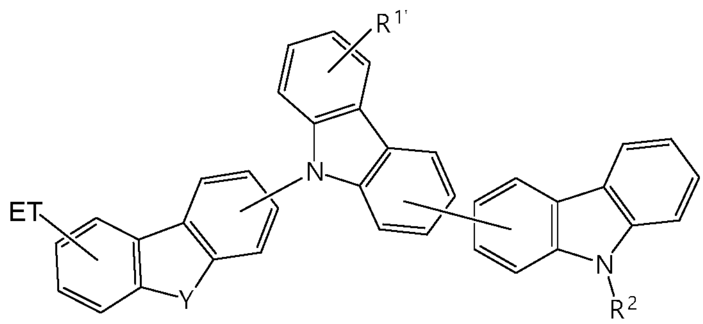

,

wobei gilt:

| Gruppe ET | Bipolarer Host |
|---|---|
| (ET-12) | Formel (1b-19) |
| (ET-13) | Formel (1b-20) |
| (ET-14) | Formel (1b-21) |
| (ET-15) | Formel (1b-22) |
| (ET-16) | Formel (1b-23) |
| (ET-20) | Formel (1b-24); |

Y ist O oder S;
und wobei für die Gruppen (ET-12), (ET-13), (ET-14), (ET-15), (ET-16) und (ET-20) gilt

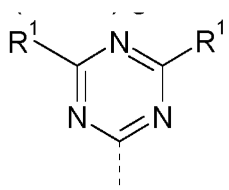

Formel (ET-12)

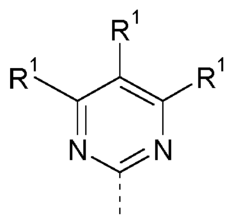

Formel (ET-13)

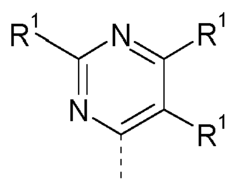

Formel (ET-14)

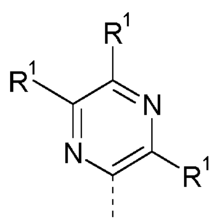

Formel (ET-15)

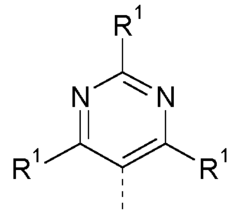

Formel (ET-16)

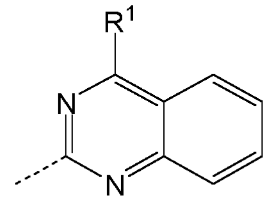

Formel (ET-20)

$R^1$, $R^{1'}$, $R^{1''}$ ist gleich oder verschieden bei jedem Auftreten H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy-, Alkylalkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy-, Arylalkoxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination aus zwei oder mehr dieser Gruppen; dabei können zwei oder mehrere benachbarte Reste $R^1$, $R^{1'}$ oder $R^{1''}$ miteinander ein mono- oder polycyclisches, aliphatisches oder aromatisches Ringsystem bilden, wobei bevorzugt ist, wenn zwei oder mehr benachbarte Reste $R^1$, $R^{1'}$ oder $R^{1''}$ miteinander kein mono- oder polycyclisches, aliphatisches oder aromatisches Ringsystem bilden;

$R^2$ ist gleich oder verschieden bei jedem Auftreten H, D, F, Cl, Br, I, $N(R^3)_2$, CN, $NO_2$, $Si(R^3)_3$, $B(OR^3)_2$, $C(=O)R^3$, $P(=O)(R^3)_2$, $S(=O)R^3$, $S(=O)_2R^3$, $OSO_2R^3$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy-, Alkylalkoxy- oder Thioalkoxygruppe mit 3 bis 40 C-Atomen, die jeweils mit einem oder mehreren Resten $R^3$ substituiert sein kann, wobei eine oder mehrere nicht benachbarte $CH_2$-Gruppen durch $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S oder $CONR^3$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^3$ substituiert sein kann, oder eine Aryloxy-, Arylalkoxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination aus zwei oder mehr dieser Gruppen; dabei können zwei oder mehrere benachbarte Reste $R^2$ miteinander ein mono- oder polycyclisches, aliphatisches oder aromatisches Ringsystem bilden;

$R^3$ ist gleich oder verschieden bei jedem Auftreten H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten $R^3$ auch miteinander ein mono- oder polycyclisches, aliphatisches oder aromatisches Ringsystem bilden;

$R^4$ ist gleich oder verschieden bei jedem Auftreten $N(R^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy-, Alkylalkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy-, Arylalkoxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein

kann, oder eine Kombination aus zwei oder mehr dieser Gruppen; dabei können zwei oder mehrere benachbarte Reste $R^4$ miteinander ein mono- oder polycyclisches, aliphatisches oder aromatisches Ringsystem bilden.

**2.** Zusammensetzung nach Anspruch 1, **dadurch gekennzeichnet, dass** der bipolare Host ausgewählt ist aus den Verbindungen der folgenden Formeln

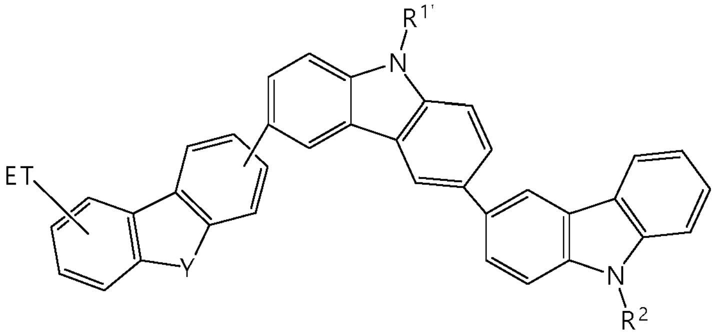

,

wobei gilt

| Gruppe ET | Bipolarer Host |
|---|---|
| (ET-12) | Formel (1a-25) |
| (ET-13) | Formel (1a-26) |
| (ET-14) | Formel (1a-27) |
| (ET-15) | Formel (1a-28) |
| (ET-16) | Formel (1a-29) |
| (ET-20) | Formel (1a-30); |

den nachfolgenden Verbindungen der Formeln (1a-31) bis (1a-36) mit der allemeinen Formel

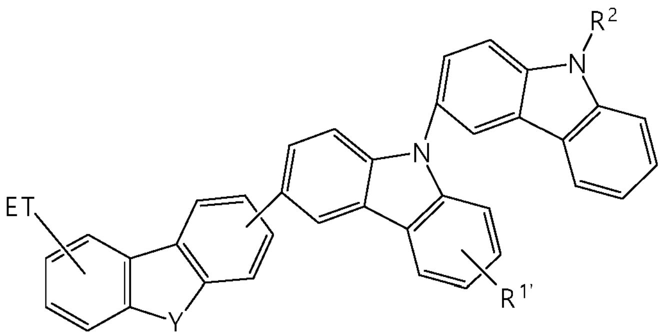

wobei gilt:

| Gruppe ET | Bipolarer Host |
|---|---|
| (ET-12) | Formel (1a-31) |
| (ET-13) | Formel (1a-32) |
| (ET-14) | Formel (1a-33) |
| (ET-15) | Formel (1a-34) |
| (ET-16) | Formel (1a-35) |
| (ET-20) | Formel (1a-36); |

den nachfolgenden Verbindungen der Formeln (1b-25) bis (1b-30) mit der allgemeinen Formel

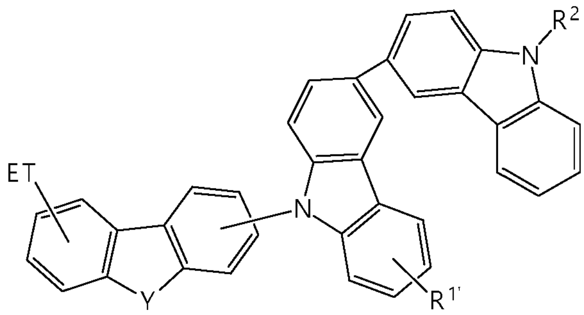

wobei gilt:

| Gruppe ET | Bipolarer Host |
|---|---|
| (ET-12) | Formel (1b-25) |
| (ET-13) | Formel (1b-26) |
| (ET-14) | Formel (1b-27) |
| (ET-15) | Formel (1b-28) |
| (ET-16) | Formel (1b-29) |
| (ET-20) | Formel (1b-30); und |

den nachfolgenden Verbindungen der Formeln (1b-31) bis (1b-36) mit der allgemeinen Formel

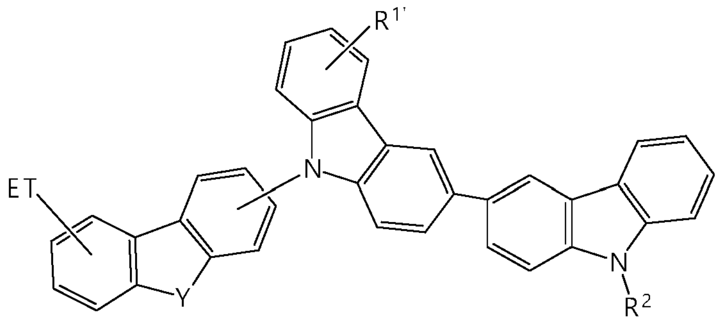

wobei gilt:

| Gruppe ET | Bipolarer Host |
|---|---|
| (ET-12) | Formel (1b-31) |
| (ET-13) | Formel (1b-32) |
| (ET-14) | Formel (1b-33) |
| (ET-15) | Formel (1b-34) |
| (ET-16) | Formel (1b-35) |
| (ET-20) | Formel (1b-36); |

und wobei die verwendeten Symbole die oben genannten Bedeutungen haben.

**3.** Zusammensetzung nach Anspruch 1 oder 2, **dadurch gekennzeichnet, dass** der bipolare Host ausgewählt ist aus den Verbindungen der Formeln (1a-37), (1a-38), (1b-37) und (1b-38)

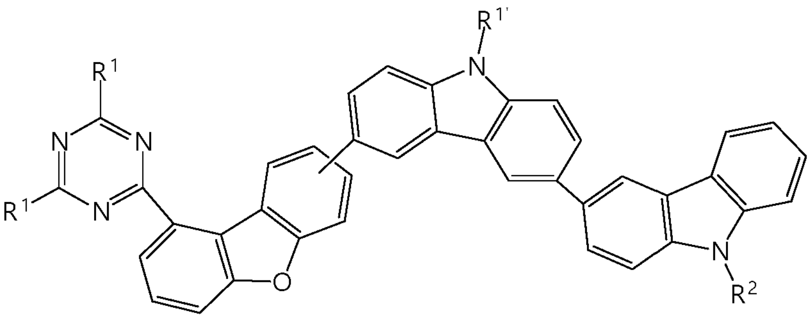

Formel (1a-37)

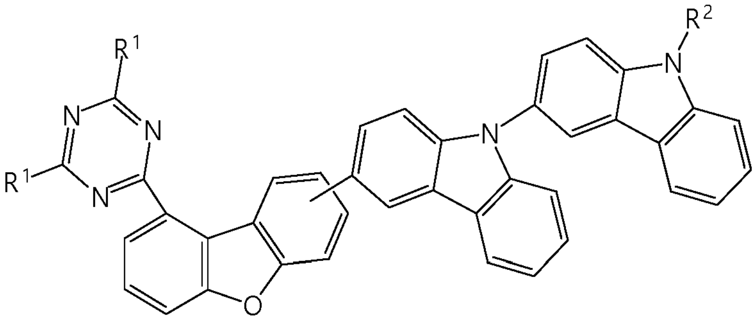

Formel (1a-38)

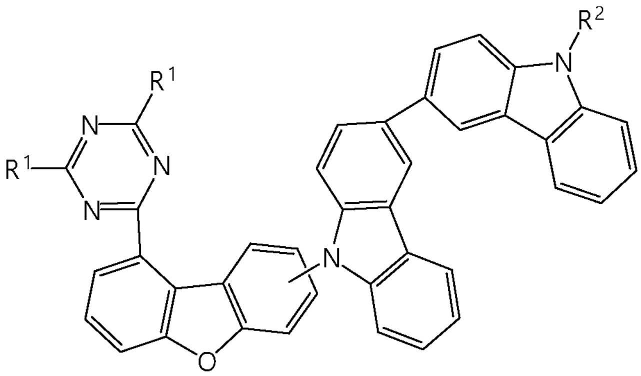

Formel (1b-37)

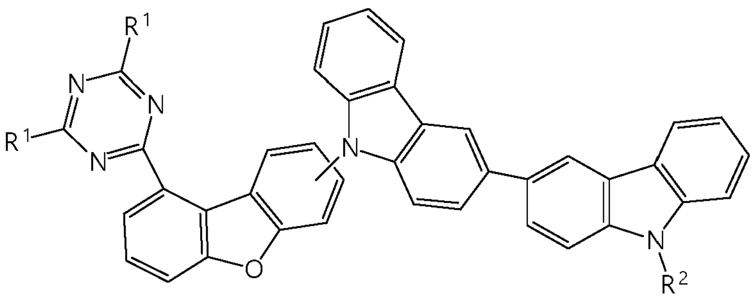

Formel (1b-38),

wobei $R^1$ und $R^2$ die oben genannte Bedeutung aufweisen.

**4.** Zusammensetzung nach einem oder mehreren der Ansprüche 1 bis 3, **dadurch gekennzeichnet, dass** $R^1$ ausgewählt ist aus der Gruppe bestehend aus H oder einem aromatischen oder heteroaromatischen Ringsystem mit 5

bis 60 aromatischen Ringatomen, das jeweils durch einen oder mehrere Reste $R^2$ substituiert sein kann, wobei bevorzugt ist, dass $R^1$ keine elektronenreiche aromatische oder heteroaromatische Ringe oder Ringsysteme enthält, wobei $R^2$ die oben genannte Bedeutung aufweist.

5. Zusammensetzung nach einem oder mehreren der Ansprüche 1 bis 4, **dadurch gekennzeichnet, dass** der Substituent $R^2$ ausgewählt ist aus der Gruppe bestehend aus H oder einem aromatischen oder heteroaromatischen Ring oder Ringsystem mit 5 bis 30 Ringatomen, wobei der Ring oder das Ringsystem jeweils durch einen oder mehrere Reste $R^3$ substituiert sein kann, bevorzugt aber unsubstituiert ist, wobei $R^3$ die oben genannte Bedeutung aufweist.

6. Zusammensetzung nach einem oder mehreren der Ansprüche 1 bis 5, **dadurch gekennzeichnet, dass** $R^2$ eine Phenyl-, Biphenyl-, Terphenyl- und Quarterphenylgruppe darstellt.

7. Zusammensetzung nach einem oder mehreren der Ansprüche 1 bis 6, **dadurch gekennzeichnet, dass** der bipolare Hoste eine Verbindung der Formeln (1a-37), (1a-38), (1b-37) und (1b-38) darstellt, wobei die carbazolhaltige HT-Gruppe an Position 8 des Dibenzofurans bindet.

8. Zusammensetzung nach einem oder mehreren der Ansprüche 1 bis 7 **dadurch gekennzeichnet, dass** der elektronentransportierende Host ein Lactam ist.

9. Zusammensetzung nach einem oder mehreren der Ansprüche 1 bis 8, **dadurch gekennzeichnet, dass** der elektronentransportierende Host eine Verbindung der allgemeinen Formel (2) oder (2a) ist,

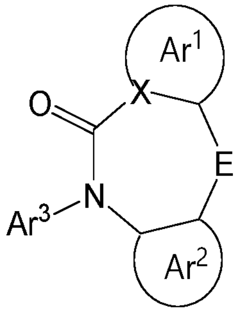

Formel (2)

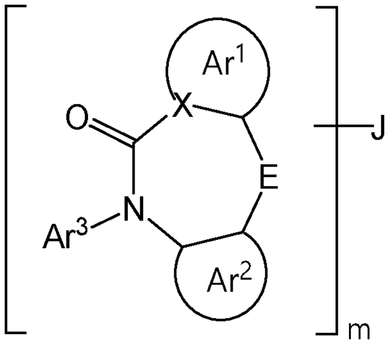

Formel (2a)

wobei für die verwendeten Symbole und Indizes gilt:

E ist eine Einfachbindung oder $NAr^4$;
X ist C, wenn $Ar^1$ eine 6-Ring-Aryl- oder 6-Ring-Heteroarylgruppe darstellt, bzw. ist C oder N, wenn $Ar^1$ eine 5-Ring-Heteroarylgruppe darstellt;
$Ar^1$ ist zusammen mit der Gruppe X und dem explizit dargestellten Kohlenstoffatom ein aromatisches oder heteroaromatisches Ringsystem mit 5 bis 30 aromatischen Ringatomen, welches durch einen oder mehrere Reste R substituiert sein kann;
$Ar^2$ ist zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann; dabei kann $Ar^2$ auch mit $Ar^3$ durch eine Einfachbindung verknüpft sein;
$Ar^3$ ist ausgewählt aus der Gruppe bestehend aus H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^6$ substituiert sein kann, wobei eine oder mehrere nicht-benachbarte $CH_2$-Gruppen durch $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 30 aromatischen Ringatomen, das jeweils mit einem oder mehreren Resten $R^6$ substituiert sein kann, einer Aryloxy- oder Heteroaryloxygruppe mit 5 bis 30 aromatischen Ringatomen, die mit einem oder mehreren Resten $R^6$ substituiert sein kann, oder einer Kombination dieser Systeme;

dabei kann $Ar^3$ auch mit $Ar^2$ durch eine Einfachbindung verknüpft sein;

$Ar^4$ ist ein aromatisches oder heteroaromatisches Ringsystem mit 5 bis 30 aromatischen Ringatomen, welches durch einen oder mehrere Reste R substituiert sein kann; dabei kann $Ar^4$ auch mit $Ar^2$ oder $Ar^1$ durch eine Einfachbindung verknüpft sein;

m 1, 3 oder 4;

J ist für m = 2 eine Einfachbindung oder eine bivalente Gruppe, bzw. für m = 3 eine trivalente Gruppe bzw. für m = 4 eine tetravalente Gruppe, welche jeweils an eine beliebige Position an $Ar^1$, $Ar^2$, $Ar^3$ oder $Ar^4$ gebunden ist;

R ist bei jedem Auftreten gleich oder verschieden ausgewählt aus der Gruppe bestehend aus H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^6$ substituiert sein kann, wobei eine oder mehrere nicht-benachbarte $CH_2$-Gruppen durch $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S oder $CONR^6$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^6$ substituiert sein kann, einer Aryloxy- oder Heteroaryloxygruppe mit 5 bis 60 aromatischen Ringatomen, die mit einem oder mehreren Resten $R^6$ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^6$ substituiert sein kann;

$R^6$ ist bei jedem Auftreten gleich oder verschieden ausgewählt aus der Gruppe bestehend aus H, D, F, Cl, Br, I, CN, $NO_2$, $N(Ar^5)_2$, $N(R^7)_2$, $C(=O)Ar^5$, $C(=O)R^7$, $P(=O)(Ar^5)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^7$ substituiert sein kann, wobei eine oder mehrere nicht-benachbarte $CH_2$-Gruppen durch $R^7C=CR^7$, C=C, $Si(R^7)_2$, $Ge(R^7)_2$, $Sn(R^7)_2$, C=O, C=S, C=Se, $C=NR^7$, $P(=O)(R^7)$, SO, $SO_2$, $NR^7$, O, S oder $CONR^7$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^7$ substituiert sein kann, einer Aryloxy- oder Heteroaryloxygruppe mit 5 bis 60 aromatischen Ringatomen, die mit einem oder mehreren Resten $R^7$ substituiert sein kann, oder einer Kombination dieser Systeme, wobei optional zwei oder mehr benachbarte Substituenten $R^6$ ein monocyclisches oder polycyclisches, aliphatisches, aromatisches oder heteroaromatisches Ringsystem bilden können, das mit einem oder mehreren Resten $R^7$ substituiert sein kann;

$Ar^5$ ist bei jedem Auftreten gleich oder verschieden ein aromatisches oder heteroaromatisches Ringsystem mit 5 bis 30 aromatischen Ringatomen, das mit einem oder mehreren nicht-aromatischen Resten $R^7$ substituiert sein kann; dabei können zwei Reste $Ar^5$, welche an dasselbe N-Atom oder P-Atom binden, auch durch eine Einfachbindung oder eine Brücke, ausgewählt aus $N(R^7)$, $C(R^7)_2$ oder O, miteinander verbrückt sein;

$R^7$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^7$ miteinander ein mono- oder polycyclisches, aliphatisches, aromatisches oder heteroaromatisches Ringsystem bilden können.

**10.** Zusammensetzung nach Anspruch 9, **dadurch gekennzeichnet, dass** in Verbindungen der Formel (2) bzw. (2a) die Gruppe $Ar^1$ für eine Gruppe der Formel (3), (4), (5), (6) oder (7) steht,

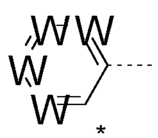
Formel (3)

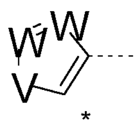
Formel (4)

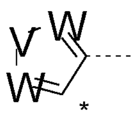
Formel (5)

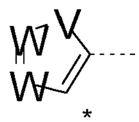
Formel (6)

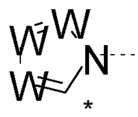
Formel (7)

wobei die gestrichelte Bindung die Verknüpfung mit der Carbonylgruppe andeutet, * die Position der Verknüpfung mit E andeutet und weiterhin gilt:

W ist gleich oder verschieden bei jedem Auftreten CR oder N; oder zwei benachbarte Gruppen W stehen für

eine Gruppe der folgenden Formel (8) oder (9),

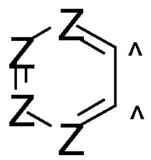

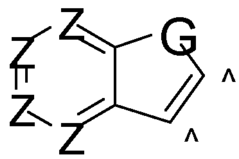

Formel (8) Formel (9)

wobei G für $CR_2$, NR, O oder S steht, Z gleich oder verschieden bei jedem Auftreten für CR oder N steht und ^ die entsprechenden benachbarten Gruppen W in der Formel (3) bis (7) andeuten;
V ist NR, O oder S;
und dass die Gruppe $Ar^2$ für eine Gruppe gemäß einer der Formeln (10), (11) oder (12) steht,

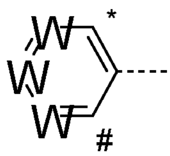

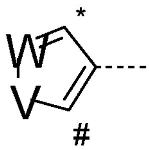

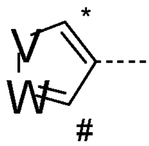

Formel (10) Formel (11) Formel (12)

wobei die gestrichelte Bindung die Verknüpfung mit N andeutet, # die Position einer möglichen Verknüpfung mit $Ar^3$ andeutet, * die Verknüpfung mit E andeutet und W und V die oben genannten Bedeutungen aufweisen;
und dass die Gruppe $Ar^3$ für eine Gruppe gemäß einer der Formeln (13), (14), (15) oder (16) steht,

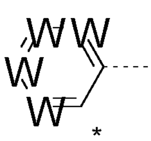

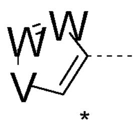

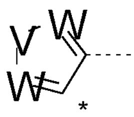

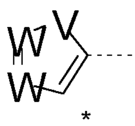

Formel (13) Formel (14) Formel (15) Formel (16)

wobei die gestrichelte Bindung die Verknüpfung mit N andeutet, * eine mögliche Verknüpfung mit $Ar^2$ andeutet und W und V die in Anspruch 13 genannten Bedeutungen aufweisen.

11. Zusammensetzung nach Anspruch 9 oder 10, **dadurch gekennzeichnet, dass** die Verbindung der Formel (2) ausgewählt ist aus den Verbindungen der Formeln (17) bis (32)

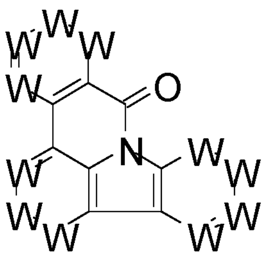

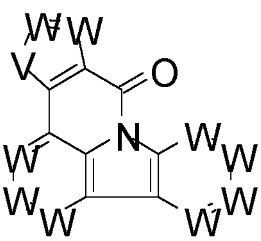

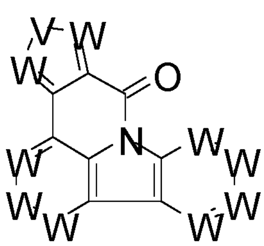

Formel (17) Formel (18) Formel (18-I)

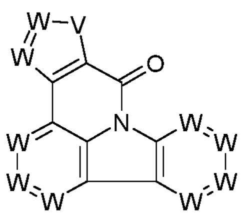

Formel (19)

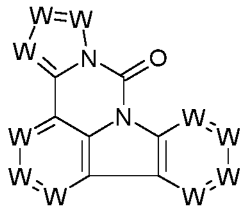

Formel (20)

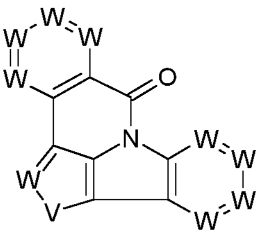

Formel (21)

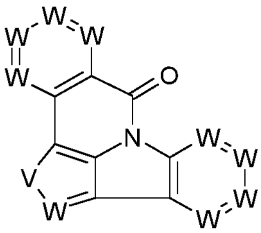

Formel (22)

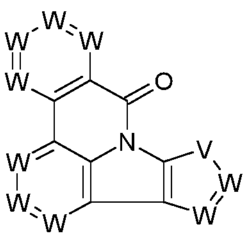

Formel (23)

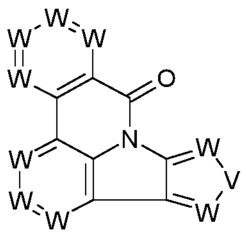

Formel (24)

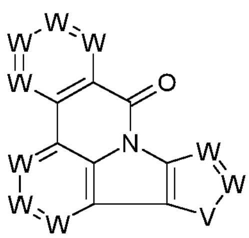

Formel (25)

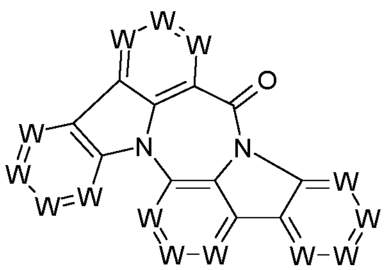

Formel (26)

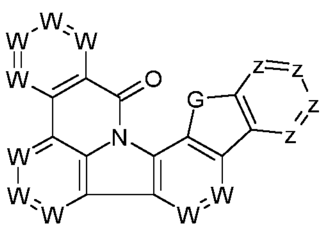

Formel (27)

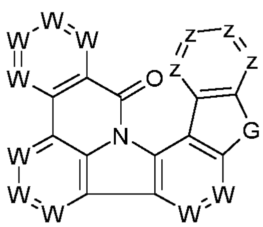

Formel (28)

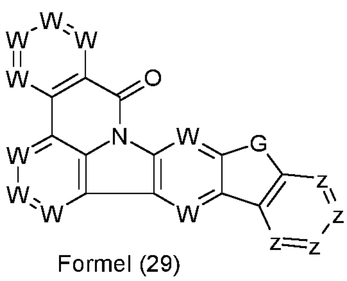

Formel (29)

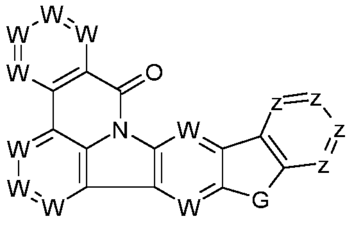

Formel (30)

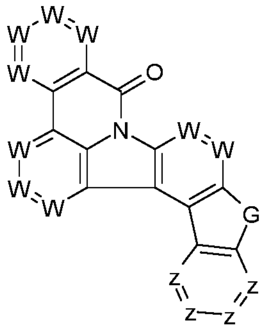

Formel (31)

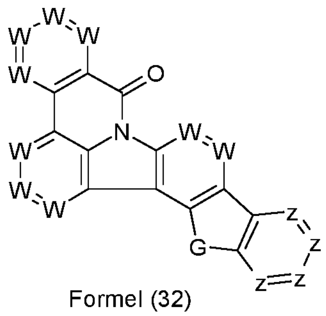

Formel (32)

wobei die verwendeten Symbole die oben genannten Bedeutungen aufweisen.

**12.** Zusammensetzung nach einem oder mehreren der Ansprüche 9 bis 11, **dadurch gekennzeichnet, dass** die Verbindung der Formel (2) ausgewählt ist aus den Verbindungen gemäß den Formeln (17a) bis (32a),

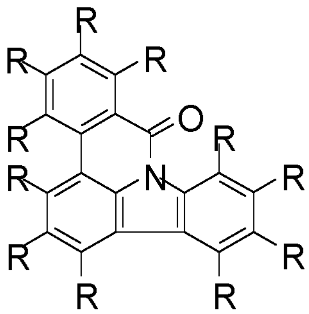

Formel (17a)

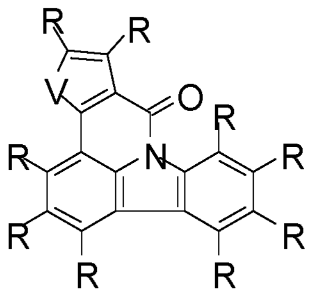

Formel (18a)

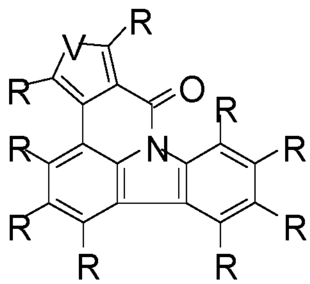

Formel (18-Ia)

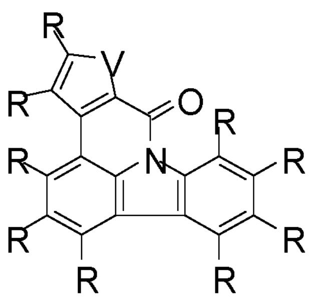

Formel (19a)

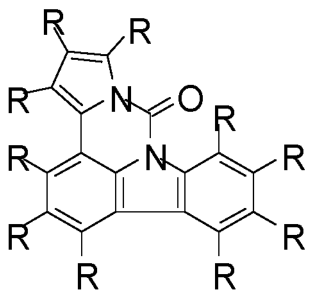

Formel (20a)

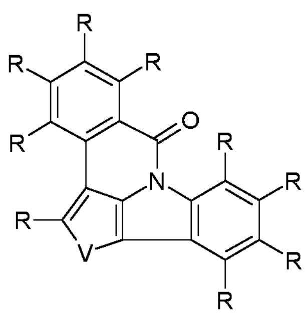

Formel (21a)

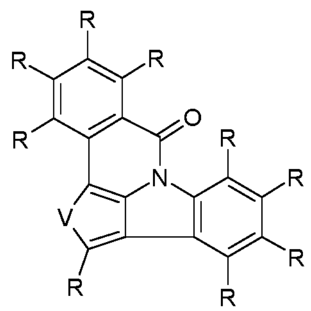

Formel (22a)

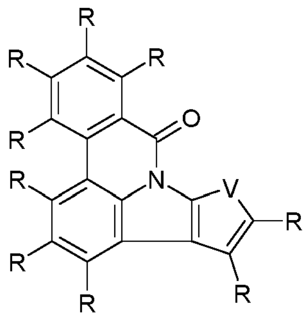

Formel (23a)

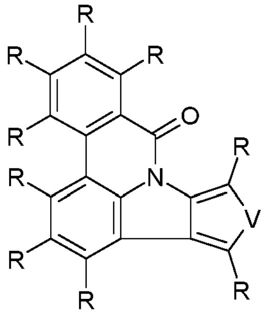

Formel (24a)

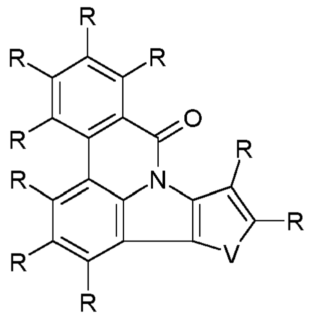

Formel (25a)

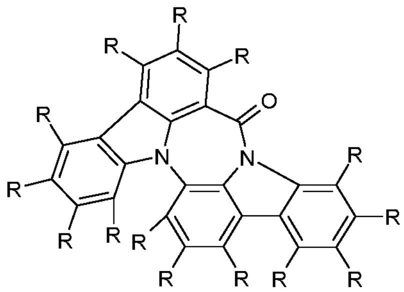

Formel (26a)

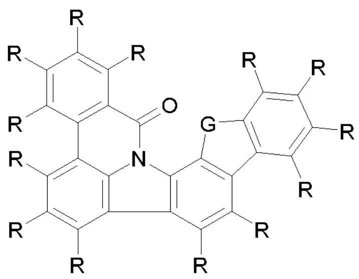

Formel (27a)

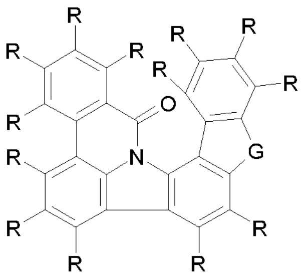

Formel (28a)

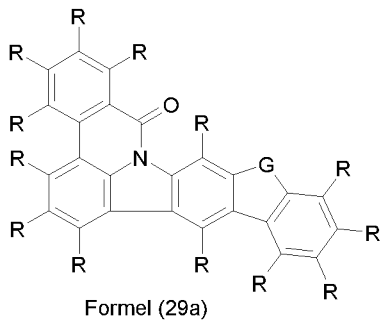

Formel (29a)

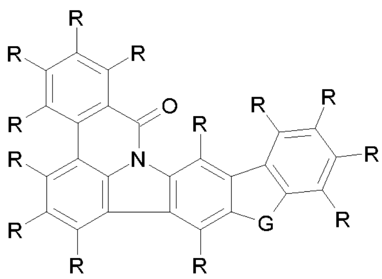

Formel (30a)

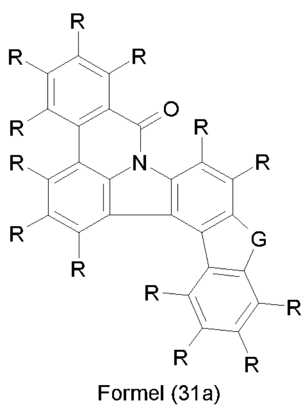

Formel (31a)

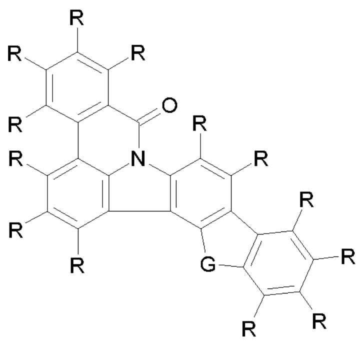

Formel (32a)

wobei die verwendeten Symbole oben genannten Bedeutungen aufweisen.

**13.** Zusammensetzung nach einem oder mehreren der Ansprüche 9 bis 12, **dadurch gekennzeichnet, dass** die Verbindung der Formel (2) ausgewählt ist aus den Verbindungen gemäß den Formeln (17b) bis (32b),

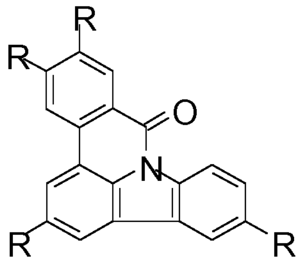

Formel (17b)

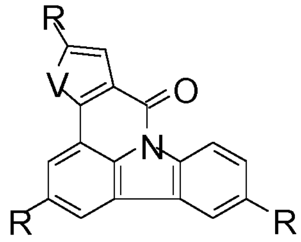

Formel (18b)

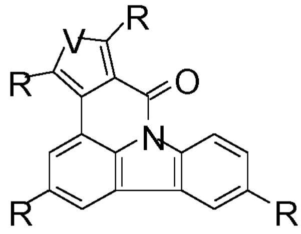

Formel (18-Ib)

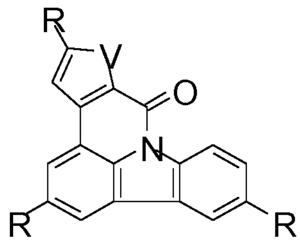

Formel (19b)

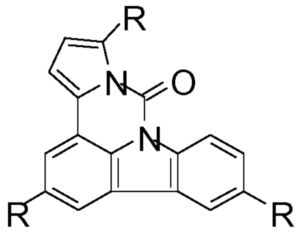

Formel (20b)

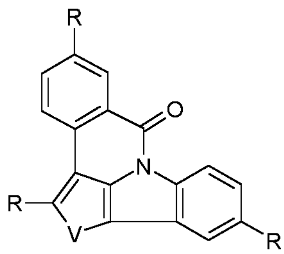

Formel (21b)

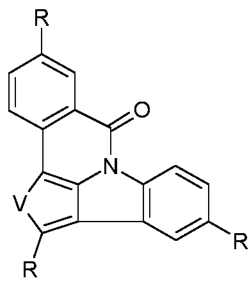

Formel (22b)

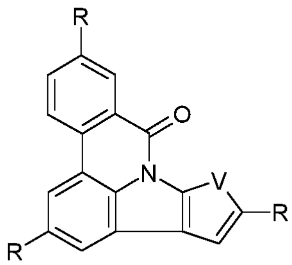

Formel (23b)

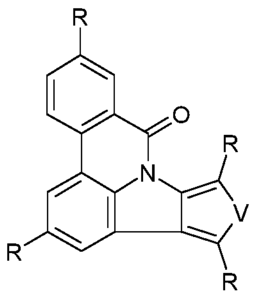

Formel (24b)

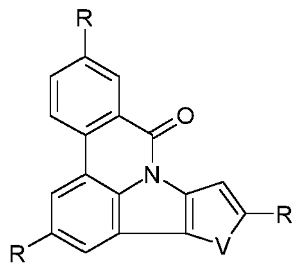

Formel (25b)

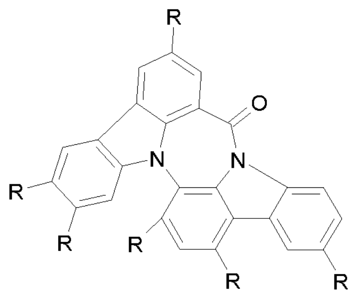

Formel (26b)

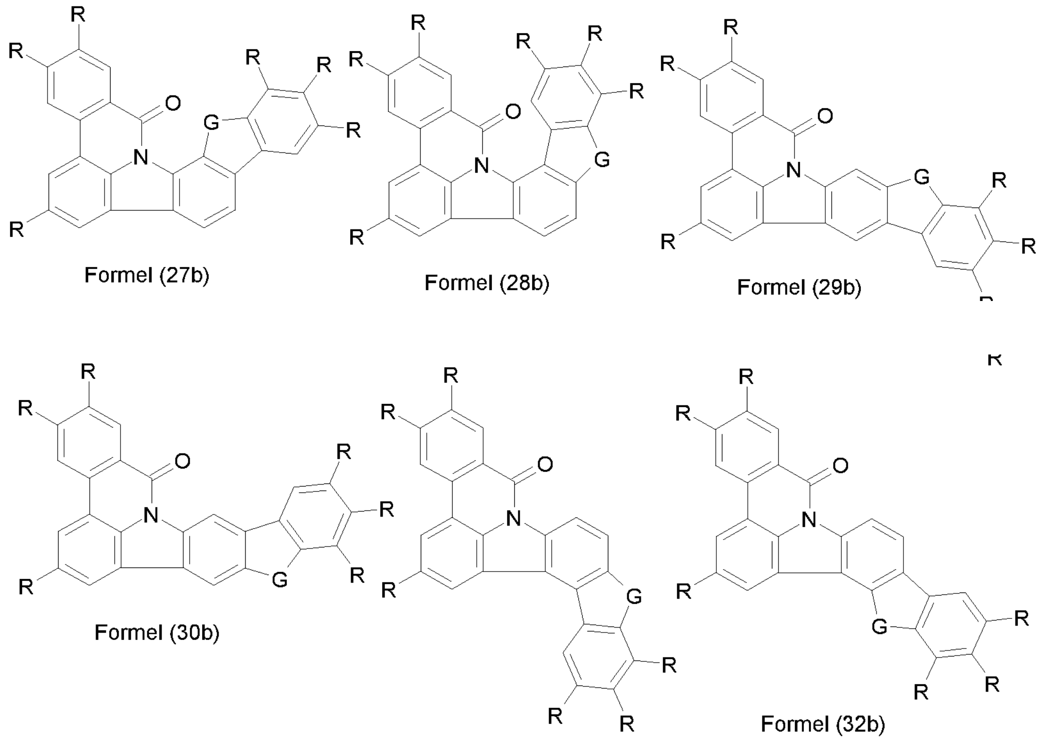

Formel (27b) Formel (28b) Formel (29b)

Formel (30b) Formel (31b) Formel (32b)

wobei die verwendeten Symbole die oben genannten Bedeutungen aufweisen.

**14.** Zusammensetzung nach einem oder mehreren der Ansprüche 1 bis 13, **dadurch gekennzeichnet, dass** die Zusammensetzung mindestens eine weitere Verbindung enthält, die ausgewählt ist aus der Gruppe bestehend aus Lochinjektionsmaterialien, Lochtransportmaterialien, Lochblockiermaterialien, wide-band-gap-Materialien, fluoreszierenden Emittern, phosphoreszierenden Emittern, Hostmaterialien, Matrix-materialien, Elektronenblockiermaterialien, Elektronentransport-materialien und Elektroneninjektionsmaterialien, n-Dotanden und p-Dotanden.

**15.** Formulierung enthaltend eine Zusammensetzung gemäß einem oder mehreren der Ansprüche 1 bis 14 sowie mindestens ein Lösungsmittel.

**16.** Verwendung einer Zusammensetzung gemäß einem oder mehreren der Ansprüche 1 bis 15 in einer organischen elektronischen Vorrichtung, die bevorzugt ausgewählt ist aus den organischen integrierten Schaltungen (OICs), organischen Feld-Effekt-Transistoren (OFETs), organischen Dünnfilmtransistoren (OTFTs), organischen Elektrolumineszenzvorrichtungen, organischen Solarzellen (OSCs), organischen optischen Detektoren und organischen Photorezeptoren, wobei die organischen Elektrolumineszenzvorrichtungen besonders bevorzugt sind, und lichtemittierende elektrochemische Zellen (OLECs) und organische lichtemittierende Dioden (OLEDs) ganz besonders bevorzugt sind.

**17.** Organische elektronische Vorrichtung enthaltend mindestens eine Zusammensetzung gemäß einem oder mehreren der Ansprüche 1 bis 14, bevorzugt in einer Emissionsschicht (EML), in einer Elektronentransportschicht (ETL), in einer Elektroneninjektionsschicht (EIL) und/oder in einer Lochblockierschicht (HBL), ganz bevorzugt in einer EML, EIL und/oder ETL und ganz besonders bevorzugt in einer EML.

**18.** Organische elektronische Vorrichtung nach Anspruch 17, **dadurch gekennzeichnet, dass** sie ausgewählt ist aus den organischen integrierten Schaltungen (OICs), organischen Feld-Effekt-Transistoren (OFETs), organischen Dünnfilmtransistoren (OTFTs), organischen Elektrolumineszenzvorrichtungen, organischen Solarzellen (OSCs), organischen optischen Detektoren und organischen Photorezeptoren, wobei die organischen Elektrolumineszenzvorrichtungen besonders bevorzugt sind.

**19.** Organische elektronische Vorrichtung nach Anspruch 17 oder 18, **dadurch gekennzeichnet, dass** es sich um eine organische Elektrolumineszenzvorrichtung handelt, die ausgewählt ist aus den organischen lichtemittierenden Transistoren (OLETs), organischen Feld-Quench-Devices (OFQDs), organischen lichtemittierenden elektrochemischen Zellen (OLECs, LECs, LEECs), organischen Laserdioden (O-Laser) und den organischen lichtemittierenden Dioden (OLEDs), bevorzugt aus den OLECs und OLEDs und besonders bevorzugt aus den OLEDs.

**20.** Organische elektronische Vorrichtung nach einem oder mehreren der Ansprüche 17 bis 19, **dadurch gekennzeichnet, dass** es sich um eine organische Elektrolumineszenzvorrichtung handelt, die die Zusammensetzung nach einem oder mehreren der Ansprüche 1 bis 14 in der Emissionsschicht zusammen mit einem phosphoreszierenden Emitter enthält.

**21.** Verfahren zur Herstellung einer organischen elektronischen Vorrichtung nach einem oder mehreren der Ansprüche 17 bis 20, **dadurch gekennzeichnet, dass** mindestens eine organische Schicht enthaltend eine Zusammensetzung nach einem oder mehreren der Ansprüche 1 bis 14 durch Gasphasenabscheidung oder aus Lösung aufgebracht wird.

**22.** Verfahren nach Anspruch 21, **dadurch gekennzeichnet, dass** die mindestens eine organische Schicht mittels Gasphasenabscheidung aufgebracht wird, indem die Zusammensetzung vorgemischt und aus einer einzigen Materialquelle verdampft wird.

## Claims

**1.** Composition comprising a bipolar host and an electron-transporting host, **characterised in that** the bipolar host is selected from the compounds of the formulae (1a-13) to (1a-18) having the general formula

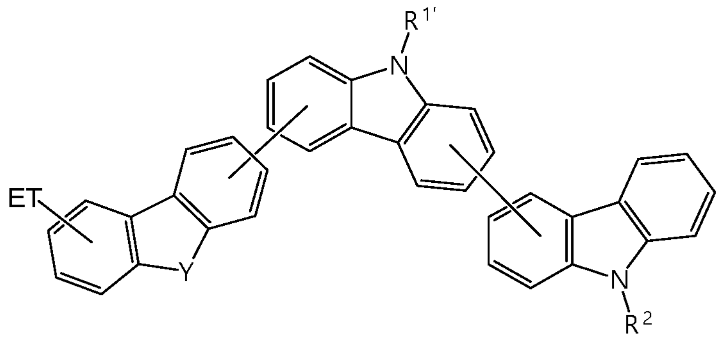

,

where the following applies:

| ET group | Bipolar host |
|---|---|
| (ET-12) | formula (1a-13) |
| (ET-13) | formula (1a-14) |
| (ET-14) | formula (1a-15) |
| (ET-15) | formula (1a-16) |
| (ET-16) | formula (1a-17) |
| (ET-20) | formula (1a-18); |

the compounds of the formulae (1a-19) to (1a-24) having the general formula

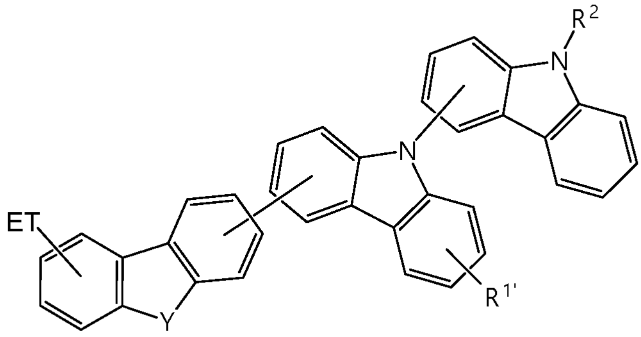

,

where the following applies:

| ET group | Bipolar host |
|---|---|
| (ET-12) | formula (1a-19) |
| (ET-13) | formula (1a-20) |
| (ET-14) | formula (1a-21) |
| (ET-15) | formula (1a-22) |
| (ET-16) | formula (1a-23) |
| (ET-20) | formula (1a-24); |

the compounds of the formulae (1b-13) to (1b-18) having the general formula

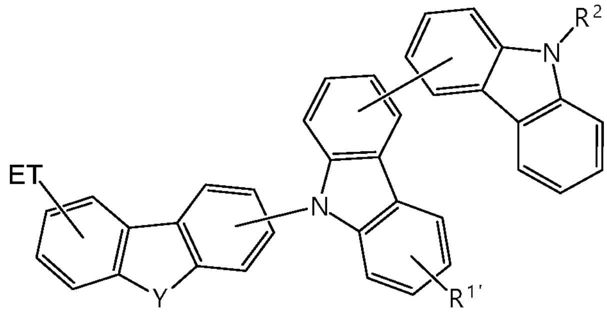

,

where the following applies:

| ET group | Bipolar host |
|---|---|
| (ET-12) | formula (1b-13) |
| (ET-13) | formula (1b-14) |
| (ET-14) | formula (1b-15) |
| (ET-15) | formula (1b-16) |
| (ET-16) | formula (1b-17) |
| (ET-20) | formula (1b-18); and |

the compounds of the formulae (1b-19) to (1b-24) having the general formula

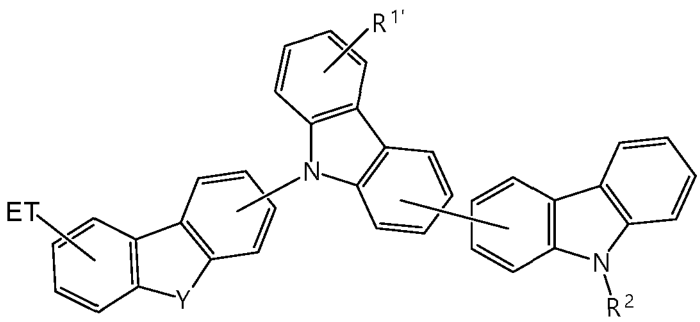

,

where the following applies:

| ET group | Bipolar host |
|---|---|
| (ET-12) | formula (1b-19) |
| (ET-13) | formula (1b-20) |
| (ET-14) | formula (1b-21) |
| (ET-15) | formula (1b-22) |
| (ET-16) | formula (1b-23) |
| (ET-20) | formula (1b-24); |

Y is O or S;
and where the following applies for the groups (ET-12), (ET-13), (ET-14), (ET-15), (ET-16) and (ET-20):

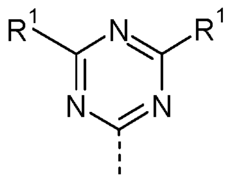

formula (ET-12)

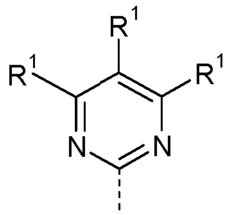

formula (ET-13)

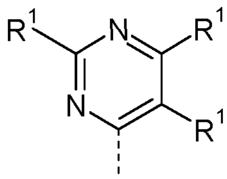

formula (ET-14)

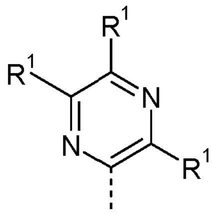

formula (ET-15)

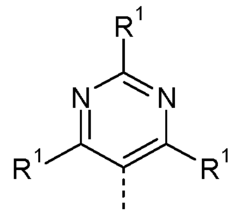

formula (ET-16)

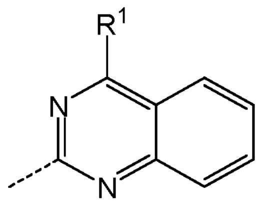

formula (ET-20)

$R^1$, $R^{1'}$, $R^{1''}$ are, identically or differently on each occurrence, H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy, alkylalkoxy or thioalkoxy group having 3 to 40 C atoms, which may in each case be substituted by one or more radicals $R^2$, where one or more non-adjacent $CH_2$ groups may be replaced by $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S or $CONR^2$ and where one or more H atoms may be replaced by D, F, Cl, Br, I, CN or $NO_2$, or an aromatic or heteroaromatic ring system having 5 to 60 aromatic ring atoms, which may in each case be substituted by one or more radicals $R^2$, or an aryloxy, arylalkoxy or heteroaryloxy group having 5 to 60 aromatic ring atoms, which may be substituted by one or more radicals $R^2$, or a diarylamino group, diheteroarylamino group or arylheteroarylamino group having 10 to 40 aromatic ring atoms, which may be substituted by one or more radicals $R^2$, or a combination of two or more of these groups; two or more adjacent radicals $R^1$, $R^{1'}$ or $R^{1''}$ may form a mono- or polycyclic, aliphatic or aromatic ring system with one another, where it is preferred if two or more adjacent radicals $R^1$, $R^{1'}$ or $R^{1''}$ do not form a mono- or polycyclic, aliphatic or aromatic ring system with one another;

$R^2$ is, identically or differently on each occurrence, H, D, F, Cl, Br, I, $N(R^3)_2$, CN, $NO_2$, $Si(R^3)_3$, $B(OR^3)_2$, $C(=O)R^3$, $P(=O)(R^3)_2$, $S(=O)R^3$, $S(=O)_2R^3$, $OSO_2R^3$, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy, alkylalkoxy or thioalkoxy group having 3 to 40 C atoms, which may in each case be substituted by one or more radicals $R^3$, where one or more non-adjacent $CH_2$ groups may be replaced by $R^3C=CR^3$, C=C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$ and where one or more H atoms may be replaced by D, F, Cl, Br, I, CN or $NO_2$, or an aromatic or heteroaromatic ring system having 5 to 60 aromatic ring atoms, which may in each case be substituted by one or more radicals $R^3$, or an aryloxy, arylalkoxy or heteroaryloxy group having 5 to 60 aromatic ring atoms, which may be substiuted by one or more radicals $R^3$, or a diarylamino group, diheteroarylamino group or arylheteroarylamino group having 10 to 40 aromatic ring atoms, which may be substituted by one or more radicals $R^3$, or a combination of two or more of these groups; two or more adjacent radicals $R^2$ may form a mono- or polycyclic, aliphatic or aromatic ring system with one another;

$R^3$ is, identically or differently on each occurrence, H, D, F or an aliphatic, aromatic and/or heteroaromatic hydrocarbon radical having 1 to 20 C atoms, in which, in addition, one or more H atoms may be replaced by F; two or more substituents $R^3$ may also form a mono- or polycyclic, aliphatic or aromatic ring system with one another;

$R^4$ is, identically or differently on each occurrence, $N(R^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy, alkylalkoxy or thioalkoxy group having 3 to 40 C atoms, which may in each case be substituted by one or more radicals $R^2$, where one or more non-adjacent $CH_2$ groups may be replaced by $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S or $CONR^2$ and where one or more H atoms may be replaced by D, F, Cl, Br, I, CN or $NO_2$, or an aromatic or heteroaromatic ring system having 5 to 60 aromatic ring atoms, which may in each case be substituted by one or more radicals $R^2$, or an aryloxy, arylalkoxy or heteroaryloxy group having 5 to 60 aromatic ring atoms, which may be substituted by one or more radicals $R^2$, or a diarylamino group, diheteroarylamino group or arylheteroarylamino group having 10 to 40 aromatic ring atoms, which may be substituted by one or more radicals $R^2$, or a combination of two or more of these groups; two or more adjacent radicals $R^4$ may form a mono- or polycyclic, aliphatic or aromatic ring system with one another.

2. Composition according to Claim 1, **characterised in that** the bipolar host is selected from the compounds of the following formula

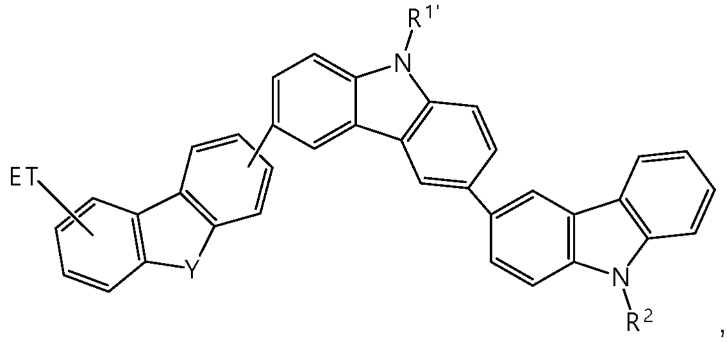

where the following applies

| ET group | Bipolar host |
|---|---|
| (ET-12) | formula (1a-25) |
| (ET-13) | formula (1a-26) |
| (ET-14) | formula (1a-27) |
| (ET-15) | formula (1a-28) |
| (ET-16) | formula (1a-29) |
| (ET-20) | formula (1a-30); |

the following compounds of the formulae (1a-31) to (1a-36) having the general formula

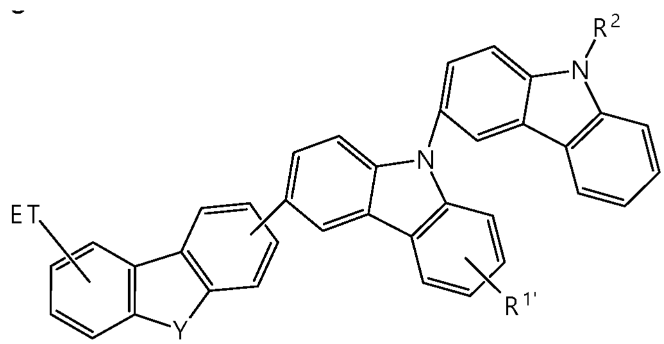

where the following applies:

| ET group | Bipolar host |
|---|---|
| (ET-12) | formula (1a-31) |
| (ET-13) | formula (1a-32) |
| (ET-14) | formula (1a-33) |
| (ET-15) | formula (1a-34) |
| (ET-16) | formula (1a-35) |
| (ET-20) | formula (1a-36); |

the following compounds of the formulae (1b-25) to (1b-30) having the general formula

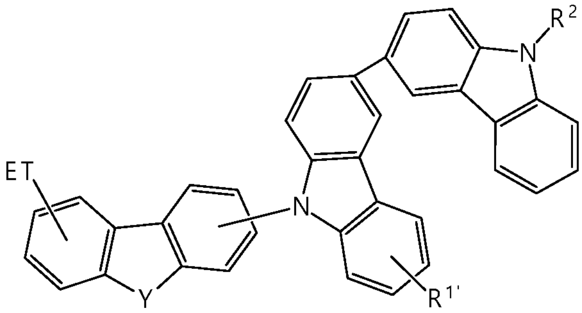

where the following applies:

| ET group | Bipolar host |
|---|---|
| (ET-12) | formula (1b-25) |
| (ET-13) | formula (1b-26) |
| (ET-14) | formula (1b-27) |
| (ET-15) | formula (1b-28) |
| (ET-16) | formula (1b-29) |
| (ET-20) | formula (1b-30); and |

the following compounds of the formulae (1b-31) to (1b-36) having the general formula

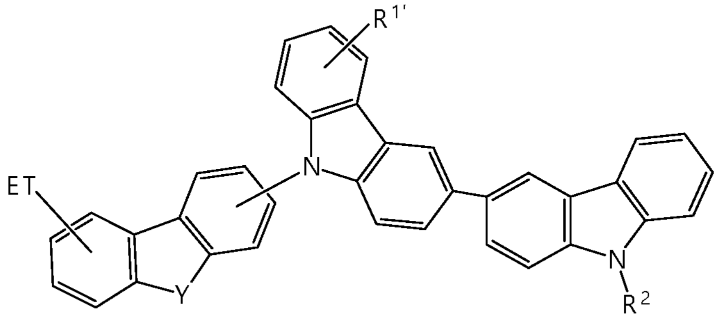

where the following applies:

| ET group | Bipolar host |
|---|---|
| (ET-12) | formula (1b-31) |
| (ET-13) | formula (1b-32) |
| (ET-14) | formula (1b-33) |
| (ET-15) | formula (1b-34) |
| (ET-16) | formula (1b-35) |
| (ET-20) | formula (1b-36); |

and where the symbols used have the meanings given above.

**3.** Composition according to Claim 1 or 2, **characterised in that** the bipolar host is selected from the compounds of the formulae (1a-37), (1a-38), (1b-37) und (1b-38)

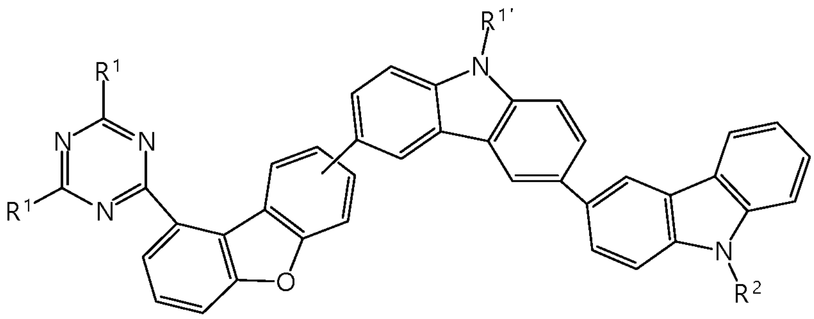

formula (1a-37)

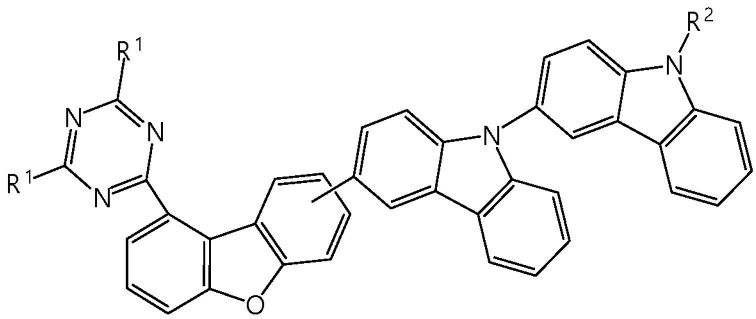

formula (1a-38)

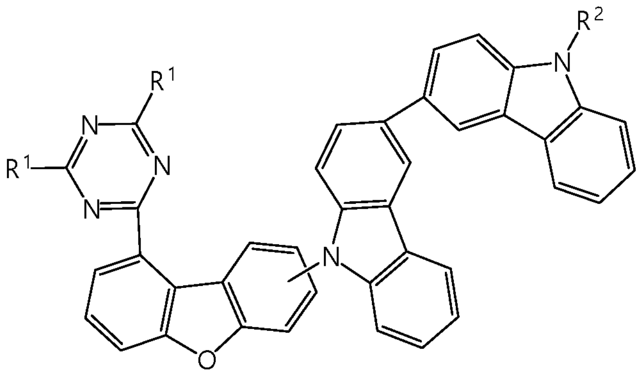

formula (1b-37)

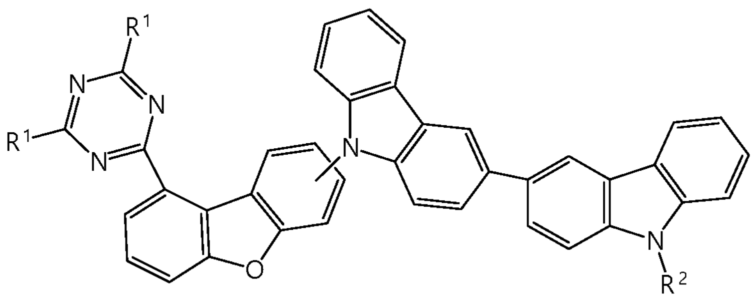

formula (1b-38),

where $R^1$ and $R^2$ have the meaning given above.

**4.** Composition according to one or more of Claims 1 to 3, **characterised in that** $R^1$ is selected from the group consisting of H or an aromatic or heteroaromatic ring system having 5 to 60 aromatic ring atoms, which may in each case be

substituted by one or more radicals $R^2$, where $R^1$ preferably does not contain any electron-rich aromatic or heteroaromatic rings or ring systems, where $R^2$ has the meaning given above.

**5.** Composition according to one or more of Claims 1 to 4, **characterised in that** the substituent $R^2$ is selected from the group consisting of H or an aromatic or heteroaromatic ring or ring system having 5 to 30 ring atoms, where the ring or ring system may in each case be substituted by one or more radicals $R^3$, but is preferably unsubstituted, where $R^3$ has the meaning given above.

**6.** Composition according to one or more of Claims 1 to 5, **characterised in that** $R^2$ represents a phenyl, biphenyl, terphenyl or quaterphenyl group.

**7.** Composition according to one or more of Claims 1 to 6, **characterised in that** the bipolar host represents a compound of the formulae (1a-37), (1a-38), (1b-37) and (1b-38), where the carbazole-containing HT group is bonded at position 8 of the dibenzofuran.

**8.** Composition according to one or more of Claims 1 to 7, **characterised in that** the electron-transporting host is a lactam.

**9.** Composition according to one or more of Claims 1 to 8, **characterised in that** the electron-transporting host is a compound of the general formula (2) or (2a),

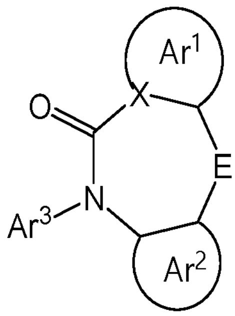

formula (2)

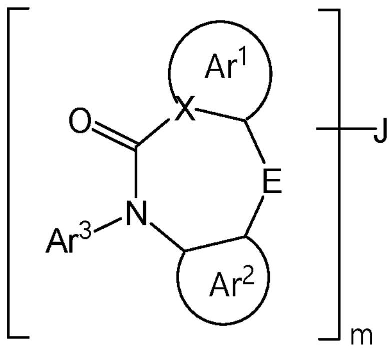

formula (2a)

where the following applies to the symbols and indices used:

E is a single bond or $NAr^4$;
X is C if $Ar^1$ represents a 6-membered aryl or 6-membered heteroaryl ring group, or is C or N if $Ar^1$ represents a 5-membered heteroaryl ring group;
$Ar^1$ is, together with the group X and the carbon atom explicitly shown, an aromatic or heteroaromatic ring system having 5 to 30 aromatic ring atoms, which may be substituted by one or more radicals R;
$Ar^2$ is, together with the carbon atoms explicitly shown, an aromatic or heteroaromatic ring system having 5 to 30 aromatic ring atoms, which may be substituted by one or more radicals R; $Ar^2$ may also be linked to $Ar^3$ by a single bond;
$Ar^3$ is selected from the group consisting of H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^6$, where one or more non-adjacent $CH_2$ groups may be replaced by $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$ and where one or more H atoms may be replaced by D, F, Cl, Br, I, CN or $NO_2$, an aromatic or heteroaromatic ring system having 5 to 30 aromatic ring atoms, which may in each case be substituted by one or more radicals $R^6$, an aryloxy or heteroaryloxy group having 5 to 30 aromatic ring atoms, which may be substituted by one or more radicals $R^6$, or a combination of these systems; $Ar^3$ may also be linked to $Ar^2$ by a single bond;
$Ar^4$ is an aromatic or heteroaromatic ring system having 5 to 30 aromatic ring atoms, which may be substituted by one or more radicals R; $Ar^4$ may also be linked to $Ar^2$ or $Ar^1$ by a single bond;
m is 1, 3 or 4;

J for m = 2 is a single bond or a divalent group, or for m = 3 is a trivalent group or for m = 4 is a tetravalent group, which is in each case bonded to $Ar^1$, $Ar^2$, $Ar^3$ or $Ar^4$ at any desired position;

R is selected on each occurrence, identically or differently, from the group consisting of H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^6$, where one or more non-adjacent $CH_2$ groups may be replaced by $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S or $CONR^6$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^6$, an aryloxy or heteroaryloxy group having 5 to 60 aromatic ring atoms, which may be substituted by one or more radicals $R^6$, or a combination of these systems, where optionally two or more adjacent substituents R may form a monocyclic or polycyclic, aliphatic, aromatic or heteroaromatic ring system, which may be substituted by one or more radicals $R^6$;

$R^6$ is selected on each occurrence, identically or differently, from the group consisting of H, D, F, Cl, Br, I, CN, $NO_2$, $N(Ar^5)_2$, $N(R^7)_2$, $C(=O)Ar^5$, $C(=O)R^7$, $P(=O)(Ar^5)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^7$, where one or more non-adjacent $CH_2$ groups may be replaced by $R^7C=CR^7$, C=C, $Si(R^7)_2$, $Ge(R^7)_2$, $Sn(R^7)_2$, C=O, C=S, C=Se, $C=NR^7$, $P(=O)(R^7)$, SO, $SO_2$, $NR^7$, O, S or $CONR^7$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^7$, an aryloxy or heteroaryloxy group having 5 to 60 aromatic ring atoms, which may be substituted by one or more radicals $R^7$, or a combination of these systems, where optionally two or more adjacent substituents $R^6$ may form a monocyclic or polycyclic, aliphatic, aromatic or heteroaromatic ring system, which may be substituted by one or more radicals R7;

$Ar^5$ is on each occurrence, identically or differently, an aromatic or heteroaromatic ring system having 5 to 30 aromatic ring atoms, which may be substituted by one or more non-aromatic radicals $R^7$; two radicals $Ar^5$ that are bonded to the same N atom or B atom may also be bridged to one another by a single bond or a bridge selected from $N(R^7)$, $C(R^7)_2$ or O;

$R^7$ is selected from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents $R^7$ may form a mono- or polycyclic, aliphatic, aromatic or heteroaromatic ring system with one another.

**10.** Composition according to Claim 9, **characterised in that**, in compounds of the formula (2) or (2a), the group $Ar^1$ stands for a group of the formula (3), (4), (5), (6) or (7),

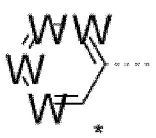
formula (3)

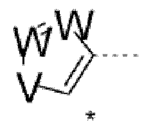
formula (4)

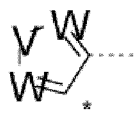
formula (5)

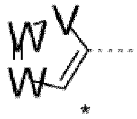
formula (6)

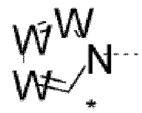
formula (7)

where the dashed bond indicates the link to the carbonyl group, * indicates the position of the link to E and furthermore the following applies:

W is, identically or differently on each occurrence, CR or N; or two adjacent groups W stand for a group of the following formula (8) or (9),

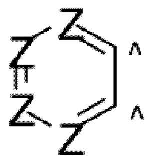

formula (8)

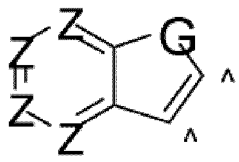

formula (9)

where G stands for $CR_2$, NR, O or S, Z stands, identically or differently on each occurrence, for CR or N, and ^ indicates the corresponding adjacent groups W in the formulae (3) to (7);
V is NR, O or S;
and **in that** the group $Ar^2$ stands for a group of one of the formulae (10), (11) or (12),

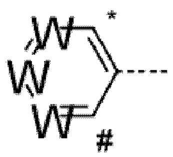

formula (10)

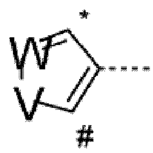

formula (11)

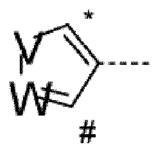

formula (12)

where the dashed bond indicates the link to N, # indicates the position of a possible link to $Ar^3$, * indicates the link to E, and W and V have the meanings given above;
and **in that** the group $Ar^3$ stands for a group of one of the formulae (13), (14), (15) or (16),

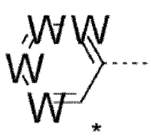

formula (13)

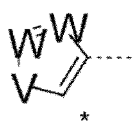

formula (14)

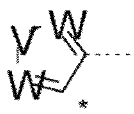

formula (15)

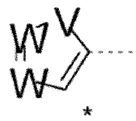

formula (16)

where the dashed bond indicates the link to N, * indicates a possible link to $Ar^2$, and W and V have the meanings given above.

11. Composition according to Claim 9 or 10, **characterised in that** the compound of the formula (2) is selected from the compounds of the formulae (17) to (32)

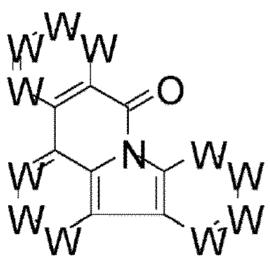

formula (17)

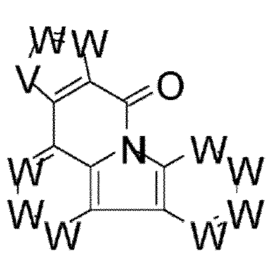

formula (18)

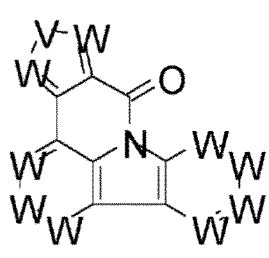

formula (18-I)

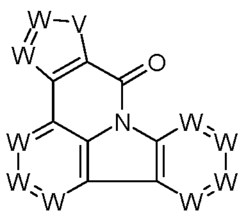

formula (19)

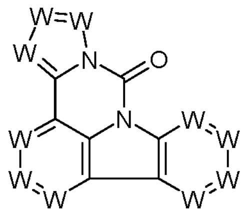

formula (20)

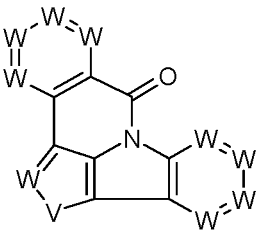

formula (21)

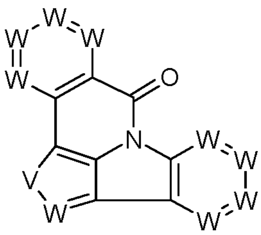

formula (22)

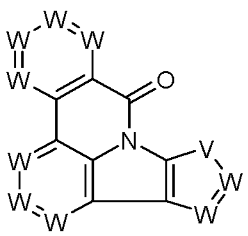

formula (23)

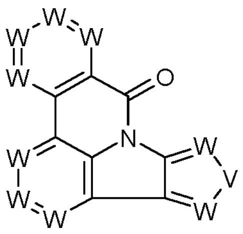

formula (24)

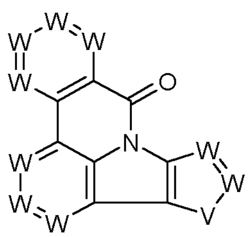

formula (25)

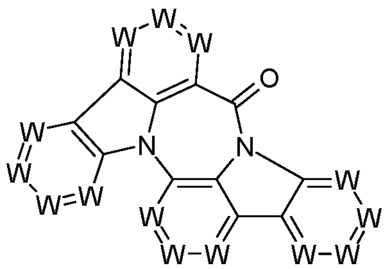

formula (26)

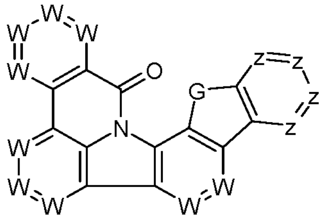

formula (27)

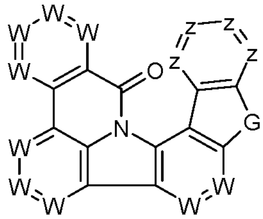

formula (28)

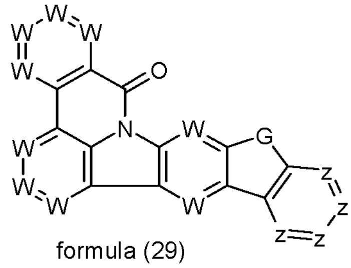

formula (29)

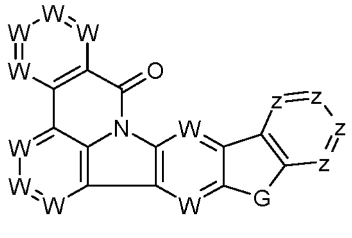

formula (30)

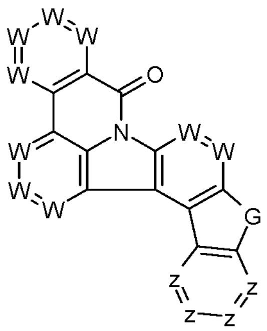

formula (31)

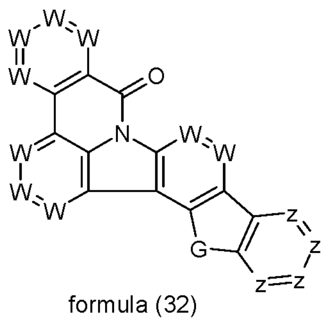

formula (32)

where the symbols used have the meanings given above.

12. Composition according to one or more of Claims 9 to 11, **characterised in that** the compound of the formula (2) is selected from the compounds of the formulae (17a) to (32a),

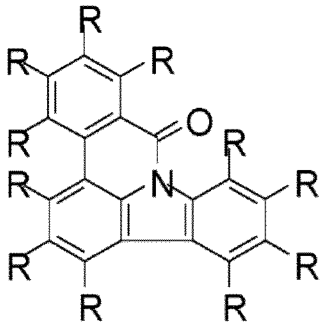

formula (17a)

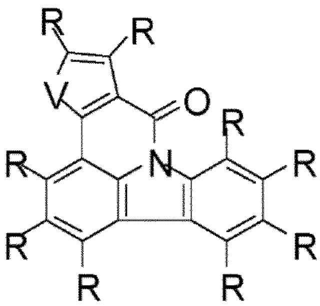

formula (18a)

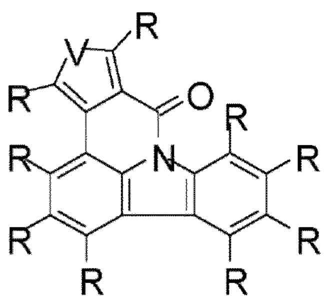

formula (18-Ia)

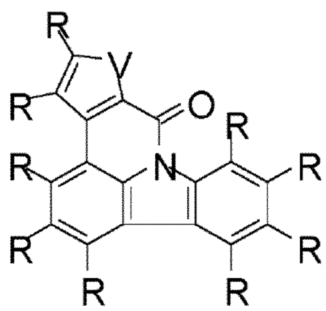

formula (19a)

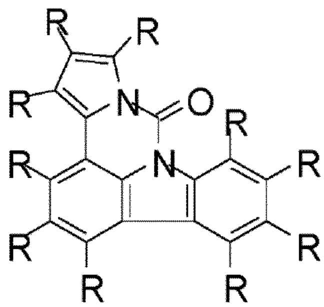

formula (20a)

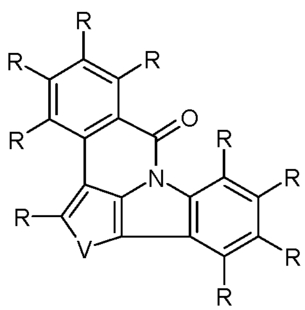

formula (21a)

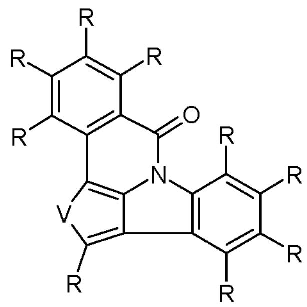

formula (22a)

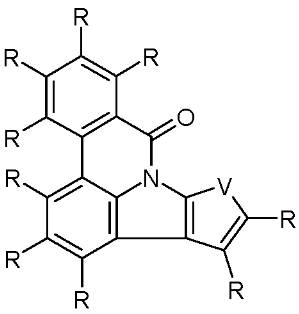

formula (23a)

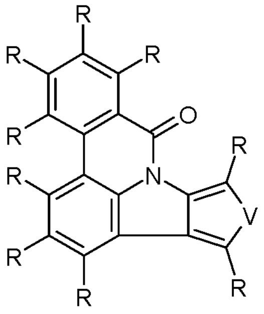

formula (24a)

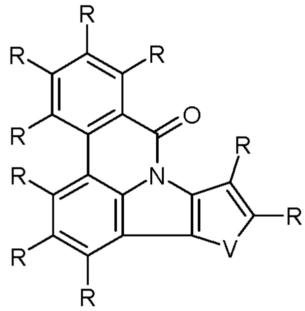

formula (25a)

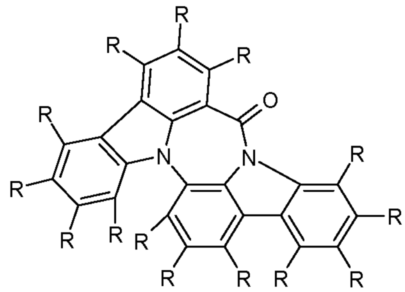

formula (26a)

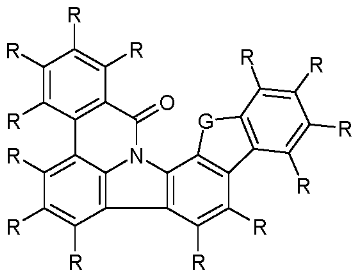

formula (27a)

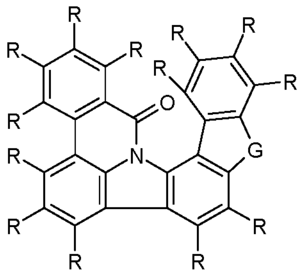

formula (28a)

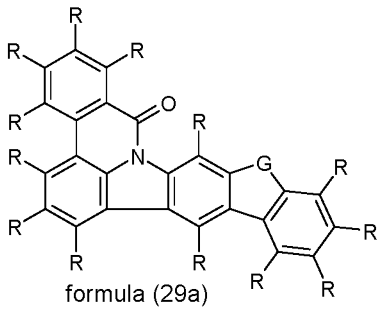

formula (29a)

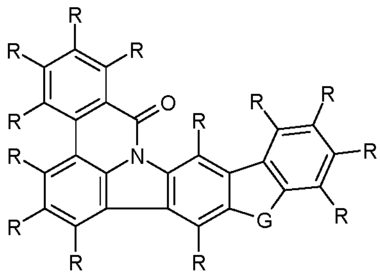

formula (30a)

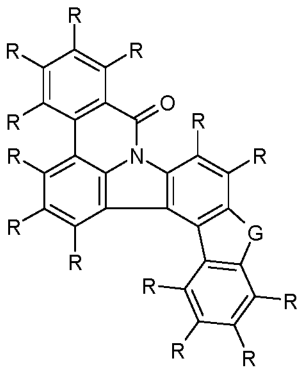

formula (31a)

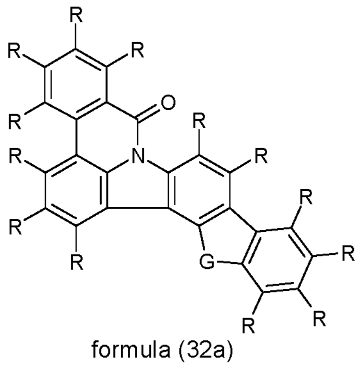

formula (32a)

where the symbols used have the meanings given above.

13. Composition according to one or more of Claims 9 to 12, **characterised in that** the compound of the formula (2) is selected from the compounds of the formulae (17b) to (32b),

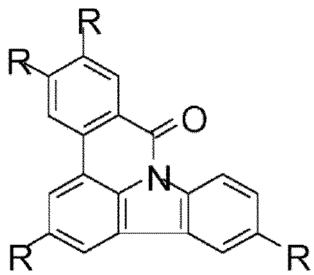
formula (17b)

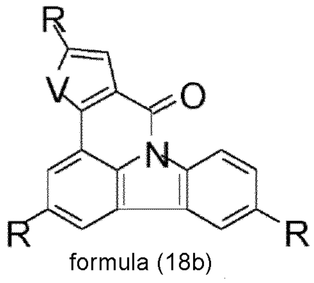
formula (18b)

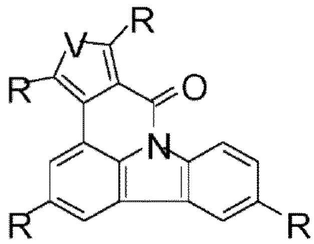
formula (18-Ib)

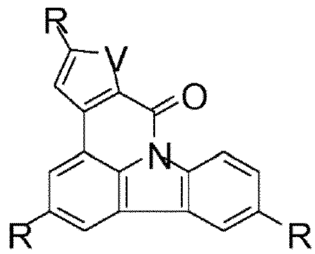
formula (19b)

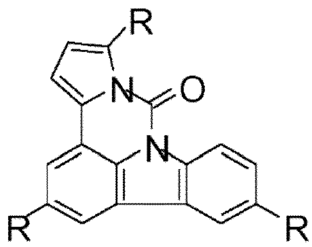
formula (20b)

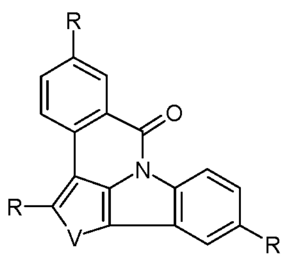
formula (21b)

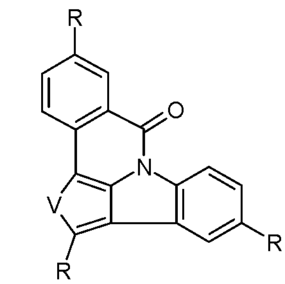
formula (22b)

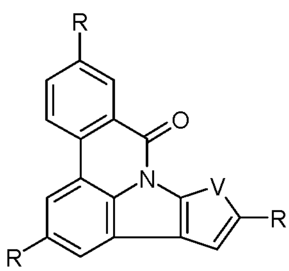
formula (23b)

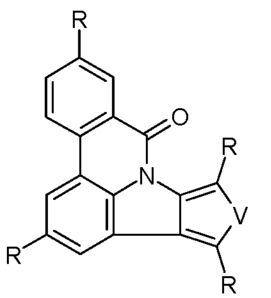
formula (24b)

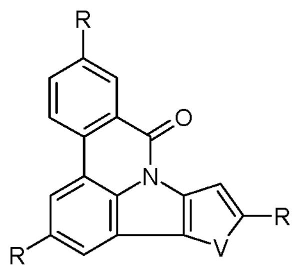
formula (25b)

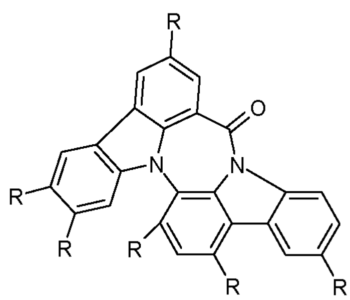
formula (26b)

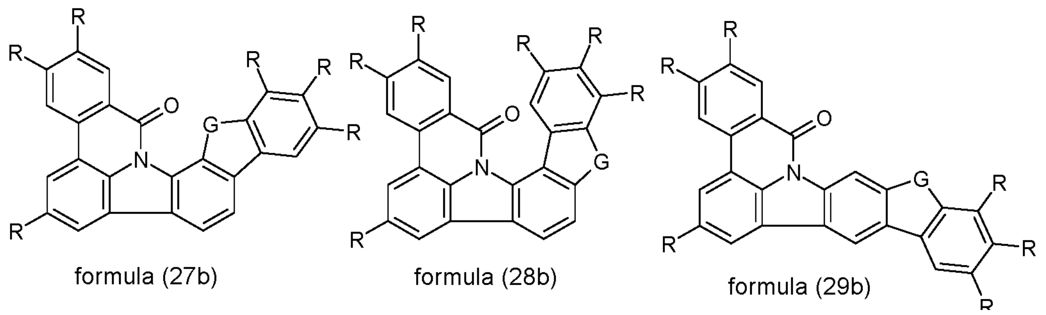

formula (27b) formula (28b) formula (29b)

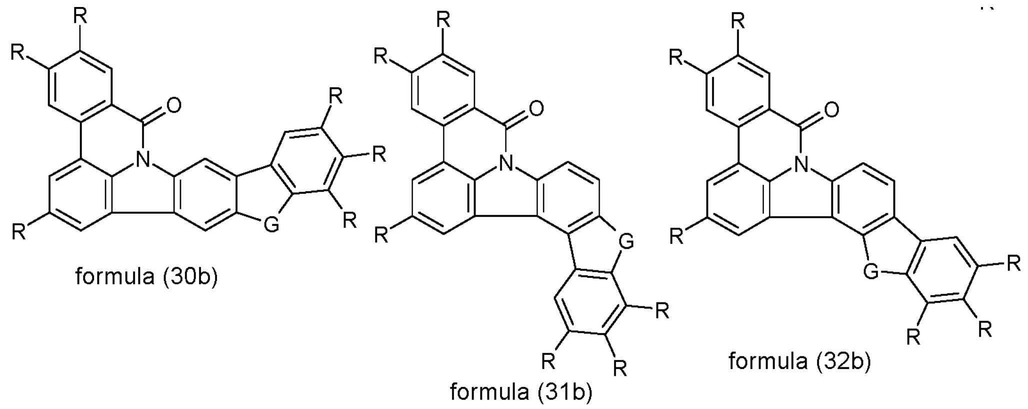

formula (30b) formula (31b) formula (32b)

where the symbols used have the meanings given above.

**14.** Composition according to one or more of Claims 1 to 13, **characterised in that** the composition comprises at least one further compound, which is selected from the group consisting of hole-injection materials, hole-transport materials, hole-blocking materials, wide-band-gap materials, fluorescent emitters, phosphorescent emitters, host materials, matrix materials, electron-blocking materials, electron-transport materials and electron-injection materials, n-dopants and p-dopants.

**15.** Formulation comprising a composition according to one or more of Claims 1 to 14 and at least one solvent.

**16.** Use of a composition according to one or more of Claims 1 to 15 in an organic electronic device, which is preferably selected from organic integrated circuits (OICs), organic field-effect transistors (OFETs), organic thin-film transistors (OTFTs), organic electroluminescent devices, organic solar cells (OSCs), organic optical detectors and organic photoreceptors, where the organic electroluminescent devices are particularly preferred, and light-emitting electrochemical cells (OLECs) and organic light-emitting diodes (OLEDs) are very particularly preferred.

**17.** Organic electronic device containing at least one composition according to one or more of Claims 1 to 14, preferably in an emission layer (EML), in an electron-transport layer (ETL), in an electron-injection layer (EIL) and/or in a hole-blocking layer (HBL), very preferably in an EML, EIL and/or ETL and very particularly preferably in an EML.

**18.** Organic electronic device according to Claim 17, **characterised in that** it is selected from organic integrated circuits (OICs), organic field-effect transistors (OFETs), organic thin-film transistors (OTFTs), organic electroluminescent devices, organic solar cells (OSCs), organic optical detectors and organic photoreceptors, where organic electroluminescent devices are particularly preferred.

**19.** Organic electronic device according to Claim 17 or 18, **characterised in that** it is an organic electroluminescent device selected from organic light-emitting transistors (OLETs), organic field-quench devices (OFQDs), organic light-emitting electrochemical cells (OLECs, LECs, LEECs), organic laser diodes (O-lasers) and organic light-emitting diodes (OLEDs), preferably from OLECs and OLEDs and particularly preferably from OLEDs.

**20.** Organic electronic device according to one or more of Claims 17 to 19, **characterised in that** it is an organic electroluminescent device which contains the composition according to one or more of Claims 1 to 14 in the emission layer together with a phosphorescent emitter.

**21.** Process for the production of an organic electronic device according to one or more of Claims 17 to 20, **characterised in that** at least one organic layer comprising a composition according to one or more of Claims 1 to 14 is applied by gas-phase deposition or from solution.

**22.** Process according to Claim 21, **characterised in that** the at least one organic layer is applied by means of gas-phase deposition by pre-mixing the composition and evaporating it from a single material source.

**Revendications**

**1.** Composition comprenant un hôte bipolaire et un hôte de transport d'électrons, **caractérisée en ce que** l'hôte bipolaire est choisi parmi les composés de formules (1a-13) à (1a-18) répondant à la formule générale

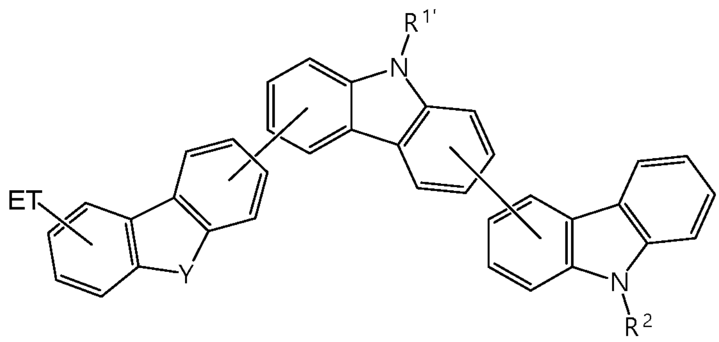

,

dans laquelle ce qui suit s'applique :

| Groupement ET | Hôte bipolaire |
|---|---|
| (ET-12) | formule (1a-13) |
| (ET-13) | formule (1a-14) |
| (ET-14) | formule (1a-15) |
| (ET-15) | formule (1a-16) |
| (ET-16) | formule (1a-17) |
| (ET-20) | formule (1a-18) ; |

les composés de formules (1a-19) à (1a-24) répondant à la formule générale

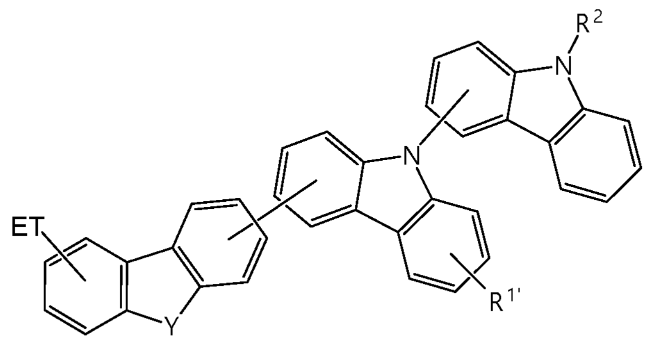

,

dans laquelle ce qui suit s'applique :

| Groupement ET | Hôte bipolaire |
|---|---|
| (ET-12) | formule (1a-19) |
| (ET-13) | formule (1a-20) |
| (ET-14) | formule (1a-21) |
| (ET-15) | formule (1a-22) |

(suite)

| Groupement ET | Hôte bipolaire |
|---|---|
| (ET-16) | formule (1a-23) |
| (ET-20) | formule (1a-24) ; |

les composés de formules (1b-13) à (1b-18) répondant à la formule générale

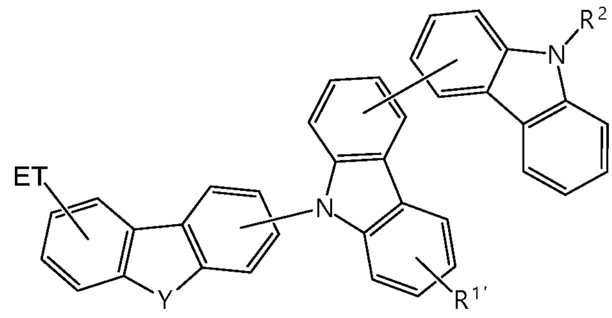

,

dans laquelle ce qui suit s'applique :

| Groupement ET | Hôte bipolaire |
|---|---|
| (ET-12) | formule (1b-13) |
| (ET-13) | formule (1b-14) |
| (ET-14) | formule (1b-15) |
| (ET-15) | formule (1b-16) |
| (ET-16) | formule (1b-17) |
| (ET-20) | formule (1b-18) ; et |

les composés de formules (1b-19) à (1b-24) répondant à la formule générale

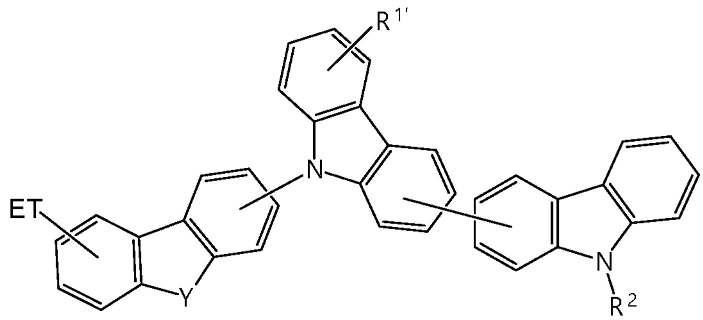

,

dans laquelle ce qui suit s'applique :

| Groupement ET | Hôte bipolaire |
|---|---|
| (ET-12) | formule (1b-19) |
| (ET-13) | formule (1b-20) |
| (ET-14) | formule (1b-21) |
| (ET-15) | formule (1b-22) |
| (ET-16) | formule (1b-23) |
| (ET-20) | formule (1b-24) ; |

Y est O ou S ;

et dans laquelle ce qui suit s'applique aux groupements (ET-12), (ET-13), (ET-14), (ET-15), (ET-16) et (ET-20):

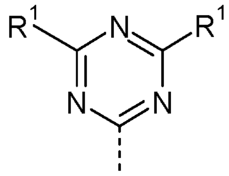

formule (ET-12)

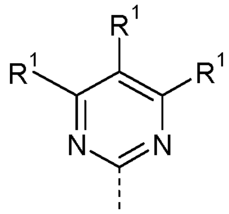

formule (ET-13)

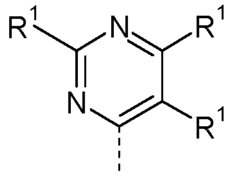

formule (ET-14)

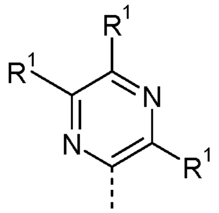

formule (ET-15)

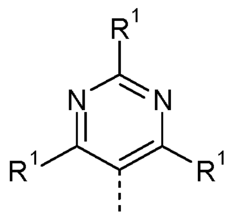

formule (ET-16)

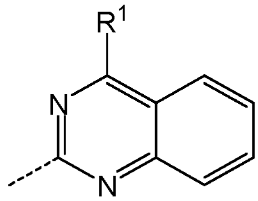

formule (ET-20)

$R^1$, $R^{1'}$, $R^{1''}$ sont, de manière identique ou différente à chaque occurrence, H, D, F, Cl, Br, I, $N(R^2)_2$, CN, $NO_2$, $Si(R^2)_3$, $B(OR^2)_2$, $C(=O)R^2$, $P(=O)(R^2)_2$, $S(=O)R^2$, $S(=O)_2R^2$, $OSO_2R^2$, un groupement alkyle, alcoxy ou thioalcoxy à chaîne linéaire ayant de 1 à 40 atomes de C ou un groupement alcényle ou alcynyle à chaîne linéaire ayant de 2 à 40 atomes de C ou un groupement alkyle, alcényle, alcynyle, alcoxy, alkylalcoxy ou thioalcoxy ramifié ou cyclique ayant de 3 à 40 atomes de C, pouvant dans chaque cas être substitués par un ou plusieurs radicaux $R^2$, où un ou plusieurs groupements $CH_2$ non adjacents peuvent être remplacés par $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S ou $CONR^2$ et où un ou plusieurs atomes de H peuvent être remplacés par D, F, Cl, Br, I, CN ou $NO_2$, ou un noyau aromatique ou hétéroaromatique ayant de 5 à 60 atomes de cycle aromatique, pouvant dans chaque cas être substitué par un ou plusieurs radicaux $R^2$, ou un groupement aryloxy, arylalcoxy ou hétéroaryloxy ayant de 5 à 60 atomes de cycle aromatique, pouvant être substitué par un ou plusieurs radicaux $R^2$, ou un groupement diarylamino, un groupement dihétéroarylamino ou un groupement arylhétéroarylamino ayant de 10 à 40 atomes de cycle aromatique, pouvant être substitué par un ou plusieurs radicaux $R^2$, ou une combinaison de deux, ou plus, parmi ces groupements ; deux, ou plus, radicaux $R^1$, $R^{1'}$ ou $R^{1''}$ adjacents peuvent former un noyau mono- ou polycyclique, aliphatique ou aromatique les uns avec les autres, où l'on préfère que deux, ou plus, radicaux $R^1$, $R^{1'}$ ou $R^{1''}$ adjacents ne forment pas de noyau mono- ou polycyclique, aliphatique ou aromatique les uns avec les autres ;

$R^2$ est, de manière identique ou différente à chaque occurrence, H, D, F, Cl, Br, I, $N(R^3)_2$, CN, $NO_2$, $Si(R^3)_3$, $B(OR^3)_2$, $C(=O)R^3$, $P(=O)(R^3)_2$, $S(=O)R^3$, $S(=O)_2R^3$, $OSO_2R^3$, un groupement alkyle, alcoxy ou thioalcoxy à chaîne linéaire ayant de 1 à 40 atomes de C ou un groupement alcényle ou alcynyle à chaîne linéaire ayant de 2 à 40 atomes de C ou un groupement alkyle, alcényle, alcynyle, alcoxy, alkylalcoxy ou thioalcoxy ramifié ou cyclique ayant de 3 à 40 atomes de C, pouvant dans chaque cas être substitués par un ou plusieurs radicaux $R^3$, où un ou plusieurs groupements $CH_2$ non adjacents peuvent être remplacés par $R^3C=CR^3$, C≡C, $Si(R^3)_2$,

$Ge(R^3)_2$, $Sn(R^3)_2$, C=O, C=S, C=Se, $C=NR^3$, $P(=O)(R^3)$, SO, $SO_2$, $NR^3$, O, S ou $CONR^5$ et où un ou plusieurs atomes de H peuvent être remplacés par D, F, Cl, Br, I, CN ou $NO_2$, ou un noyau aromatique ou hétéroaromatique ayant de 5 à 60 atomes de cycle aromatique, pouvant dans chaque cas être substitué par un ou plusieurs radicaux $R^3$, ou un groupement aryloxy, arylalcoxy ou hétéroaryloxy ayant de 5 à 60 atomes de cycle aromatique, pouvant être substitué par un ou plusieurs radicaux $R^3$, ou un groupement diarylamino, un groupement dihétéroarylamino ou un groupement arylhétéroarylamino ayant de 10 à 40 atomes de cycle aromatique, pouvant être substitué par un ou plusieurs radicaux $R^3$, ou une combinaison de deux, ou plus, parmi ces groupements ; deux, ou plus, radicaux $R^2$ adjacents peuvent former un noyau mono- ou polycyclique, aliphatique ou aromatique les uns avec les autres ;

$R^5$ est, de manière identique ou différente à chaque occurrence, H, D, F ou un radical hydrocarboné aliphatique, aromatique et/ou hétéroaromatique ayant de 1 à 20 atomes de C, où, de plus, un ou plusieurs atomes de H peuvent être remplacés par F ; deux, ou plus, substituants $R^3$ peuvent également former un noyau mono- ou polycyclique, aliphatique ou aromatique les uns avec les autres ;

$R^4$ est, de manière identique ou différente à chaque occurrence, $N(R^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, un groupement alkyle, alcoxy ou thioalcoxy à chaîne linéaire ayant de 1 à 40 atomes de C ou un groupement alcényle ou alcynyle à chaîne linéaire ayant de 2 à 40 atomes de C ou un groupement alkyle, alcényle, alcynyle, alcoxy, alkylalcoxy ou thioalcoxy ramifié ou cyclique ayant de 3 à 40 atomes de C, pouvant dans chaque cas être substitués par un ou plusieurs radicaux $R^2$, où un ou plusieurs groupements $CH_2$ non adjacents peuvent être remplacés par $R^2C=CR^2$, C=C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S ou $CONR^2$ et où un ou plusieurs atomes de H peuvent être remplacés par D, F, Cl, Br, I, CN ou $NO_2$, ou un noyau aromatique ou hétéroaromatique ayant de 5 à 60 atomes de cycle aromatique, pouvant dans chaque cas être substitué par un ou plusieurs radicaux $R^2$, ou un groupement aryloxy, arylalcoxy ou hétéroaryloxy ayant de 5 à 60 atomes de cycle aromatique, pouvant être substitué par un ou plusieurs radicaux $R^2$, ou un groupement diarylamino, un groupement dihétéroarylamino ou un groupement arylhétéroarylamino ayant de 10 à 40 atomes de cycle aromatique, pouvant être substitué par un ou plusieurs radicaux $R^2$, ou une combinaison de deux, ou plus, parmi ces groupements ; deux, ou plus, radicaux $R^4$ adjacents peuvent former un noyau mono- ou polycyclique, aliphatique ou aromatique les uns avec les autres.

2. Composition selon la revendication 1, **caractérisée en ce que** l'hôte bipolaire est choisi parmi les composés de formule suivante

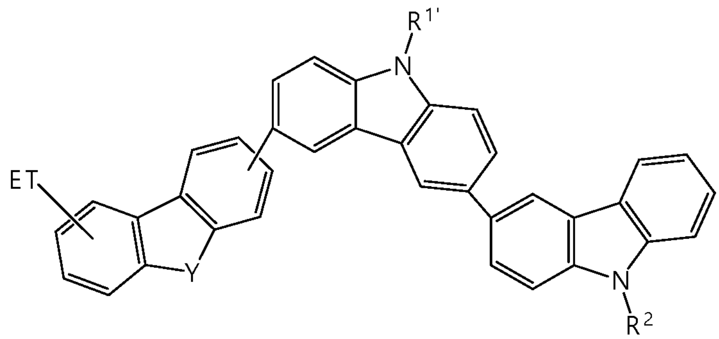

,

dans laquelle ce qui suit s'applique

| Groupement ET | Hôte bipolaire |
|---|---|
| (ET-12) | formule (1a-25) |
| (ET-13) | formule (1a-26) |
| (ET-14) | formule (1a-27) |
| (ET-15) | formule (1a-28) |
| (ET-16) | formule (1a-29) |
| (ET-20) | formule (1a-30) ; |

les composés suivants de formules (1a-31) à (1a-36) répondant à la formule qénérale

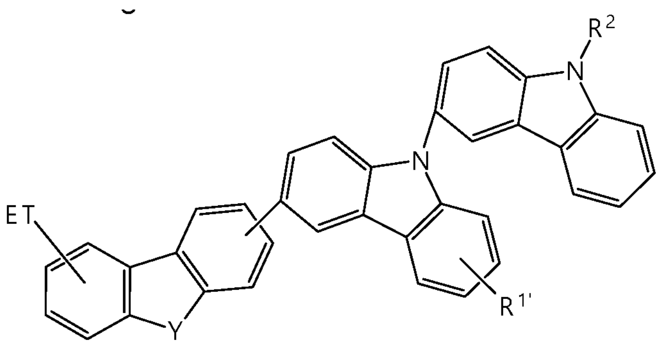

dans laquelle ce qui suit s'applique :

| Groupement ET | Hôte bipolaire |
|---|---|
| (ET-12) | formule (1a-31) |
| (ET-13) | formule (1a-32) |
| (ET-14) | formule (1a-33) |
| (ET-15) | formule (1a-34) |
| (ET-16) | formule (1a-35) |
| (ET-20) | formule (1a-36) ; |

les composés suivants de formules (1b-25) à (1b-30) répondant à la formule générale

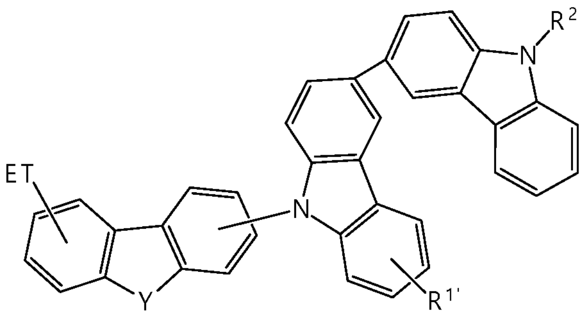

dans laquelle ce qui suit s'applique :

| Groupement ET | Hôte bipolaire |
|---|---|
| (ET-12) | formule (1b-25) |
| (ET-13) | formule (1b-26) |
| (ET-14) | formule (1b-27) |
| (ET-15) | formule (1b-28) |
| (ET-16) | formule (1b-29) |
| (ET-20) | formule (1b-30) ; et |

les composés suivants de formules (1b-31) à (1b-36) répondant à la formule générale

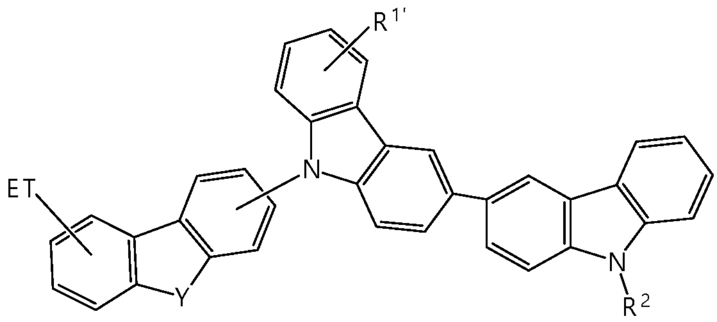

dans laquelle ce qui suit s'applique :

| Groupement ET | Hôte bipolaire |
|---|---|
| (ET-12) | formule (1b-31) |
| (ET-13) | formule (1b-32) |
| (ET-14) | formule (1b-33) |
| (ET-15) | formule (1b-34) |
| (ET-16) | formule (1b-35) |
| (ET-20) | formule (1b-36) ; |

et dans laquelle les symboles utilisés revêtent les significations données ci-dessus.

3. Composition selon la revendication 1 ou 2, **caractérisée en ce que** l'hôte bipolaire est choisi parmi les composés de formules (1a-37), (1a-38), (1b-37) et (1b-38)

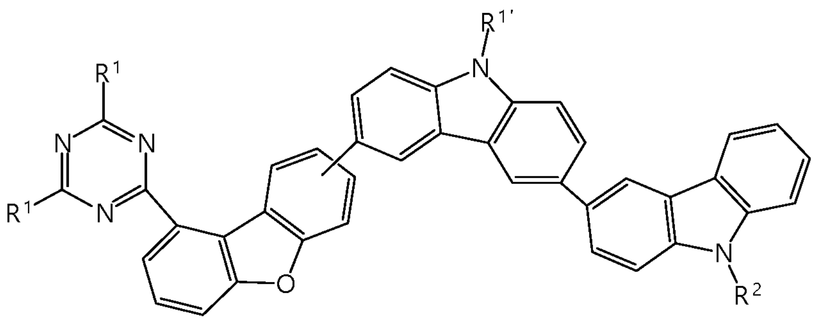

formule (1a-37)

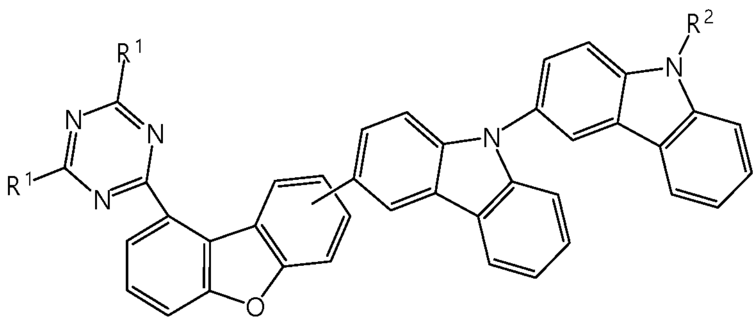

formule (1a-38)

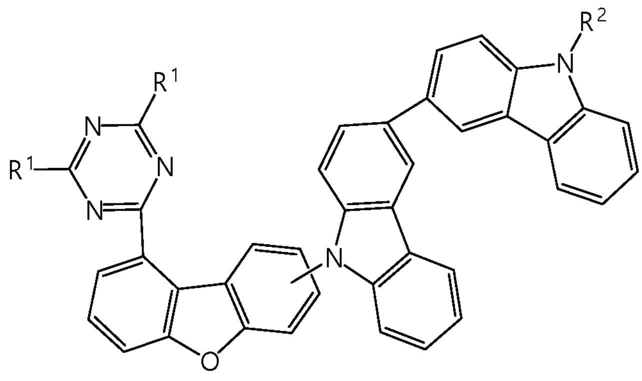

formule (1b-37)

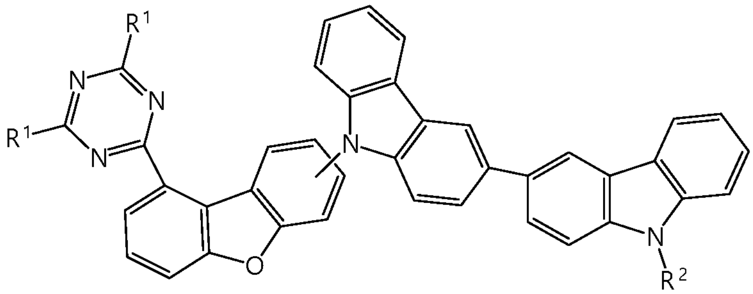

formule (1b-38),

dans lesquelles $R^1$ et $R^2$ revêtent la signification donnée ci-dessus.

**4.** Composition selon l'une ou plusieurs parmi les revendications 1 à 3, **caractérisée en ce que** $R^1$ est choisi dans le groupe constitué par H ou un noyau aromatique ou hétéroaromatique ayant de 5 à 60 atomes de cycle aromatique, pouvant dans chaque cas être substitué par un ou plusieurs radicaux $R^2$, où $R^1$ ne contient pas de préférence de cycles ou noyaux aromatiques ou hétéroaromatiques et riches en électrons, où $R^2$ revêt la signification donnée ci-dessus.

**5.** Composition selon l'une ou plusieurs parmi les revendications 1 à 4, **caractérisée en ce que** le substituant $R^2$ est choisi dans le groupe constitué par H ou un cycle ou noyau aromatique ou hétéroaromatique ayant de 5 à 30 atomes de cycle, où le cycle ou noyau peut dans chaque cas être substitué par un ou plusieurs radicaux $R^3$, mais est préférablement non substitué, où $R^5$ revêt la signification donnée ci-dessus.

**6.** Composition selon l'une ou plusieurs parmi les revendications 1 à 5, **caractérisée en ce que** $R^2$ représente un groupement phényle, biphényle, terphényle ou quaterphényle.

**7.** Composition selon l'une ou plusieurs parmi les revendications 1 à 6, **caractérisée en ce que** l'hôte bipolaire représente un composé de formules (1a-37), (1a-38), (1b-37) et (1b-38), où le groupement HT contenant du carbazole est lié au niveau de la position 8 du dibenzo-furane.

**8.** Composition selon l'une ou plusieurs parmi les revendications 1 à 7, **caractérisée en ce que** l'hôte de transport d'électrons est un lactame.

**9.** Composition selon l'une ou plusieurs parmi les revendications 1 à 8, **caractérisée en ce que** l'hôte de transport d'électrons est un composé de formule générale (2) ou (2a),

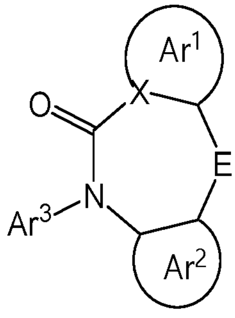

formule (2)

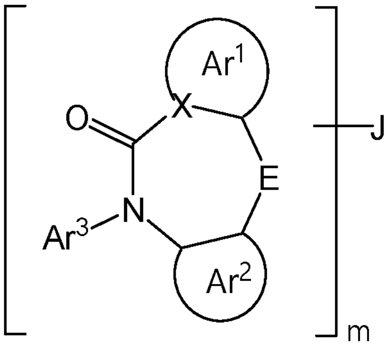

formule (2a)

dans laquelle ce qui suit s'applique aux symboles et indices utilisés :

E est une liaison simple ou $NAr^4$ ;
X est C si $Ar^1$ représente un groupement de cycle aryle de 6 chaînons ou hétéroaryle de 6 chaînons, ou est C ou N si $Ar^1$ représente un groupement de cycle hétéroaryle de 5 chaînons ;
$Ar^1$ est, conjointement avec le groupement X et l'atome de carbone explicitement illustré, un noyau aromatique ou hétéroaromatique ayant de 5 à 30 atomes de cycle aromatique, pouvant être substitué par un ou plusieurs radicaux R ;
$Ar^2$ est, conjointement avec les atomes de carbone explicitement illustrés, un noyau aromatique ou hétéroaromatique ayant de 5 à 30 atomes de cycle aromatique, pouvant être substitué par un ou plusieurs radicaux R ; $Ar^2$ peut également être lié à $Ar^3$ via une liaison simple ;
$Ar^3$ est choisi dans le groupe constitué par H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, pouvant dans chaque cas être substitués par un ou plusieurs radicaux $R^6$, où un ou plusieurs groupements $CH_2$ non adjacents peuvent être remplacés par $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S ou $CONR^6$ et où un ou plusieurs atomes de H peuvent être remplacés par D, F, Cl, Br, I, CN ou $NO_2$, un noyau aromatique ou hétéroaromatique ayant de 5 à 30 atomes de cycle aromatique, pouvant dans chaque cas être substitué par un ou plusieurs radicaux $R^6$, un groupement aryloxy ou hétéroaryloxy ayant de 5 à 30 atomes de cycle aromatique, pouvant être substitué par un ou plusieurs radicaux $R^6$, ou une combinaison de ces systèmes ; $Ar^3$ peut également être lié à $Ar^2$ via une liaison simple ;
$Ar^4$ est un noyau aromatique ou hétéroaromatique ayant de 5 à 30 atomes de cycle aromatique, pouvant être substitué par un ou plusieurs radicaux R ; $Ar^4$ peut également être lié à $Ar^2$ ou $Ar^1$ via une liaison simple ;
m vaut 1, 3 ou 4 ;
J pour m = 2 est une liaison simple ou un groupement divalent, ou pour m = 3 est un groupement trivalent ou pour m = 4 est un groupement tétravalent, qui est dans chaque cas lié à $Ar^1$, $Ar^2$, $Ar^3$ ou $Ar^4$ au niveau d'une position désirée quelconque ;
R est choisi à chaque occurrence, de manière identique ou différente, dans le groupe constitué par H, D, F, Cl, Br, I, CN, $NO_2$, $N(Ar^5)_2$, $N(R^6)_2$, $C(=O)Ar^5$, $C(=O)R^6$, $P(=O)(Ar^5)_2$, un groupement alkyle, alcoxy ou thioalkyle à chaîne linéaire ayant de 1 à 40 atomes de C ou un groupement alkyle, alcoxy ou thioalkyle ramifié ou cyclique ayant de 3 à 40 atomes de C ou un groupement alcényle ou alcynyle ayant de 2 à 40 atomes de C, pouvant dans chaque cas être substitués par un ou plusieurs radicaux $R^6$, où un ou plusieurs groupements $CH_2$ non adjacents peuvent être remplacés par $R^6C=CR^6$, C=C, $Si(R^6)_2$, $Ge(R^6)_2$, $Sn(R^6)_2$, C=O, C=S, C=Se, $C=NR^6$, $P(=O)(R^6)$, SO, $SO_2$, $NR^6$, O, S ou $CONR^6$ et où un ou plusieurs atomes de H peuvent être remplacés par D, F, Cl, Br, I, CN ou $NO_2$, un noyau aromatique ou hétéroaromatique ayant de 5 à 60 atomes de cycle aromatique, pouvant dans chaque cas être substitué par un ou plusieurs radicaux $R^6$, un groupement aryloxy ou hétéroaryloxy ayant de 5 à 60 atomes de cycle aromatique, pouvant être substitué par un ou plusieurs radicaux $R^6$, ou une combinaison de ces systèmes, où éventuellement deux, ou plus, substituants R adjacents peuvent former un noyau monocyclique ou polycyclique, aliphatique, aromatique ou hétéroaromatique, pouvant être substitué par un ou plusieurs radicaux $R^6$ ;
$R^6$ est choisi à chaque occurrence, de manière identique ou différente, dans le groupe constitué par H, D, F, Cl, Br, I, CN, $NO_2$, $N(Ar^5)_2$, $N(R^7)_2$, $C(=O)Ar^5$, $C(=O)R^7$, $P(=O)(Ar^5)_2$, un groupement alkyle, alcoxy ou thioalkyle à chaîne linéaire ayant de 1 à 40 atomes de C ou un groupement alkyle, alcoxy ou thioalkyle ramifié ou cyclique

ayant de 3 à 40 atomes de C ou un groupement alcényle ou alcynyle ayant de 2 à 40 atomes de C, pouvant dans chaque cas être substitués par un ou plusieurs radicaux $R^7$, où un ou plusieurs groupements $CH_2$ non adjacents peuvent être remplacés par $R^7C=CR^7$, C≡C, $Si(R^7)_2$, $Ge(R^7)_2$, $Sn(R^7)_2$, C=O, C=S, C=Se, $C=NR^7$, $P(=O)(R^7)$, SO, $SO_2$, $NR^7$, O, S ou $CONR^7$ et où un ou plusieurs atomes de H peuvent être remplacés par D, F, Cl, Br, I, CN ou $NO_2$, un noyau aromatique ou hétéroaromatique ayant de 5 à 60 atomes de cycle aromatique, pouvant dans chaque cas être substitué par un ou plusieurs radicaux $R^7$, un groupement aryloxy ou hétéroaryloxy ayant de 5 à 60 atomes de cycle aromatique, pouvant être substitué par un ou plusieurs radicaux $R^7$, ou une combinaison de ces systèmes, où éventuellement deux, ou plus, substituants $R^6$ adjacents peuvent former un noyau monocyclique ou polycyclique, aliphatique, aromatique ou hétéroaromatique, pouvant être substitué par un ou plusieurs radicaux $R^7$ ;

$Ar^5$ est à chaque occurrence, de manière identique ou différente, un noyau aromatique ou hétéroaromatique ayant de 5 à 30 atomes de cycle aromatique, pouvant être substitué par un ou plusieurs radicaux $R^7$ non aromatiques ; deux radicaux $Ar^5$ qui sont liés au même atome de N ou atome de B peuvent également être pontés l'un avec l'autre via une liaison simple ou un pont choisi parmi $N(R^7)$, $C(R^7)_2$ ou O ;

$R^7$ est choisi dans le groupe constitué par H, D, F, CN, un radical hydrocarboné aliphatique ayant de 1 à 20 atomes de C, un noyau aromatique ou hétéroaromatique ayant de 5 à 30 atomes de cycle aromatique, où un ou plusieurs atomes de H peuvent être remplacés par D, F, Cl, Br, I ou CN, où deux, ou plus, substituants $R^7$ adjacents peuvent former un noyau mono- ou polycyclique, aliphatique, aromatique ou hétéroaromatique les uns avec les autres.

**10.** Composition selon la revendication 9, **caractérisée en ce que**, dans les composés de formule (2) ou (2a), le groupement $Ar^1$ représente un groupement de formule (3), (4), (5), (6) ou (7),

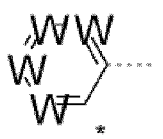
formule (3)

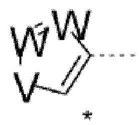
formule (4)

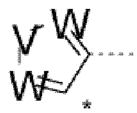
formule (5)

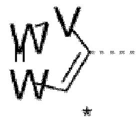
formule (6)

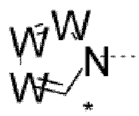
formule (7)

dans laquelle la lignée en pointillés indique la liaison au groupement carbonyle, * indique la position de la liaison à E et, en outre, ce qui suit s'applique :

W est, de manière identique ou différente à chaque occurrence, CR ou N ; ou deux groupements W adjacents représentent un groupement de formule (8) ou (9) suivante,

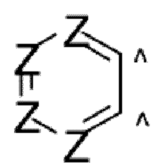
formule (8)

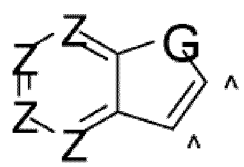
formule (9)

dans laquelle G représente $CR_2$, NR, O ou S, Z représente, de manière identique ou différente à chaque occurrence, CR ou N, et ^ indique les groupements W adjacents correspondants dans les formules (3) à (7) ;

V est NR, O ou S ;

et **en ce que** le groupement $Ar^2$ représente un groupement répondant à l'une des formules (10), (11) ou (12),

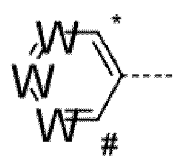
formule (10)

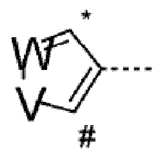
formule (11)

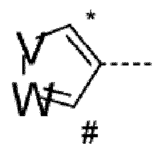
formule (12)

dans lesquelles la lignée en pointillés indique la liaison à N, # indique la position d'une liaison éventuelle à $Ar^3$, * indique la liaison à E, et W et V revêtent les significations données ci-dessus ;
et **en ce que** le groupement $Ar^3$ représente un groupement répondant à l'une des formules (13), (14), (15) ou (16),

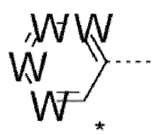
formule (13)

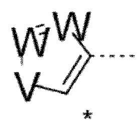
formule (14)

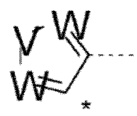
formule (15)

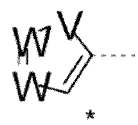
formule (16)

dans lesquelles la lignée en pointillés indique la liaison au N, * indique une liaison éventuelle à $Ar^2$, et W et V revêtent les significations données ci-dessus.

**11.** Composition selon la revendication 9 ou 10, **caractérisée en ce que** le composé de formule (2) est choisi parmi les composés de formules (17) à (32)

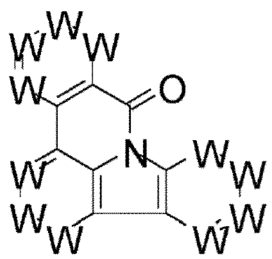
formule (17)

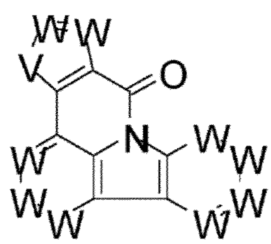
formule (18)

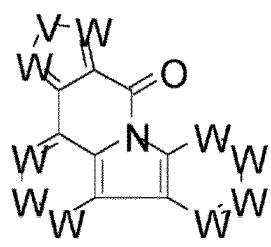
formule (18-I)

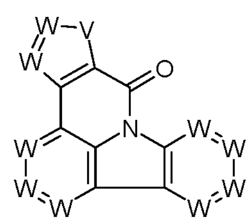
formule (19)

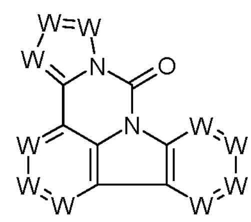
formule (20)

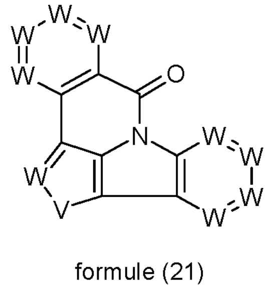
formule (21)

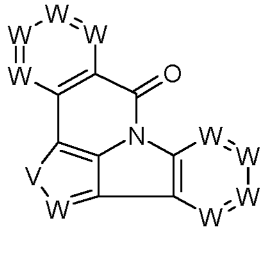
formule (22)

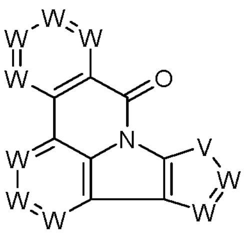

formule (23)

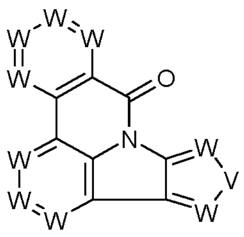

formule (24)

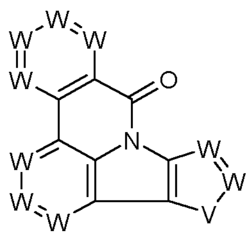

formule (25)

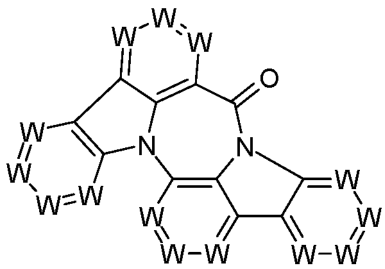

formule (26)

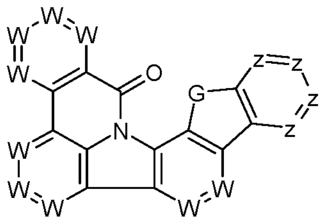

formule (27)

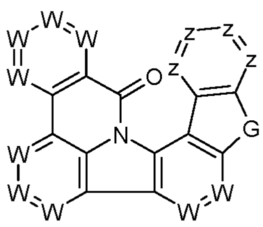

formule (28)

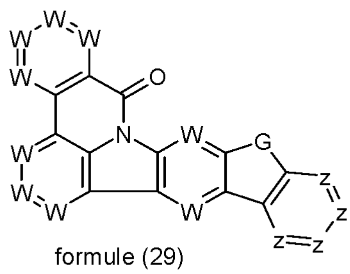

formule (29)

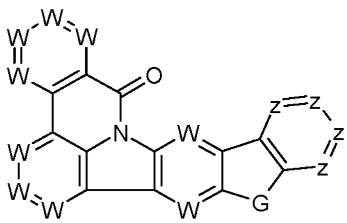

formule (30)

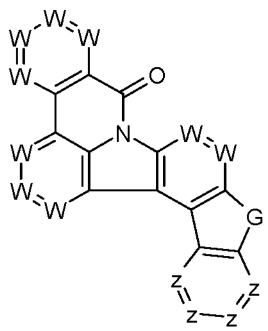

formule (31)

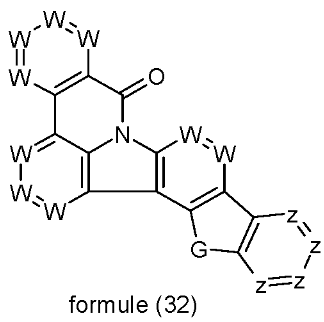

formule (32)

dans lesquelles les symboles utilisés revêtent les significations données ci-dessus.

**12.** Composition selon l'une ou plusieurs parmi les revendications 9 à 11, **caractérisée en ce que** le composé de formule (2) est choisi parmi les composés de formules (17a) à (32a),

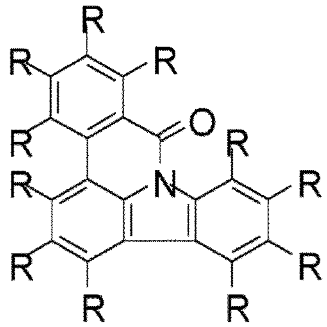

formule (17a)

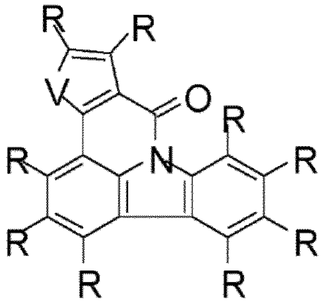

formule (18a)

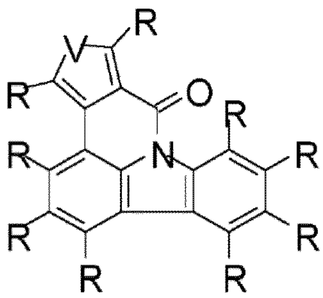

formule (18-la)

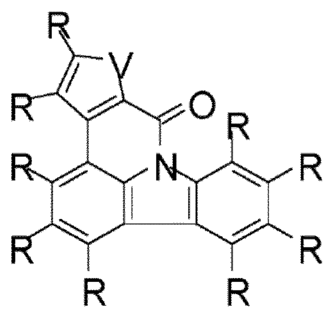

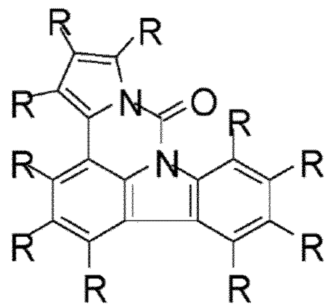

formule (19a) formule (20a)

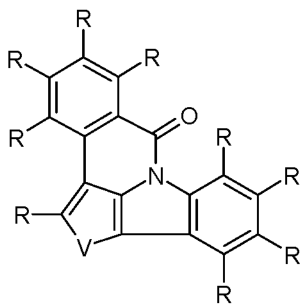

formule (21a)

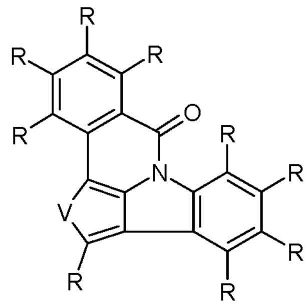

formule (22a)

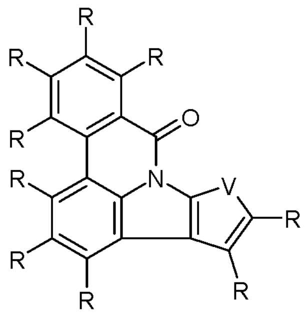

formule (23a)

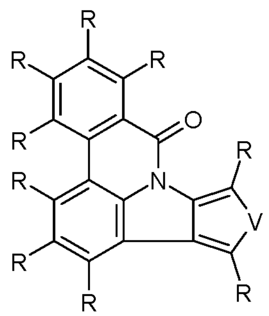

formule (24a)

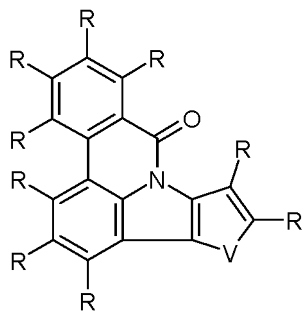

formule (25a)

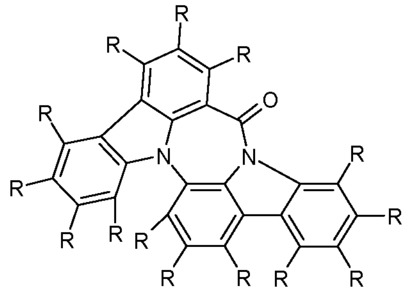

formule (26a)

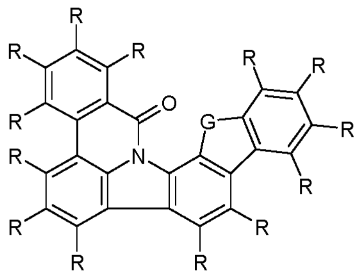

formule (27a)

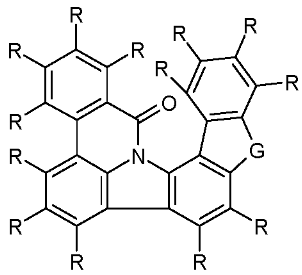

formule (28a)

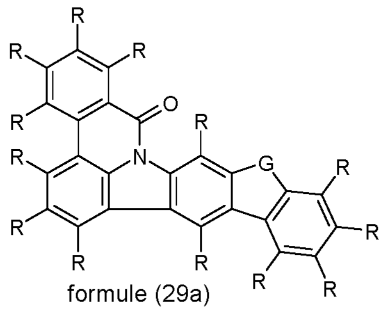

formule (29a)

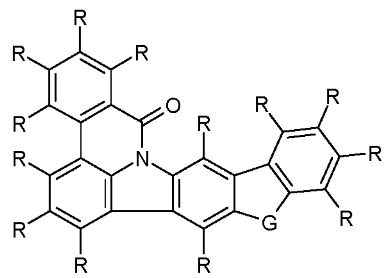

formule (30a)

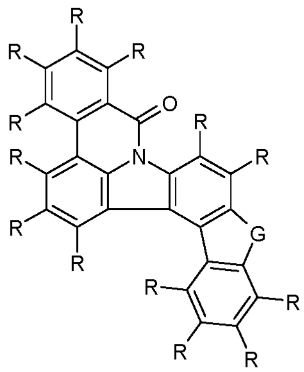

formule (31a)

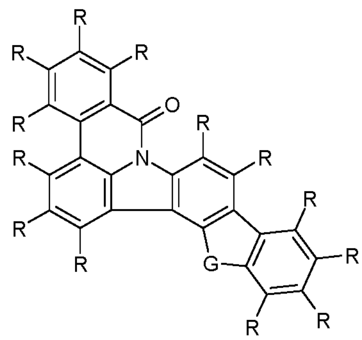

formule (32a)

dans lesquelles les symboles utilisés revêtent les significations données ci-dessus.

13. Composition selon l'une ou plusieurs parmi les revendications 9 à 12, **caractérisée en ce que** le composé de formule (2) est choisi parmi les composés de formules (17b) à (32b),

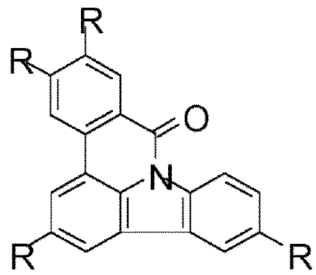

formule (17b)

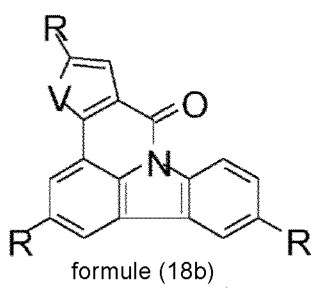

formule (18b)

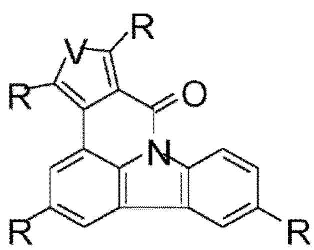

formule (18-Ib)

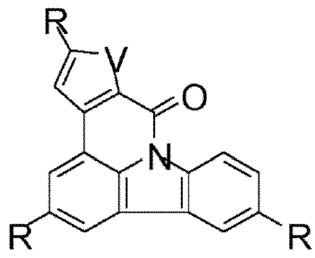

formule (19b)

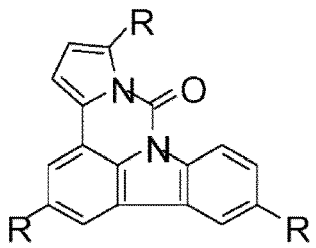

formule (20b)

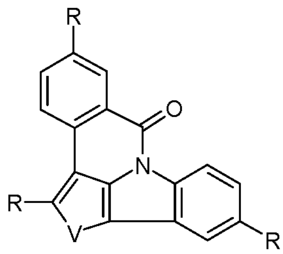

formule (21b)

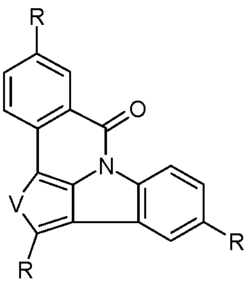

formule (22b)

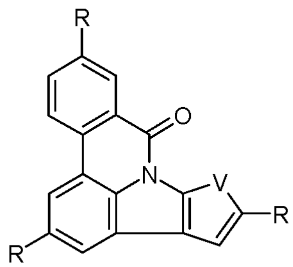

formule (23b)

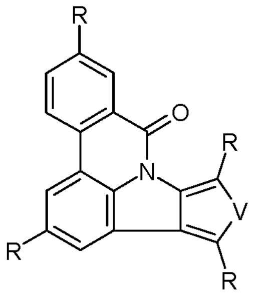

formule (24b)

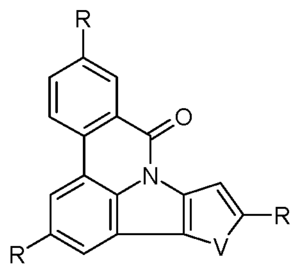

formule (25b)

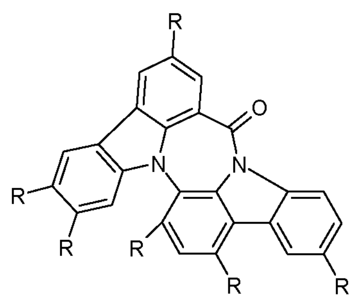

formule (26b)

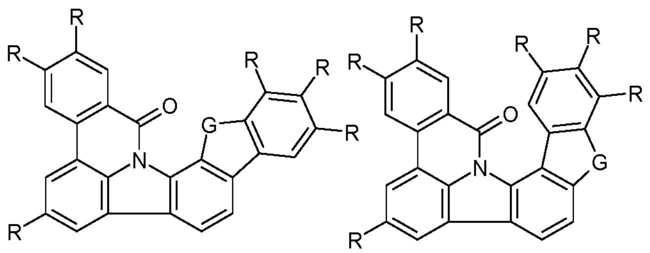

formule (27b)

formule (28b)

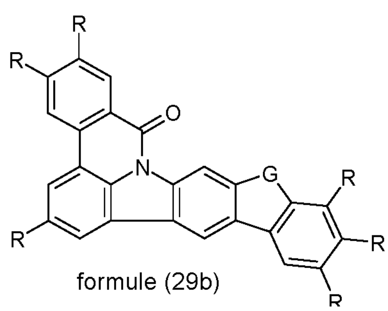

formule (29b)

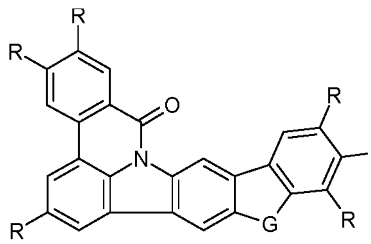

formule (30b)

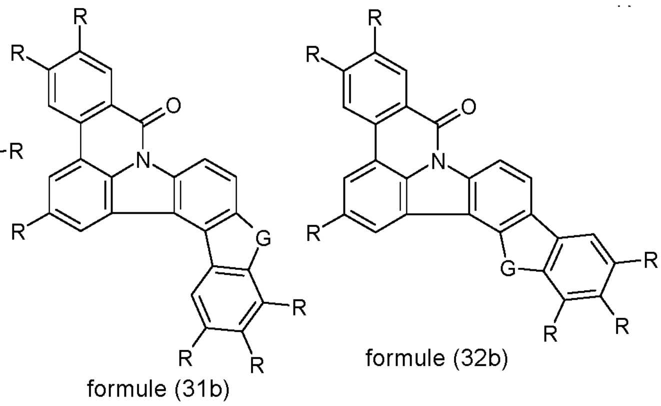

formule (32b)

formule (31b)

dans lesquelles les symboles utilisés revêtent les significations données ci-dessus.

**14.** Composition selon l'une ou plusieurs parmi les revendications 1 à 13, **caractérisée en ce que** la composition comprend au moins un autre composé, qui est choisi dans le groupe constitué par les matériaux d'injection de trous, les matériaux de transport de trous, les matériaux de blocage de trous, les matériaux à large bande interdite, les émetteurs fluorescents, les émetteurs phosphorescents, les matériaux hôtes, les matériaux de matrice, les matériaux de blocage d'électrons, les matériaux de transport d'électrons et les matériaux d'injection d'électrons, les dopants de type N et les dopants de type P.

**15.** Formulation comprenant une composition selon l'une ou plusieurs parmi les revendications 1 à 14 et au moins un solvant.

**16.** Utilisation d'une composition selon l'une ou plusieurs parmi les revendications 1 à 15 dans un dispositif électronique organique, qui est choisi de préférence parmi les circuits intégrés organiques (OIC), les transistors organiques à effet de champ (OFET), les transistors organiques à couche mince (OTFT), les dispositifs électroluminescents organiques, les cellules solaires organiques (OSC), les détecteurs optiques organiques et les photorécepteurs organiques, où les dispositifs électroluminescents organiques sont particulièrement préférés, et les cellules électrochimiques émettrices de lumière (OLEC) et les diodes électroluminescentes organiques (OLED) sont très particulièrement préférées.

**17.** Dispositif électronique organique contenant au moins une composition selon l'une ou plusieurs parmi les revendications 1 à 14, préférablement dans une couche d'émission (EML), dans une couche de transport d'électrons (ETL), dans une couche d'injection d'électrons (EIL) et/ou dans une couche de blocage de trous (HBL), très préférablement dans une EML, EIL et/ou ETL et très particulièrement préférablement dans une EML.

**18.** Dispositif électronique organique selon la revendication 17, **caractérisé en ce qu'**il est choisi parmi les circuits intégrés organiques (OIC), les transistors organiques à effet de champ (OFET), les transistors organiques à couche mince (OTFT), les dispositifs électroluminescents organiques, les cellules solaires organiques (OSC), les détecteurs optiques organiques et les photorécepteurs organiques, où les dispositifs électroluminescents organiques sont particulièrement préférés.

**19.** Dispositif électronique organique selon la revendication 17 ou 18, **caractérisé en ce qu'**il s'agit d'un dispositif électroluminescent organique choisi parmi les transistors organiques émetteurs de lumière (OLET), les dispositifs organiques à extinction de champ (OFQD), les cellules électrochimiques organiques émettrices de lumière (OLEC, LEC, LEEC), les diodes laser organiques (O-lasers) et les diodes électroluminescentes organiques (OLED), préférablement parmi les OLEC et les OLED et particulièrement préférablement parmi les OLED.

**20.** Dispositif électronique organique selon l'une ou plusieurs parmi les revendications 17 à 19, **caractérisé en ce qu'**il s'agit d'un dispositif électroluminescent organique qui contient la composition selon l'une ou plusieurs parmi les revendications 1 à 14 dans la couche d'émission conjointement avec un émetteur phosphorescent.

**21.** Procédé de production d'un dispositif électronique organique selon l'une ou plusieurs parmi les revendications 17 à 20, **caractérisé en ce qu'**au moins une couche organique comprenant une composition selon l'une ou plusieurs parmi les revendications 1 à 14 est appliquée par dépôt en phase gazeuse ou à partir d'une solution.

**22.** Procédé selon la revendication 21, **caractérisé en ce que** la au moins une couche organique est appliquée par dépôt en phase gazeuse par le prémélange de la composition et son évaporation à partir d’une source de matériau unique.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- US 5935721 A
- WO 03095445 A
- CN 1362464
- WO 01076323 A
- WO 01021729 A
- WO 2004013073 A
- WO 2004018588 A
- WO 2003087023 A
- WO 2004018587 A
- WO 2004016575 A
- WO 2008145239 A
- WO 2004093207 A
- WO 2010006680 A
- WO 2005003253 A
- WO 2008056746 A
- EP 0906947 A
- EP 0908787 A
- EP 0906948 A
- WO 2011116865 A
- WO 2011137951 A
- WO 2005039246 A
- US 20050069729 A
- WO 2014015931 A
- WO 2007063754 A
- WO 2010136109 A
- WO 2011000455 A
- WO 2011057706 A
- WO 2011046182 A
- WO 2009069442 A
- JP 2009021336 A
- US 6392250 B1
- US 6803720 B1
- WO 2010108579 A
- WO 2014094964 A
- WO 2015169412 A
- WO 2016015810 A
- WO 2005086251 A2
- WO 2012175535 A1
- WO 2012175219 A1
- WO 2012168358 A1
- WO 2012031735 A1
- EP 1837926 A1
- WO 2007107306 A1
- EP 2452946 A1
- EP 2463927 A1
- WO 2009000237 A1
- US 2007145355 A1
- EP 1538684 A1
- WO 2006081780 A1
- WO 2009003455 A1
- WO 2010097433 A1
- EP 1988587 A1
- US 2010102709 A1
- EP 2180029 A1
- WO 2011131185 A1
- WO 2011134458 A1
- US 2012223296 A1
- WO 2007134873 A1
- WO 2008061517 A2
- WO 2008061518 A2
- DE 102008051737 A1
- WO 2009089821 A1
- US 2010096600 A1
- WO 2008138580 A1
- WO 2008058525 A2
- WO 2007115540 A1
- DE 102010046040 A1
- WO 2008128519 A2
- US 7294849 B
- WO 0070655 A
- WO 200141512 A
- WO 200202714 A
- WO 200215645 A
- EP 1191613 A
- EP 1191612 A
- EP 1191614 A
- WO 05033244 A
- WO 05019373 A
- US 20050258742 A
- WO 2009146770 A
- WO 2010015307 A
- WO 2010031485 A
- WO 2010054731 A
- WO 2010054728 A
- WO 2010086089 A
- WO 2010099852 A
- WO 2010102709 A
- WO 2011032626 A
- WO 2011066898 A
- WO 2011157339 A
- WO 2012007086 A
- WO 2014008982 A
- WO 2014023377 A
- WO 2014094961 A

- WO 2014094960 A
- EP 13004411
- EP 14000345
- EP 14000417
- EP 14002623
- WO 2006108497 A
- WO 2006122630 A
- WO 2008006449 A
- WO 2007140847 A
- WO 2010012328 A
- EP 676461 A
- WO 2004081017 A
- WO 2004058911 A
- WO 2005084081 A
- WO 2005084082 A
- WO 2006048268 A
- WO 2006117052 A
- JP 2004288381 A
- EP 1205527 A
- WO 2008086851 A
- WO 2011088877 A
- WO 2011128017 A
- EP 1617710 A
- EP 1617711 A
- EP 1731584 A
- JP 2005347160 A
- WO 2007137725 A
- WO 2005111172 A
- WO 2010015306 A
- EP 652273 A
- WO 2009062578 A
- WO 2010054729 A
- WO 2010054730 A
- WO 2005011013 A
- JP 2000053957 A
- WO 2003060956 A
- WO 2004028217 A
- WO 2004080975 A
- WO 2010072300 A
- WO 06122630 A
- WO 06100896 A
- EP 1661888 A
- WO 01049806 A
- US 5061569 A
- WO 9509147 A
- WO 08006449 A
- WO 07140847 A
- WO 2012034627 A
- EP 12000929
- EP 12005369
- EP 12005370
- EP 12005371
- EP 11009127
- EP 11007067

**In der Beschreibung aufgeführte Nicht-Patentliteratur**


- **M. A. BALDO et al.** *Appl. Phys. Lett.,* 1999, vol. 75, 4-6
- **T. MATSUMOTO ; T. NAKADA ; J. ENDO ; K. MORI ; N. KAWAMURA ; A. YOKOI ; J. KIDO.** *Multiphoton Organic EL Device Having Charge Generation Layer*
- **Y. SHIROTA et al.** *Chem. Rev.,* 2007, vol. 107 (4), 953-1010
- **B. M. S. ARNOLD et al.** *Appl. Phys. Lett.,* 2008, vol. 92, 053301